(19) Europäisches Patentamt / European Patent Office / Office européen des brevets

(11) **EP 3 938 807 B1**

(12) # EUROPÄISCHE PATENTSCHRIFT

(45) Veröffentlichungstag und Bekanntmachung des Hinweises auf die Patenterteilung:
**28.08.2024 Patentblatt 2024/35**

(21) Anmeldenummer: **20711159.2**

(22) Anmeldetag: **12.03.2020**

(51) Internationale Patentklassifikation (IPC):
**G01S 15/931** (2020.01)   **G01S 15/87** (2006.01)
**G01S 7/00** (2006.01)   **G01S 13/72** (2006.01)
**G01S 13/931** (2020.01)   **G01S 17/66** (2006.01)
**G01S 7/41** (2006.01)   **G01S 13/86** (2006.01)
**G01S 7/539** (2006.01)   **G01S 7/52** (2006.01)
**G01S 15/66** (2006.01)   **G01S 15/86** (2020.01)
**G06N 3/04** (2023.01)   **H03M 7/30** (2006.01)
**G01S 7/533** (2006.01)   **G06N 3/08** (2023.01)
**G06N 3/044** (2023.01)   **G06N 3/045** (2023.01)

(52) Gemeinsame Patentklassifikation (CPC):
**G01S 15/931; G01S 7/003; G01S 7/533;
G01S 7/539; G01S 15/66; G01S 15/86;
G01S 15/876; G06N 3/044; G06N 3/045;
G06N 3/08; H03M 7/30; H03M 7/3082;** G01S 7/417;
G01S 7/52001; G01S 13/723;       (Forts.)

(86) Internationale Anmeldenummer:
**PCT/EP2020/056727**

(87) Internationale Veröffentlichungsnummer:
**WO 2020/182963 (17.09.2020 Gazette 2020/38)**

(54) **VERFAHREN ZUR DETEKTION VON HINDERNISOBJEKTEN DURCH EIN SENSOR SYSTEM MITTELS NEURONALER NETZE**

METHOD FOR DETECTING OF OBSTACLES WITH A SENSOR SYSTEM USING NEURAL NETWORKS

PROCÉDÉ DE DETECTION DES OBSTACLES AVEC UN SYSTÈME DES CAPTEURS UTILISANT DES RÉSEAUX NEURONALES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.03.2019 DE 102019106204**

(43) Veröffentlichungstag der Anmeldung:
**19.01.2022 Patentblatt 2022/03**

(60) Teilanmeldung:
**22175074.8 / 4 071 513
22175103.5 / 4 067 937**

(73) Patentinhaber: **Elmos Semiconductor SE
44227 Dortmund (DE)**

(72) Erfinder:
• **KREISS, Dennis**
  44227 Dortmund (DE)
• **DUTINÉ, Jennifer**
  44227 Dortmund (DE)

(74) Vertreter: **dompatent von Kreisler Selting Werner - Partnerschaft von Patent- und Rechtsanwälten mbB
Deichmannhaus am Dom
Bahnhofsvorplatz 1
50667 Köln (DE)**

(56) Entgegenhaltungen:
WO-A1-2018/106805       WO-A1-2018/210966
DE-A1- 102019 105 651       DE-A1- 102019 106 190
DE-B3- 102017 108 348       US-A1- 2018 211 128

US-A1- 2018 314 985    US-B1- 10 106 153

- **"Wavelet", 22 March 2017 (2017-03-22), XP002785208, Retrieved from the Internet <URL:https://de.wikipedia.org/w/index.php?title=Wavelet&oldid=163843365> [retrieved on 20180927]**

(52) Gemeinsame Patentklassifikation (CPC): (Forts.)
G01S 13/862; G01S 17/66; G01S 17/931;
G01S 2013/9323; G01S 2013/9324

**Beschreibung**

Die vorliegende Patentanmeldung nimmt die Priorität der deutschen Patentanmeldung 10 2019 106 204.7 vom 12. März 2019 in Anspruch

Die Erfindung betrifft ein Verfahren zur Erkennung von Hindernisobjekten sowie zur Prognose der Veränderung der Position bekannter Hindernisobjekte anhand von Signalen mehrerer Sensoren und zur Kompression sowie Dekompression von zu den obigen Zwecken verwendeten Sensorsignalen, insbesondere für ein Fahrzeug zur Erfassung des Umfelds des Fahrzeugs, wie dies beispielsweise bei Einparkhilfen von Fahrzeugen vorgesehen ist.

Ultraschallsensorsysteme für Einparkhilfen in Fahrzeugen erfreuen sich zunehmender Beliebtheit. Hierbei besteht der Wunsch, immer mehr Daten des eigentlichen Messsignals des Ultraschallsensors an ein zentrales Rechnersystem zu übertragen, in dem diese mit Daten anderer Ultraschallsensorsysteme und auch andersartiger Sensorsysteme, z.B. Radarsystemen, durch Sensor-Fusion zur Erstellung sogenannter Umgebungs- oder Umweltkarten aufge- und verarbeitet werden. Es besteht daher der Wunsch, eine Objekterkennung nicht im Ultraschallsensorsystem selbst, sondern durch eben diese Sensorfusion erst im Rechnersystem vorzunehmen, um Datenverluste zu vermeiden und so die Wahrscheinlichkeit für Fehlinformationen und damit Fehlentscheidungen und somit für Unfälle abzusenken. Gleichzeitig ist aber die Übertragungsbandbreite der verfügbaren Sensordatenbusse begrenzt. Deren Austausch soll vermieden werden, da sie sich im Feld bewährt haben. Es besteht daher gleichzeitig der Wunsch, die Menge der zu übertragenden Daten nicht ansteigen zu lassen. Kurzum: Der Informationsgehalt der Daten und deren Relevanz für die spätere im Rechnersystem ablaufende Hinderniserkennung (Objekterkennung) muss gesteigert werden, ohne die Datenrate zu sehr anheben zu müssen oder, was noch besser wäre, ohne die Datenrate überhaupt vergrößern zu müssen. Ganz im Gegenteil: Bevorzugt sollte der Datenratenbedarf sogar gesenkt werden, um Datenratenkapazitäten für die Übermittlung von Statusdaten und Selbsttestinformationen des Ultraschallsensorsystems an das Rechnersystem zuzulassen, was im Rahmen der Funktionalen Sicherheit (FuSi) zwingend erforderlich ist. Diesem Problem widmet sich die Erfindung.

Im Stand der Technik sind bereits verschiedene Methoden der Bearbeitung eines Ultraschallsensorsignals bekannt.

Aus WO-A-2012/016834 ist beispielsweise solch ein Verfahren zur Auswertung eines Echosignals zur Fahrzeugumfelderfassung bekannt. Es wird dort vorgeschlagen, ein Messsignal mit einer vorgebbaren Codierung und Form auszusenden und in dem Empfangssignal mittels einer Korrelation mit dem Messsignal nach den Anteilen des Messsignals im Empfangssignal zu suchen und diese zu bestimmen. Der Pegel der Korrelation und nicht der Pegel der Hüllkurve des Echosignals wird dann mit einem Schwellwert bewertet.

Aus DE-A-4 433 957 ist bekannt, zur Hinderniserkennung Ultraschallimpulse periodisch auszustrahlen und aus der Laufzeit auf die Position von Hindernissen zu schließen, wobei bei der Bewertung zeitlich über mehrere Messzyklen korreliert bleibende Echos verstärkt werden, währen unkorreliert bleibende Echos unterdrückt werden.

Aus DE-A-10 2012 015 967 ist ein Verfahren zum Dekodieren eines von einem Ultraschallsensor eines Kraftfahrzeugs empfangenen Empfangssignals bekannt, bei welchem ein Sendesignal des Ultraschallsensors kodiert ausgesendet wird und zur Dekodierung das Empfangssignal mit einem Referenzsignal korreliert wird, wobei vor dem Korrelieren des Empfangssignals mit dem Referenzsignal eine Frequenzverschiebung des Empfangssignals gegenüber dem Sendesignal bestimmt wird und das Empfangssignal mit dem um die ermittelte Frequenzverschiebung bezüglich seiner Frequenz verschobenen Sendesignal als Referenzsignal korreliert wird, wobei zur Bestimmung der Frequenzverschiebung des Empfangssignals dieses einer Fourier-Transformation unterzogen wird und die Frequenzverschiebung anhand eines Ergebnisses der Fourier-Transformation bestimmt wird.

Aus DE-A-10 2011 085 286 ist ein Verfahren zur Erfassung der Umgebung eines Fahrzeugs mittels Ultraschalls bekannt, wobei Ultraschallpulse ausgesendet und die an Objekten reflektierten Ultraschallechos detektiert werden. Der Erfassungsbereich ist in mindestens zwei Entfernungsbereiche unterteilt, wobei die für die Erfassung im jeweiligen Entfernungsbereich verwendeten Ultraschallpulse voneinander unabhängig ausgesendet werden und durch verschiedene Frequenzen kodiert sind.

Aus WO-A-2014/108300 sind eine Vorrichtung und ein Verfahren zur Umfeldsensorik mittels eines Signalwandlers und einer Auswerteeinheit bekannt, wobei aus dem Umfeld empfangener Signale mit einer ersten Impulsantwortlänge zu einem ersten Zeitpunkt während eines Messzyklus und mit einer zweiten längeren Impulsantwortlänge zu einem zweiten späteren Zeitpunkt innerhalb desselben Messzyklus Signale laufzeitabhängig gefiltert werden.

Aus DE-A-10 2015 104 934 ist ein Verfahren zum Bereitstellen von Informationen bekannt, die von einem in einem Umgebungsbereich eines Kraftfahrzeugs erfassten Hindernisobjekt abhängen. Bei diesem bekannten Verfahren wird der Umgebungsbereich des Kraftfahrzeugs mit einer Sensoreinrichtung des Kraftfahrzeugs erfasst und eine Information an einer Kommunikationsschnittstelle im Kraftfahrzeug bereitgestellt. Dabei werden Sensor-Rohdaten als Information über einen zwischen der Sensoreinrichtung und einem im Umgebungsbereich erfassten Hindernisobjekt erkannter Freiraum in einer sensoreinrichtungsseitigen Steuereinheit abgelegt. Diese Sensor-Rohdaten werden gemäß dem bekannten Verfahren an einer mit der sensoreinrichtungsseitigen Steuereinheit verbundenen Kommunikationsschnittstelle zur Übertragung an und zur Weiterverarbeitung durch eine zur Erstellung einer Umgebungsbereichskarte ausgebildeten Verarbeitungseinrichtung bereitgestellt.

Die technischen Lehren der obigen Schutzrechte sind allesamt von dem Gedanken geleitet, die Erkennung eines Objekts im Umfeld des Fahrzeugs mit Hilfe des Ultraschallsensors bereits im Ultraschallsensor durchzuführen und dann erst die Objektdaten nach Erkennung der Objekte zu übertragen. Hierbei gehen jedoch Synergieeffekte bei der Verwendung mehrerer Ultraschallsender verloren.

Aus DE-A-10 2010 041 424 ist ein Verfahren zum Erfassen eines Umfelds eines Fahrzeugs mit einer Anzahl von Sensoren bekannt, bei dem von mindestens einem Sensor während zumindest eines Echo-Zyklus mindestens eine Echo-Information zu dem Umfeld erfasst und mit einem Algorithmus komprimiert wird und bei dem die mindestens eine komprimierte Echo-Information an mindestens eine Verarbeitungseinheit übertragen wird. Zwar ist dieses bekannte Verfahren auch auf die komprimierte Übertragung von erkannten Objektdaten fokussiert, es wird aber bereits erkannt, dass es ganz allgemein sinnvoll ist, Daten, die aus dem empfangenen Echo-Signal extrahiert werden (Echo-Informationen) komprimiert an das Steuergerät zu übertragen, ohne dass eine Kompressionsmethode angegeben wird.

Aus DE-A-10 2013 226 373 ist ein Verfahren zur Sensoranbindung bekannt. Aus DE-A- 10 2013 226 376 ist ein Verfahren zum Betreiben eines Sensorsystems, insbesondere eines Ultraschallsensorsystems, mit einem Ultraschallsensor und mit einem Steuergerät bekannt. Daten werden von dem Ultraschallsensor an das Steuergerät strommoduliert übertragen. Daten werden von dem Steuergerät an den mindestens einen Ultraschallsensor spannungsmoduliert übertragen.

Aus DE-A-10 024 959 ist eine Vorrichtung zum unidirektionalen oder bidirektionalen Austausch von Daten zwischen einer Messeinheit zur Messung einer physikalischen Größe und einer Regel-/Auswerteeinheit bekannt, die anhand der von der Messeinheit bereitgestellten Messdaten die physikalische Größe mit einer vorgegebenen Genauigkeit bestimmt, Die Messeinheit ist mit der Regel-/Auswerteeinheit über eine Datenleitung verbunden. Es soll die Datenübertragung zwischen einer Messeinheit und einer entfernten Regel-/Auswerteeinheit optimiert werden, wozu zumindest eine Komprimiereinheit vorgesehen ist, die der Messeinheit zugeordnet ist und die die von der Messeinheit in einem vorgegebenen Zyklus gelieferten Messdaten derart komprimiert, dass einerseits der Informationsgehalt der Messdaten vollständig oder derart reduziert über die Datenleitung an die Regel-/Auswerteeinheit übertragen wird, dass die physikalische Größe mit der vorgegebenen Genauigkeit bestimmt ist, und dass andererseits die übertragene Datenmenge minimal ist. Aus DE-A-10 2013 015 402 ist ein Verfahren zum Betreiben einer Sensorvorrichtung eines Kraftfahrzeugs bekannt, bei welchem mittels eines Sensors, insbesondere eines Ultraschallsensors, der Sensorvorrichtung ein Sendesignal in einen Umgebungsbereich des Kraftfahrzeugs ausgesendet und ein in dem Umgebungsbereich 7 an einem Zielobjekt reflektierter Signalanteil des Sendesignals 11 als Echorohsignal 12 empfangen wird. Zwischen dem Sensor und einem Steuergerät der Sensorvorrichtung werden Daten über einen Datenbus übertragen. Mittels der Sensorvorrichtung wird eine Messgröße zu dem Zielobjekt bestimmt. Mittels eines Wandlers des Sensors wird das Echorohsignal zu einem digitalen Echorohsignal umgewandelt, und das digitale Echorohsignal wird von dem Sensor über den Datenbus an das Steuergerät übertragen, welches durch ein Inbezugsetzen des digitalen Echorohsignals zu einem dem Sendesignal entsprechenden Referenzsignal die Messgröße bestimmt. Eine Dekompression der Daten im Steuergerät ist hierbei allerdings nicht vorgesehen.

Aus US-A-2006/0250297 ist ein System zur Sensorfusion bekannt.

Aus WO-A-2018/210966 ist ein Verfahren zur effizienten Übertragung von Daten über einen Fahrzeugbus von einem Ultraschallsystem zu einer Datenverarbeitungseinrichtung bekannt. Das bekannte Verfahren betrifft jedoch nicht die Ausführung der Objekterkennung.

In DE-B-10 2018 106 244 und DE-A-10 2019 106 190 (erst nach dem Prioritätstag der vorliegenden PCT-Anmeldung veröffentlicht) sind Verfahren zur Übertragung von Daten über einen Fahrzeugbus von einem Ultraschallsystem zu einer Datenverarbeitungseinrichtung bekannt, ohne allerdings zu beschreiben, wie die Hindernisobjekterkennung abläuft. Aus DE-B-10 2017 108348 und US-B-10 106 153, die den nächsten Stand der Technik darstellen, ist die Nutzung mehrerer, jeweils einem Ultraschallsensor zugeordneten neuronalen Netzwerken zur Hinderniserkennung bekannt.

Der Erfindung liegt daher die Aufgabe zugrunde, den anderen zuvor genannten Aufgabenstellungen gerecht zu werden.

Diese Aufgabe wird erfindungsgemäß durch ein Verfahren nach Anspruch 1 gelöst. Einzelne Ausgestaltung der Erfindung sind Gegenstand der Unteransprüche.

Hinsichtlich der Erkennung der Existenz von Hindernisobjekten im Umfeld eines Fahrzeugs betrifft die Erfindung ein Verfahren zur Erkennung der Existenz von Hindernisobjekten in einem an ein Fahrzeug angrenzenden Erfassungsbereich, insbesondere in der Umgebung eines Fahrzeugs, anhand von von mehreren Sensoren, insbesondere von mehreren Ultraschallsensoren, gelieferten Sensorsignalen, wobei bei dem Verfahren

A) für jeden Sensor mittels einer Merkmalsextaktion aus dessen Sensorsignal Signalverlaufscharakteristika extrahiert und aus diesen Merkmalen ein das Sensorsignal repräsentierendes Merkmalsvektorsignal EF1,EF2,EF3,...,EFm gebildet wird,

B) die Merkmalsvektorsignale EF1,EF2,EF3,...,EFm einem künstlichen neuronalen Gesamthindernisobjekterkennungsnetz ANN0 als Eingabesignale zugeführt werden, das anhand der Merkmale des Merkmalsvektorsignals EF1,EF2,EF3,...,EFm mindestens ein Hindernisobjekt erkennt und dieses Hindernisobjekt beschreibende Informationen pro Hindernisobjekt in einem separaten Hindernisobjektspeicher EO1,EO2,...,EOp abspeichert,

C) die Informationen jedes Hindernisobjektsspeichers EO1,EO2,...,EOp in einem diesem zugeordneten künstlichen neuronalen Einzelhindernisobjekterkennungsnetz RNN1,RNN2,...,RNNp als Eingabedaten eingegeben werden,

D) jedes neuronale Einzelhindernisobjekterkennungsnetz RNN1,RNN2,...,RNNp ein das Hindernisobjekt des betreffenden Hindernisobjektspeichers EO1,EO2,...,EOp repräsentierendes Hindernisobjekt-Merkmalsvektorsignal RO1,RO2,...,ROp und eine mit der Anzahl der Sensoren identische Anzahl von Zwischen-Merkmalsvektorsignalen (ROij mit i = 1, 2, ..., p, mit p gleich der Anzahl der Hindernisobjekte, und mit j = 1, 2, ..., m, mit m gleich der Anzahl der Sensoren) ausgibt, von denen jedes einem einzigen Sensor S1,S2,S3 ...,Sm zugeordnet ist,

E) für jeden Sensor S1,S2,S3,...,Sm die von den neuronalen Einzelhindernisobjekterkennungsnetzen RNN1,RNN2,...,RNNp ausgegebenen Zwischen-Merkmalsvektorsignalen(RO ij mit i = 1, 2, ..., p, mit p gleich der Anzahl der Hindernisobjekte, und mit j = 1, 2, ..., m, mit m gleich der Anzahl der Sensoren) zur Bildung eines korrigierten Merkmalsvektorsignals EV1,EV2,EV3,...,EVm addiert werden,

F) für jeden Sensor S1,S2,S3,...,Sm ein Restmerkmalsvektorsignal EC1,EC2,EC3,...,ECm gebildet wird, indem das korrigierte Merkmalsvektorsignal EV1,EV2,EV3,...,EVm von dem Merkmalsvektorsignal RC1,RC2,RC3,...,RCm subtrahiert wird,

G) die Schritte B) bis F) unter Verwendung des jeweils aktualisierten Restmerkmalsvektorsignals EC1,EC2,EC3,...,ECm wiederholt werden, sofern das Restmerkmalsvektorsignal EC1,EC2,EC3,...,ECm größer ist als ein Schwellwertsignal, und

H) andernfalls die von den neuronalen Unternetzen RNN1,RNN2,...,RNNp ausgegebenen Hindernisobjekt-Merkmalsvektorsignale RO1,RO2,...,ROp jeweils ein Hindernisobjekt repräsentieren und anhand der Hindernisobjekt-Merkmalsvektorsignale RO1,RO2,...,ROp potentielle, in dem Erfassungsbereich befindliche Hindernisobjekte insbesondere hinsichtlich Position, Lage und/oder Orientierung und/oder hinsichtlich ihrer Typen, ihrer Beschaffenheiten und/oder ihrer Abstände zum Fahrzeug bestimmt werden.

Ausgangspunkt bei diesem Verfahren ist das Vorliegen von Merkmalsvektorsignalen, die Sensorsignale repräsentieren, welche ihrerseits von jeweils einem von mehreren Sensoren stammen, mittels derer das Umfeld des Fahrzeugs erfasst wird. All diese Merkmalsvektorsignale werden einem künstlichen neuronale Gesamthindernisobjekterkennungsnetz zugeführt, das anhand dieser Merkmale ein oder mehrere Hindernisobjekte erkennt, deren beschreibende Informationen dann in verschiedenen Hindernisobjektspeichern abgespeichert werden. Pro Hindernisobjekt existiert ein Hindernisobjektspeicher. Aus den Hindernisobjektspeichern wird dann mittels diesen Speichern jeweils zugeordneten künstlichen neuronalen Einzelhindernisobjekterkennungsnetzen Hindernisobjekt-Merkmalsvektorsignale rekonstruiert. Dies erfolgt zunächst durch Erzeugung von Zwischen-Merkmalsvektorsignalen, und zwar für jedes Hindernisobjekt ein diesem zugeordnetes Merkmalsvektorsignal, wobei all diese Signale addiert werden und zur Bildung eines Restmerkmalsvektorsignals von dem Merkmalsvektorsignal für die jeweiligen Hindernisobjekte subtrahiert wird. Dieser iterative Prozess wird solange wiederholt, bis das nach jedem Schritt erzeugte Restmerkmalsvektorsignal klein genug ist, also kleiner als ein vorgegebenes Schwellsignal ist. Dann befinden sich in den Hindernisobjektspeichern diejenigen Informationen über die tatsächlich im Umfeld des Fahrzeugs befindlichen realen Hindernisobjekte. Deren Parameter wie beispielsweise Position, Lage, Orientierung, Abstand zum Fahrzeug, Typ, Beschaffenheit etc. lassen sich dann auf Wunsch anzeigen.

Die im Rahmen der Erfindung genannten künstlichen neuronalen Netze sind entsprechend trainiert, und zwar mittels Trainingsdaten, wie es für die Lernphase neuronaler Netze grundsätzlich bekannt ist. Im Rahmen dieser Erfindung handelt es sich bei künstlichen neuronalen Netzen um jedwede Art von Konzepten künstlicher Intelligenz. Nach der Erfindung werden künstliche neuronale Netze eingesetzt, die zur Erzeugung von Daten und daraus gebildeten Signalen mit verschiedenen Inhalten genutzt werden. Die künstlichen neuronalen Netze setzen in bekannter Weise auf Datenanalysen anhand von vergleichsweise großen Datenmengen auf, mit denen die neuronalen Netze in Trainings- und Lernphasen gespeist worden sind und die aus experimentellen Tests oder Simulationen im Vorfeld des Einsatzes zur Analyse aktuell anstehender Eingangssignale resultieren (sogenanntes machine learning oder deep learning). Es können sämtliche Typen von ein- oder mehrlagigen bereits bekannten und zukünftigen künstlichen neuronalen Netzen eingesetzt werden, auch solche, die im realen Betrieb selbstlernend und/oder sich selbststrukturierend sind. Unter dem Begriff "künstliches neuronales Netz" fallen im Sinne der Erfindung sämtliche bekannte und zukünftige Instrumente der Daten-/Signal-Analyse und Daten-/Signal-Verarbeitung, mit denen sich das, was im engeren und weiteren Sinne unter "künstlicher Intelligenz" verstanden wird und/oder zukünftig noch verstanden werden wird, realisieren lässt.

Die erfindungsgemäß genutzten künstlichen neuronalen Netze werden in Trainings- bzw. Lernphasen mit experimentell gewonnenen oder aber auch mit durch Simulation gewonnenen Daten gespeist. So wird beispielsweise das Signalobjekt erkennungsnetz NN0 mit Daten versorgt, die die Zuordnung von Signalverlaufscharakteristika oder von Gruppen von sequentiellen Signalverlaufscharakteristika anhand von Merkmalsvektoren oder Merkmalsvektorsignalen zu den zugehörigen Signalobjekten beschreiben. Die Einzelrekonstruktionsnetze NN1,NN2,...,NNn werden mit Daten versorgt, die die Zuordnung von Signalobjekten zu diese repräsentierenden Merkmalsvektoren oder Merkmalsvektorsignalen beschreiben. Die Einzeldekompressionsnetze ENN1,ENN2,...,ENNn werden mit Daten gespeist, die die Zuordnung von Signalobjekten zu diese repräsentierenden Merkmalsvektoren oder Merkmalsvektorsignalen beschreiben. Das Gesamthindernisobjekterkennungsnetz ANN0 enthält Daten, die die Zuordnung von Hindernisobjekten zu Signalverlaufscharakteristika mehrerer Sensorsignale umfassen und die zugehörigen Merkmalsvektoren oder Merkmalsvektorsignale beschreiben. Die Einzelhindernisobjekterkennungsnetze RNN1, RNN2, ..., RNNp werden mit Daten versorgt, die die Zuordnung von Hindernisobjekten zu Merkmalsvektoren oder Merkmalsvektorsignalen beschreiben, die wiederum Signalverlaufscharakteristika mehrerer Sensorsignale repräsentieren.

Das Gesamtprognosenetz DANN0 enthält Daten, die die Zuordnung von Hindernisobjekten zu Signalverlaufscharakteristika mehrerer Sensorsignale umfassen und die zugehörigen Merkmalsvektoren oder Merkmalsvektorsignale beschreiben. Die Einzelprognosenetze MNN1,MNN2,...,MNNp sind mit Daten versorgt, die die Zuordnung von Hindernisobjekten in einem Umfeld z.B. eines Fahrzeugs zu einem Gesamtmerkmalsvektor oder Gesamtmerkmalsvektorsignal beschreiben, das sämtliche Hindernisobjekte im Umfeld repräsentiert.

Im Folgenden werden verschiedene Einzelheiten und Maßnahmen beschrieben, die im Zusammenhang mit der Ausführung der Verfahren nach der Erfindung eingesetzt werden können. Die Erfindung ist vorstehend bzw. wird nachfolgend vornehmlich anhand ihrer Verwendung bei einem Fahrzeug beschrieben, dessen Messsystem der Untersuchung des Umfelds des Fahrzeugs auf die Existenz von Hindernisobjekten dient. Ganz allgemein betrifft die Erfindung allerdings ein Messsystem zur Ermittlung der Abstände des Systems zu einzelnen Objekten, wobei die Art der ausgesendeten und empfangenen Signale vielfältig sein kann.

Die Erfindung beruht auf der Erstellung von Merkmalsvektoren und Merkmalsvektorsignalen durch eine Merkmalsextraktion (Feature Extraction) von Sensorsignalen.

Ein Beispiel für die Erstellung eines Merkmalsvektorsignals wird nachfolgend beschrieben. Bei einem Merkmalsvektorsignal handelt es sich um eine Folge von Merkmalsvektoren. Ein "Merkmal" beispielsweise ein Charakteristikum des zeitlichen Verlaufs des vom Sensor gelieferten Signals kann dessen Wert (Signalpegel) in Abhängigkeit von der Zeit, den Wert der ersten (und/oder auch höheren) Ableitung des Signalverlaufs über der Zeit, den Wert des Integrals des Signalverlaufs über der Zeit, den Wert des Logarithmus des Signalverlaufs über der Zeit etc. umfassen. Grundlage für die Erstellung des Merkmalsvektors sind also verschiedene Kurven, die durch beispielsweise mathematische Operationen aus dem zeitlichen Verlauf des Sensorsignals gebildet worden sind. Werden nun diese Kurven abgetastet, so sind pro Abtastzeitpunkt mehrere Werte gegeben, die den Merkmalsvektor zu einem bestimmten Zeitpunkt bilden. Die Folge solcher Merkmalsvektoren bildet dann das Merkmalsvektorsignal. Jeder Merkmalsvektor weist mehrere Werte (auch als Parameter bezeichnet) auf. Die Folge dieser jeweils ein und derselben Kurven zugeordneten Parameter bildet dann ein Parametersignal.

Anders ausgedrückt kann man eine Merkmalsvektorextraktion auch wie folgt beschreiben:

- Das zu verarbeitende Signal wird z.B. durch Differentiation, Integration, Filterung, Verzerrung, Verzögerung, Schwellwertvergleich aufbereitet. Hierdurch steigt typischerweise die Dimensionalität des Signals von 1 drastisch, beispielsweise auf 24 und mehr an. Was genau gemacht wird, ist dabei unerheblich. Die Feature-Extraktion ist sehr anwendungsspezifisch.
- Die einzelnen Vektordimensionen der so erzeugten Feature-Vektoren haben bezüglich der typischerweise verwendeten Testdatensätze in der Regel keine optimale Signifikanz. Eine optimale Signifikanz liegt dann vor, wenn in dem erlaubten Parameterbereich einer einzelnen Dimension der Feature-Vektoren 50% der Feature-Vektoren bezüglich dieses Parameters oberhalb eines Schwellwerts in der Mitte des Bereiches liegen und 50% unterhalb. Um die maximale Signifikanz zu erreichen, wird die Dimension des Feature-Vektors typischerweise durch Multiplikation mit einer LDA-Matrix reduziert und der Feature-Vektor verzerrt und gedreht, so dass diese Signifikanz hergestellt wird.

Merkmalsvektoren können als mehrdimensionaler Signalstrom von verarbeiteten Abtastwerten verstanden werden und weisen z.B. mehrdimensional Abtastwerte von mehreren Signalen auf, und zwar zu jeweiligen Abtastzeitpunkten. Die Abfolge von Merkmalsvektoren kann man als Merkmalsvektorsignal bezeichnen. Das Signal hat mehrere Dimensionen. Ein Signal, das einer einzigen, bestimmen Dimension dieses mehrdimensionalen Merkmalsvektorsignals entspricht, ist das dieser Dimension zugeordnete Parametersignal.

Der obige Prozess und insbesondere die Korrespondenz zwischen einem Signalverlaufscharakteristikum, einem Signalobjekt und den Merkmalen hierfür in einem Merkmalsvektor bzw. in einem Merkmalsvektorsignal soll nachfolgend nochmals anhand eines konkreten Beispiels beschrieben werden.

Ein ansteigender Signalpegel, der sich innerhalb einer bestimmten Zeitspanne ausgehend von einem Minimalwert, der kleiner als ein Schwellwert ist, bis zu einem Maximalwert, der größer als der Schwellwert ist, verändert, sei als Beispiel für ein erstes Signalverlaufscharakteristikum betrachtet. Es sei ferner angenommen, dass sich an dieses erste Signalverlaufscharakteristikum ein dazu inverses zweites Signalverlaufscharakteristikum, nämlich ein abfallender Signalpegelverlauf anschließt. Das sich daraus ergebende Signalobjekt wäre also ein Dreieck-Signal mit bestimmten Steigungen seiner Flanken und mit bestimmter Spreizung sowie mit einem bestimmten "Schwerpunkt" (Lage des Maximums auf der Zeitachse). Die zu Abtastzeitpunkten dieses Dreieck-Signals sowie seiner sich durch z.B. mathematische Operationen ergebenden Kurvenverläufe (siehe die oben angegebenen Beispiele für derartige mathematische Operationen) bilden dann die Parameter (oder Werte) der Merkmalsvektoren, deren Folge das das Dreieck-Signal repräsentierenden Merkmalsvektorsignal ist. Anhand des Merkmalsvektorsignals kann also das Signalobjekt "Dreieck-Signal" zugeordnet werden, wobei auch die das Dreieck-Signal weiter beschreibenden Parameter wie z.B. Steigung/Abfall der Flanken, Lage und Größe des Maximums etc. bestimmbar sind. Insoweit bildet also das Merkmalsvektorsignal das Signalobjekt "Dreieck-Signal" des Sensorsignals ab. Bei der Übertragung der Daten des Sensorsignals brauchen also nun lediglich noch ein Symbol für die Signalobjektklasse "Dreieck-Signal" und einige wenige weitere Parameter für eine nähere Beschreibung der konkreten Ausgestaltung des Dreieck-Signals übertragen zu werden. Damit einher geht also eine massive Datenkompression mit den bereits weiter oben beschriebenen Vorteilen des gesamten Hindernisobjekterkennungssystems.

Wie oben erläutert, sind die technischen Lehren aus dem Stand der Technik allesamt von dem Gedanken geleitet, die Erkennung eines Hindernisobjekts im Umfeld des Fahrzeugs bereits im Ultraschallsensor durchzuführen und dann erst die Objektdaten nach Erkennung der Hindernisobjekte zu übertragen. Da hierbei jedoch Synergieeffekte bei der Verwendung mehrerer Ultraschallsender verloren gehen, wurde im Rahmen der Erfindung erkannt, dass es nicht sinnvoll ist, nur die Echo-Daten des Ultraschallsensors selbst, sondern die Daten aller Ultraschallsensoren zu übertragen und erst in einem zentralen Rechnersystem (Datenverarbeitungseinheit) die Daten mehrerer Sensoren auszuwerten. Hierfür muss die Kompression der Daten für die Übertragung über einen Datenbus mit geringerer Busbandbreite aber anders erfolgen als im Stand der Technik. Hierdurch können dann Synergieeffekte erschlossen werden. So ist es beispielsweise denkbar, dass ein Fahrzeug mehr als einen Ultraschallsensor aufweist. Um die beiden Sensoren unterscheiden zu können, ist es sinnvoll, wenn diese beiden Sensoren mit unterschiedlicher Codierung senden. Im Gegensatz zum Stand der Technik sollen beide Sensoren aber nun die Ultraschallechos der Abstrahlungen beider Ultraschallsensoren erfassen und geeignet komprimiert an das zentrale Rechnersystem übertragen, in dem die Ultraschallempfangssignale rekonstruiert werden. Erst nach der Rekonstruktion (Dekompression) erfolgt die Erkennung der Objekte. Dies ermöglicht zudem die Fusion der Ultraschallsensordaten mit weiteren Sensorsystemen wie z.B. Radar usw.

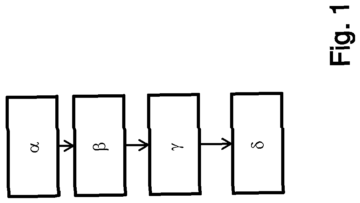

Es wird ein Verfahren zur Übertragung von Sensordaten von einem Sensor zu einem Rechnersystem vorgeschlagen. Besonders geeignet ist das Verfahren für die Verwendung zur Übertragung von Daten eines Ultraschallempfangssignals von einem Ultraschallsensor an ein Steuergerät als Rechnersystem eines Entfernungsmesssystems für z.B. ein Fahrzeug. Das Verfahren wird anhand der Fig. 1 erläutert.

Gemäß einem Ausführungsbeispiel des Verfahrens wird zunächst ein Ultraschall-Burst erzeugt und in einen Freiraum, typischerweise in das Umfeld des Fahrzeugs ausgesendet (Schritt α der Fig. 1). Ein Ultraschall-Burst besteht dabei aus mehreren mit Ultraschallfrequenz aufeinanderfolgenden Schallpulsen. Dieser Ultraschall-Burst entsteht dadurch, dass ein mechanischer Schwinger in einem Ultraschallsender oder Ultraschall-Transducer langsam anschwingt und wieder ausschwingt. Der so von dem beispielhaften Ultraschall-Transducer ausgesendete Ultraschall-Burst wird dann an Objekten im Umfeld des Fahrzeugs reflektiert und durch einen Ultraschallempfänger oder den Ultraschall-Transducer selbst als Ultraschallsignal empfangen und in ein elektrisches Empfangssignal umgewandelt (Schritt β der Fig. 1). Besonders bevorzugt ist der Ultraschallsender identisch mit dem Ultraschallempfänger und wird im Folgenden dann als Transducer bezeichnet. Das im Folgenden erläuterte Prinzip lässt sich aber auch für getrennt angeordnete und/oder ausgebildete Empfänger und Sender anwenden. In dem vorgeschlagenen Ultraschallsensor befindet sich eine Signalverarbeitungseinheit, die nun das so empfangene elektrische Empfangssignal analysiert und komprimiert (Schritt γ der Fig. 1), um die notwendige Datenübertragung zu minimieren und Freiraum für die besagten Statusmeldungen und weitere Steuerbefehle des Steuergeräts an die Signalverarbeitungseinheit bzw. das Ultraschallsensorsystem zu schaffen. Anschließend wird das komprimierte elektrische Empfangssignal an das Rechnersystem übertragen (Schritt δ der Fig. 1).

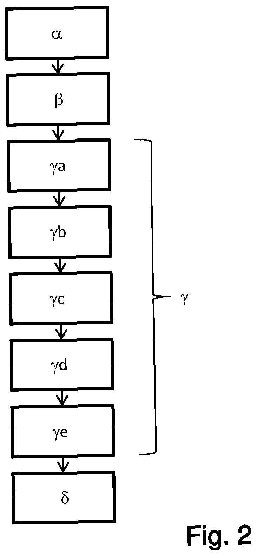

Das Verfahren gemäß der zuvor beschriebenen Variante und der nachfolgend erläuterten vorteilhaften Ausgestaltungen dient somit zur Übertragung von Sensordaten, insbesondere eines Ultraschallsensors, von einem Sensor zu einem Rechnersystem, insbesondere in einem Fahrzeug. Es beginnt mit dem Aussenden eines Ultraschall-Bursts (Schritt α der Fig. 1). Es folgt das Empfangen eines Ultraschallsignals und das Bilden eines elektrischen Empfangssignals (Schritt β der Fig. 1) sowie die Durchführung einer Datenkompression des Empfangssignals (Schritt γ der Fig. 1) zur Erzeugung komprimierter Daten (Schritt γ der Fig. 1) und die Erfassung mindestens zweier oder dreier oder mehrerer vorbestimmter Eigenschaften. Bevorzugt wird das elektrische Empfangssignal durch Abtastung (Schritt γa der Fig. 2) in ein abgetastetes Empfangssignal verwandelt, das aus einem zeitdiskreten Strom von Abtastwerten besteht. Jedem Abtastwert kann dabei typischerweise ein Abtastzeitpunkt als Zeitstempel dieses Abtastwertes zugeordnet werden. Die Kompression kann beispielsweise durch eine Wavelet-Transformation (Schritt γb der Fig. 2) erfolgen. Hierfür kann das empfangene Ultraschallsignal in Form des abgetasteten Empfangssignals mit vorbestimmten Signal-Grundformen, die beispielsweise in einer Bibliothek abgelegt sind, durch Bildung eines Korrelationsintegrals (zur Definition dieses Begriffs z.B. in Wikipedia) zwischen den vorbestimmten Signal-Grundformen und dem abgetasteten Empfangssignal verglichen werden. Die vorbestimmten Signal-Grundformen werden im Folgenden auch Signalobjektklassen genannt. Durch die Bildung des Korrelationsintegrals werden für jeden dieser prototypischen Signalobjektklassen jeweils zugehörige Spektralwerte dieser prototypischen Signalobjektklasse ermittelt. Da dies fortlaufend geschieht, stellen die Spektralwerte selbst einen Strom von zeitdiskreten momentanen Spektralwerten dar, wobei jedem Spektralwert wieder ein Zeitstempel zugeordnet werden kann. Eine alternative, aber mathematisch äquivalente Methode ist die Verwendung von Optimalfiltern (englisch matched-filter) je vorbestimmter Signalobjektklasse (Signal-Grundform). Da in der Regel mehrere prototypische Signalobjektklassen verwendet werden, die zudem noch unterschiedlichen zeitlichen Spreizungen unterworfen werden können, ergibt sich auf diese Weise typischerweise ein zeitdiskreter Strom multidimensionaler Vektoren von Spektralwerten unterschiedlicher prototypischer Signalobjektklassen und deren unterschiedlicher jeweiligen zeitlicher Spreizungen, wobei jedem dieser multidimensionalen Vektoren wieder ein Zeitstempel zugeordnet wird. Jeder dieser multidimensionalen Vektoren ist ein sogenannter Feature-Vektor (Merkmalsvektor). Es handelt sich somit um einen zeitdiskreten Strom von Feature-Vektoren. Jedem dieser Feature-Vektoren ist bevorzugt wieder ein Zeitstempel zugeordnet (Schritt yb der Fig. 2).

Durch die fortlaufende zeitliche Verschiebung ergibt sich somit auch eine zeitliche Dimension. Hierdurch kann der Feature-Vektor der Spektralwerte auch um Werte der Vergangenheit oder um Werte, die von diesen abhängen, beispielsweise zeitliche Integrale oder Ableitungen oder Filterwerte von einem oder mehreren dieser Werte etc., ergänzt werden. Dies kann die Dimension dieser Feature-Vektoren innerhalb des Feature-Vektor-Datenstroms weiter erhöhen. Um den Aufwand im Folgenden klein zu halten, ist daher die Beschränkung auf wenige prototypische Signalobjektklassen während der Extraktion der Feature-Vektoren aus dem abgetasteten Eingangssignal des Ultraschallsensors sinnvoll. Somit können dann beispielsweise Optimalfilter (englisch matched filter) verwendet werden, um fortlaufend das Auftreten dieser prototypischen Signalobjektklassen im Empfangssignal zu überwachen.

Als besonders einfache prototypische Signalobjektklassen können hier beispielhaft das gleichschenklige Dreieck und die Doppelspitze genannt werden. Eine prototypische Signalobjektklasse besteht dabei in der Regel aus einem vorgegebenen Spektralkoeffizientenvektor, also einem vorgegebenen prototypischen Feature-Vektor-Wert.

Für die Bestimmung der Relevanz der Spektralkoeffizienten eines Feature-Vektors eines Ultraschall-Echo-Signals erfolgt die Bestimmung des Betrags eines Abstands dieser Eigenschaften, der Elemente des Vektors der momentanen Spektralkoeffizienten (Feature-Vektor), zu zumindest einer prototypischen Kombination dieser Eigenschaften (Prototyp) in Form einer prototypischen Signalobjektklasse, die durch einen vorgegebenen prototypischen Feature-Vektor (Prototyp oder Prototypenvektor) aus einer Bibliothek von vorgegebenen prototypischen Signalobjektklassen-Vektoren symbolisiert wird (Schritt yd der Fig. 2). Bevorzugt werden die Spektralkoeffizienten des Feature-Vektors vor der Korrelation mit den Prototypen normiert (Schritt γc der Fig. 2). Der in dieser Abstandsbestimmung ermittelte Abstand kann z.B. aus der Summe aller Differenzen zwischen jeweils einem Spektralkoeffizienten des vorgegebenen prototypischen Feature-Vektors (Prototypen oder Prototypenvektors) des jeweiligen Prototypens und dem entsprechenden normierten Spektralkoeffizienten des aktuellen Feature-Vektors des Ultraschall-Echo-Signals bestehen. Ein euklidischer Abstand würde durch die Wurzel aus der Summe der Quadrate aller Differenzen zwischen jeweils einem Spektralkoeffizienten des vorgegebenen prototypischen Feature-Vektors (Prototypen oder Prototypenvektors) des Prototypens und dem entsprechenden normierten Spektralkoeffizienten des aktuellen Feature-Vektors des Ultraschall-Echo-Signals gebildet werden. Diese Abstandsbildung ist aber in der Regel zu aufwändig. Andere Methoden der Abstandsbildung sind denkbar. Jedem vorgegebenen prototypischen Feature-Vektor (Prototyp oder Prototypenvektor) kann dann ein Symbol und gegebenenfalls auch ein Parameter, z.B. der Abstandswert und/oder die Amplitude vor der Normierung, zugeordnet werden. Unterschreitet der so ermittelte Abstand einen ersten Schwellwert und ist es der kleinste Abstand des aktuellen Feature-Vektor-Werts zu einem der vorgegebenen prototypischen Feature-Vektorwerte (Prototypen oder Werte der Prototypenvektoren), so wird dessen Symbol als erkannter Prototyp weiterverwendet. Es entsteht somit eine Paarung aus erkannten Prototypen und Zeitstempel des aktuellen Feature-Vektors. Es erfolgt dann bevorzugt die Übertragen der Daten (Schritt δ der Fig. 2), hier des ermittelten Symbols, das den erkannten Prototypen am besten symbolisiert, und beispielsweise des Abstands sowie der Zeitpunkt des Auftretens (Zeitstempels) an das Rechnersystem nur dann, wenn der Betrag dieses Abstands unter dem ersten Schwellwert liegt und der erkannte Prototyp ein zu übertragender Prototyp ist. Es kann nämlich sein, dass auch nicht zu erkennende Prototypen beispielsweise für Rauschen, also z.B. das nicht Vorhandensein von Reflexionen etc. hinterlegt werden. Diese Daten sind für die Hinderniserkennung irrelevant und sollen daher gegebenenfalls auch nicht übertragen werden. Ein Prototyp wird also erkannt, wenn der Betrag des ermittelten Abstands zwischen aktuellem Feature-Vektor-Wert und vorgegebenen prototypischen Feature-Vektor-Wert (Prototyp oder Wert des Prototypenvektors) unter diesem ersten Schwellwert liegt (Schritt γe der Fig. 2). Es wird also nicht mehr das Ultraschallechosignal selbst übertragen, sondern nur eine Folge von Symbolen für erkannte typische zeitliche Signalverläufe und diesen Signalverläufen zugehörige Zeitstempel in einem bestimmten Zeitabschnitt (Schritt δ der Fig. 2). Es wird dann bevorzugt jeweils je erkanntem Signalobjekt nur ein Symbol für den erkannten Signalformprototypen, dessen Parameter (z.B. Amplitude der Hüllkurve (des Ultraschall-Echo-Signals) und/oder zeitliche Streckung) und ein zeitlicher Referenzpunkt des Auftretend dieses Signalformprototypen (der Zeitstempel) als erkanntest Signalobjekt übertragen. Die Übertragung der einzelnen Abtastwerte oder von Zeitpunkten, zu denen Schwellwerte durch die Hüllkurve des abgetasteten Empfangssignals (des Ultraschall-Echo-Signals) überschritten werden etc., entfällt. Auf diese Weise führt diese Selektion der relevanten Prototypen zu einer massiven Datenkompression und zu einer Reduktion der ansonsten für die schnelle Übertragung großer Datenmengen benötigten Busbandbreite.

Es erfolgt also eine quantitative Erfassung des Vorliegens einer Kombination von Eigenschaften unter Bildung eines Schätzwertes - hier z.B. des inversen Abstands zwischen dem Repräsentanten der prototypischen Signalobjektklasse in Form des vorgegebenen prototypischen Feature-Vektors (Prototyp oder Prototypenvektor) - und das anschließende Übertragen der komprimierten Daten an das Rechnersystem, wenn der Betrag dieses Schätzwertes (z.B. inverser Abstand) über einem zweiten Schwellwert bzw. der inverse Schätzwert unter einem ersten Schwellwert liegt. Die Signalverarbeitungseinheit des Ultraschallsensors führt somit eine Datenkompression des Empfangssignals zur Erzeugung komprimierter Daten aus.

Zur besseren Klarheit soll die Abstandermittlung (im Zusammenhang mit z.B. Klassifikatoren) hier nochmals erläutert werden.

Diese Abstandsermittlung ist auch als Klassifikation aus der Signalverarbeitung statistischer Signale bekannt. Als Klassifikatorbeispiele seien hier die logistische Regression, der Quader-Klassifikator, der Abstandsklassifikator, der Nächste-Nachbarn-Klassifikator, der Polynomklassifikator, das Clusterverfahren, künstliche neuronale Netze, latente Klassenanalyse genannt.

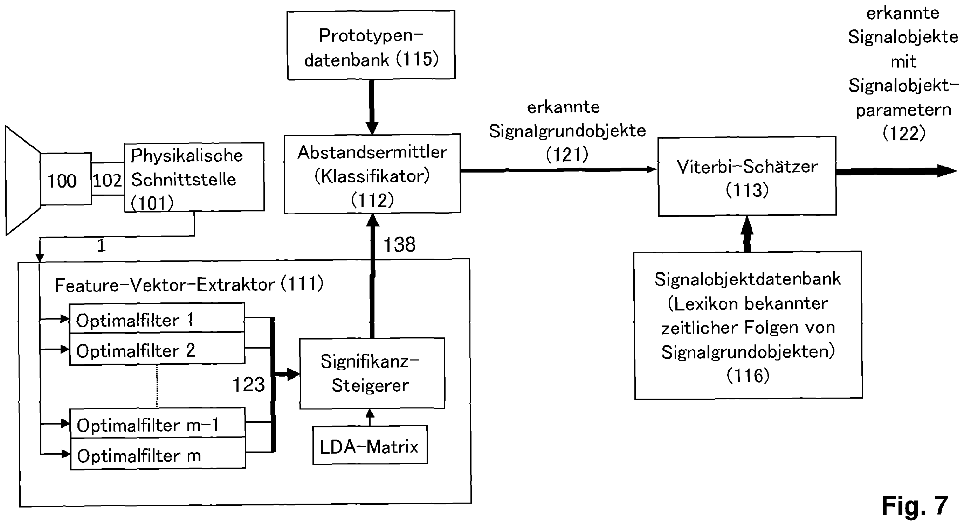

Ein Klassifikator-Beispiel ist in Fig. 7 schematisch gezeigt.

Eine physikalische Schnittstelle 101 steuert z.B. einen Ultraschallwandler 100 an und veranlasst diesen zum Aussenden eines z.B. Ultraschallsendepulses oder Ultraschallsendebursts. Der Ultraschallwandler 100 empfängt den von einem nicht in Fig. 7 eingezeichneten Hindernisobjekt reflektierten Ultraschallsendepuls oder Ultraschallsendeburst mit einer Amplitudenänderung, einer Verzögerung und typischerweise mit einer Verzerrung, die durch die Beschaffenheit des reflektierenden Hindernisobjekts hervorgerufen wird. Außerdem befinden sich typischerweise mehrere Hindernisobjekte im Umfeld des Fahrzeugt, die zu der reflektierten Ultraschallwelle modifizierend beitragen. Der Ultraschallwandler 100 wandelt die empfangene reflektierte Ultraschallwelle in ein Ultraschallwandlersignal 102 um. Die physikalische Schnittstelle wandelt dieses Ultraschallwandlersignal, typischerweise durch Filterung und/oder Verstärkung in ein Ultraschall-Echo-Signal 1 um. Der Feature-Vektor-Extraktor 111 extrahiert aus diesem Ultraschall-Echo-Signal 1 Signalverlaufscharakteristika (Merkmale bzw. "Features"). Bevorzugt übermittelt die physikalische Schnittstelle 101 an den Feature-Vektor-Extraktor 111 das Ultraschall-Echo-Signal 1 als ein zeitdiskretes Empfangssignal bestehend aus einer Folge von Abtastwerten beginnt. Jedem Abtastwert ist dabei bevorzugt ein zeitliches Datum (Zeitstempel) zugeordnet. Der Feature-Vektor-Extraktor 111 weist in dem Beispiel der Fig. 7 eine Mehrzahl von m (mit m als ganzer positiver Zahl) Optimalfiltern (Optimalfilter 1 bis Optimalfilter m) auf. Diese dienen der Bestimmung von m Zwischenparametersignalen 123 jeweils betreffend das Vorliegen jeweils eines dem jeweiligen Zwischenparametersignal bevorzugt zugeordneten Signalgrundobjekts bevorzugt mit Hilfe eines geeigneten Filters (z.B. eines Optimalfilters) aus der Folge von Abtastwerten des Ultraschall-Echo-Signals 1. Die sich ergebenden Zwischenparametersignale 123 sind ebenfalls als zeitdiskrete Folge von jeweiligen Zwischenparametersignalwerten ausgebildet, die bevorzugt jeweils mit einem Datum (Zeitstempel) korreliert sind. Somit ist bevorzugt jedem Zwischenparametersignalwert genau ein zeitliches Datum (Zeitstempel) zugeordnet.

Ein nachfolgender Signifikanzsteigerer 125 führt eine Matrixmultiplikation des Vektors der Zwischenparametersignalwerte des Zwischenparametersignals 123 mit einer sogenannten LDA-Matrix 126 durch. Diese wird typischerweise zum Konstruktionszeitpunkt mittels Methoden der statistischen Signalverarbeitung und der Mustererkennung ermittelt. Der Signifikanzsteigerer erzeugt auf diese Weise das Feature-Vektor-Signal 138. Hierbei bildet er die m Zwischenparametersignalwerte auf n (mit n als ganzer Zahl) Parametersignalwerte des Feature-Vektor-Signals 138 ab. Typischerweise umfasst also das Feature-Vektor-Signal 138 aus n Parametersignalen. Bevorzugt ist n<m. An dieser Stelle sei angemerkt, dass der Begriff "Feature-Vektor" in der statistischen Signaltheorie und in der Mustererkennung auch oft als Merkmalsvektor bezeichnet wird (nachfolgend auch mit Feature-Vektor bezeichnet). Das Feature-Vektor-Signal 138 ist somit u.a. als zeitdiskrete Folge von Feature-Vektor-Signalwerten mit jeweils n Parametersignalwerten der bevorzugt n Parametersignale des Feature-Vektor-signals 138 ausgebildet, die die Parametersignalwerte und weitere Parametersignalwerte mit jeweils gleichem zeitlichem Datum (Zeitstempel) umfassten. Hierbei ist n die Dimension der einzelnen Feature-Vektor-Signalwerte, die bevorzugt von einem Feature-Vektorwert zum nächsten Feature-Vektorwert gleich sind. Ein Feature-Vektor-Signalwert ist in diesem Sinne ein Vektor mit einem Zeitstempel, der mehrere, bevorzugt n, Parametersignalwerte umfasst. Jedem so gebildeten Feature-Vektor-Signalwert wird dieses jeweilige zeitliche Datum (Zeitstempel) zugeordnet.

Es folgt nun die Auswertung des zeitlichen Verlaufs des Feature-Vektor-Signals 138 in dem sich ergebenden n-dimensionalen Phasenraum sowie das Schließen auf ein erkanntes Signalgrundobjekt unter Ermittlung eines Bewertungswerts (z.B. des Abstands).

Hierzu vergleicht ein Abstandsermittler (oder Klassifikator) 112 den aktuellen Feature-Vektor-Signalwert des Feature-Vektor-Signals 138 mit einer Mehrzahl von prototypischen, zuvor in einer Prototypendatenbank 115 abgespeicherten Feature-Vektor-Signalwert-Prototypen. Dies wird im Folgenden noch detaillierter erläutert. Der Abstandsermittler (oder Klassifikator) 112 ermittelt dabei einen Bewertungswert für jeden der untersuchten Feature-Vektor-Signalwert-Prototypen der Prototypendatenbank 115, der angibt, inwieweit der jeweilige Feature-Vektor-Signalwert-Prototyp der Prototypendatenbank 115 dem aktuellen Feature-Vektor-Signalwert gleicht. Dieser Bewertungswert wird im Folgenden als Abstand bezeichnet. Bevorzugt sind die Feature-Vektor-Signalwert-Prototypen jeweils bevorzugt genau einem Signalgrundobjekt zugeordnet. Der Feature-Vektor-Signalwert-Prototyp der Prototypendatenbank 115 mit dem kleinsten Abstand zu dem aktuellen Feature-Vektor-Signalwert gleicht diesem dann am besten. Ist der Abstand kleiner als ein vorgegebener Schwellwert, so repräsentiert dieser Feature-Vektor-Signalwert-Prototyp der Prototypendatenbank 115 das mit höchster Wahrscheinlichkeit erkannte Signalgrundobjekt 121.

Dieser Erkennungsprozess wird mehrmals hintereinander ausgeführt, so dass sich eine ermittelte Signalgrundobjektfolge aus der zeitlichen Folge der erkannten Signalgrundobjekte 121 ergibt.

Dann folgt die Ermittlung des wahrscheinlich vorliegenden Signalobjekts 122 durch Ermittlung derjenigen Folge vorgegebener Signalgrundobjektfolgen einer Signalobjektdatenbank 116, die der ermittelten Signalgrundobjektfolge am ähnlichsten ist. Wie zuvor erläutert, besteht dabei ein Signalobjekt, aus einer zeitlichen Abfolge von Signalgrundobjekten. Dem Signalobjekt ist dabei typischerweise vordefiniert ein Symbol in der Signalobjektdatenbank 116 zugeordnet.

Beispielsweise kann diese Schätzung der Signalgrundobjektabfolge durch einen Viterbi-Schätzer 113 erfolgen. Im einfachsten Fall wird die Anzahl der innerhalb eines vorgegebenen Zeitraums erkannten Signalgrundobjekte, die entsprechend ihrer Position in der Folge der erkannten Signalgrundobjekte mit der Position eines erwarteten Signalgrundobjekts in einer in der Signalobjektdatenbank 116 als vorgegebenes Signalobjekt vorgegebenen erwarteten Folge von Signalgrundobjekten übereinstimmen minus der Anzahl der innerhalb des vorgegebenen Zeitraums erkannten Signalgrundobjekte, die entsprechend ihrer Position in der Folge der erkannten Signalgrundobjekte mit der Position eines erwarteten Signalgrundobjekts in einer in der Signalobjektdatenbank 116 als vorgegebenes Signalobjekt vorgegebenen erwarteten Folge von Signalgrundobjekten nicht übereinstimmen, als Bewertungswert für die Übereinstimmung genommen. Auf diese Weise ermittelt der Viterbi-Schätzer für jedes der vorgegebenen Signalobjekte der Signalobjektdatenbank 116 einen Bewertungswert, wobei die Signalobjekte der Signalobjektdatenbank 116 aus vorgegebenen Folgen von erwarteten Signalgrundobjekten bestehen und mit einem jeweiligen Symbol korreliert sind.

Anders ausgedrückt wird hier geprüft, ob der Punkt, auf den das n-dimensionale Feature-Vektor-Signal 138 im n-dimensionalen Phasenraum zeigt, bei seinem Wege durch den n-dimensionalen Phasenraum in vorbestimmter zeitlicher Abfolge sich vorbestimmten Punkten in diesem n-dimensionalen Phasenraum näher als ein vorgegebener Maximalabstand nähert. Das Feature-Vektor-Signal 138 hat also einen einem zeitlichen Verlauf. Es wird dann ein Bewertungswert (z.B. ein Abstand) berechnet, der beispielsweise der Wahrscheinlichkeit für das Vorliegen einer bestimmten Abfolge wiedergeben kann. Es erfolgt dann bevorzugt innerhalb des Viterbi-Schätzers 113 der Vergleich dieses Bewertungswerts, dem wieder ein zeitliches Datum (Zeitstempel) zugeordnet ist, mit einem Schwellwertvektor unter Bildung eines booleschen Resultats, das einen ersten und einen zweiten Wert haben kann. Wenn dieses boolesche Resultat für dieses zeitliche Datum (Zeitstempel) den ersten Wert hat, erfolgt ein Übertragen des Symbols des Signalobjekts und des diesem Symbol zugeordneten zeitlichen Datums (Zeitstempel) von dem Sensor zu dem Rechnersystem. Hierdurch wird das erkanntes Signalobjekt 122 bevorzugt mit seinen Parametern übertragen. Gegebenenfalls können je nach erkanntem Signalobjekt weitere Parameter übertragen werden.

An dieser Stelle soll zur besseren Klarheit nochmals auf die Verarbeitung des Feature-Vektors-Signals 138 eingegangen werden. Bevorzugt ist das Ultraschall-Echo-Signal 1 eine Folge von Quantisierungsvektoren - den Ultraschall-Echo-Signalwerten -, deren Komponenten, die gemessenen Parameter, im Allgemeinen aber nicht vollkommen unabhängig voneinander sein werden. Jeder Ultraschall-Echo-Signalwert eines Ultraschall-Echo-Signals 1 für sich weist in der Regel eine zu geringe Selektivität für die genaue Signalobjektermittlung in komplexen Zusammenhängen auf. Genau dies ist der Mangel im Stand der Technik. Durch die Erstellung eines oder mehrerer solcher Quantisierungsvektoren aus dem kontinuierlichen Strom analoger physikalischer Werte des Ultraschall-Echo-Signals 1 in typischerweise regelmäßigen oder regulären Zeitabständen durch das physikalische Interface 101 (siehe Fig. 7) entsteht der zeitlich und wertemäßig quantisierter mehrdimensionaler Ultraschall-Echo-Signalwertdatenstrom in Form des Ultraschall-Echo-Signals 1.

Dieses so gewonnene mehrdimensionale Ultraschall-Echo-Signal 1 in Form eines oder mehrerer Ströme von Quantisierungsvektoren wird in einem ersten Bearbeitungsschritt zunächst in einzelne Frames definierter Länge unterteilt, gefiltert, normiert, dann orthogonalisiert und gegebenenfalls durch eine nichtlineare Abbildung - z.B. Logarithmierung und Cepstrum-Analyse - geeignet verzerrt. Dies ist durch den Block der Optimalfilter in der Feature-Vektor-Extraktor 111 der Fig. 7 angedeutet. Statt der Optimalfilter kann man sich hier also auch andere Signalaufbereitungsstrukturen zur Erzeugung der Parameterzwischensignale 123 vorstellen. Beispielsweise können hier auch Ableitungen der so generierten Ultraschall-Echo-Signalwerte gebildet werden. Schließlich findet eine Signifikanzsteigerung des ermittelten Zwischenparametersignals 123 in einer Signifikanzsteigerungseinheit 125 zum eigentlichen Feature-Vektorsignal 138 statt. Dies kann, wie beschrieben, beispielsweise durch Multiplikation des mehrdimensionalen Quantifizierungssektors mit einer so genannten, vorgegebenen LDA-Matrix 126 erfolgen.

Der nun folgende Schritt der Erkennung in dem Abstandsermittler (bzw. Klassifikator) 112 kann beispielsweise auf unterschiedliche Weisen durchgeführt werden:

a) durch ein Neuronales Netz oder
b) durch einen HMM-Erkenner
c) durch ein Petri-Netz

Hier wird wieder beispielhaft der HMM-Erkenner (Fig. 7) beschrieben:
Mit Hilfe der besagten vordefinierten LDA-Matrix 126 wird der Zwischenparameterdatenstrom 123 so vom mehrdimensionalen Eingangsparameterraum auf einen neuen Parameterraum durch den Signifikanzsteigerer 125 abgebildet, wodurch seine Selektivität maximal wird. Die Komponenten der dabei gewonnenen neuen transformierten Merkmalsvektoren werden hierbei nicht nach realen physikalischen oder sonstigen Parametern, sondern nach maximaler Signifikanz ausgewählt, was besagte maximale Selektivität zur Folge hat.

Die LDA-Matrix 126 wird in der Regel zuvor zum Konstruktionszeitpunkt auf Grund von Beispieldatenströmen mit bekannten Signalobjektdatensätzen, also Datensätzen, die mit vorgegeben Strukturen des Signalverlaufs gewonnen wurden, zuvor durch einen Trainingsschritt offline berechnet.

Wenn dafür gesorgt wird, dass alle Elemente der des vom Abstandsermittler (bzw. dem Klassifikator) 112 durchgeführten Verfahren zumindest lokal umkehrbare Funktionen ausführen, so können Abweichungen des Signalverlaufs in Form einer annähernd linearen Transformationsfunktion berücksichtigt werden.

Die Prototypen aus Beispieldatenströmen für die vorgegebenen prototypischen Signalverläufe (prototypische Signalgrundobjekte) in den Koordinaten des neuen Parameterraumes werden in der Konstruktionsphase berechnet und in einer Prototypendatenbank 115 für die spätere Wiedererkennung hinterlegt. Diese kann neben diesen statistischen Daten auch Anweisungen für ein Rechnersystem enthalten, was bei einer erfolgreichen bzw. fehlgeschlagenen Erkennung des jeweiligen Signalgrundobjektprototyps geschehen soll. In der Regel wird es sich bei dem Rechnersystem um das Rechnersystem des Sensorsystems handeln.

Die Feature-Vektor-Signalwerte des Feature-Vektor-Signals 138, die von dem Feature-Extractor 111 für diese prototypischen Signalverläufe der vorgegebenen Signalgrundobjekte des Ultraschall-Echo-Signals 1 im Labor ausgegeben werden, werden also in dieser Prototypendatenbank 115 als Signalgrundobjektprototypen gesichert.

Im späteren Betrieb werden die Feature-Vektor-Signalwerte des Feature-Vektor-Signals 138 nun mit diesen vorab eingespeicherten, d.h. erlernten Signalgrundobjektprototypen 115 beispielsweise durch Berechnung des euklidischen Abstands zwischen einem Quantisierungsvektor in den Koordinaten des neuen Parameterraumes und allen diesen zuvor abgespeicherten Signalgrundobjektprototypen 115 in dem Abstandsermittler 112 verglichen. Hierbei werden mindestens zwei Erkennungen geleistet:

1. Entspricht der erkannte Feature-Vektor-Wert des Feature-Vektorsignals 138 einem der vorgespeicherten Signalgrundobjektprototypen der Prototypendatenbank 115 oder nicht und mit welcher Wahrscheinlichkeit und Zuverlässigkeit?

2. Wenn es einer der bereits gespeicherten Signalgrundobjektprototypen der Prototypendatenbank 115 ist, welcher es ist und mit welcher Wahrscheinlichkeit und Zuverlässigkeit?

Um die erste Erkennung zu leisten, werden in der Regel auch Dummy-Prototypen in der Prototypendatenbank 115 der Signalgrundobjektprototypen abgespeichert, die alle im Betrieb vorkommenden parasitären Parameterkombinationen weitestgehend abdecken sollten. Die Abspeicherung besagter Signalgrundobjektprototypen geschieht in der Prototypendatenbank 115.

Für die Signalgrundobjektprototypen der Prototypendatenbank 115 kann zum Konstruktionszeitpunkt der Abstand entsprechend dem im Abstandsermittler 112 angewandten Verfahren für jede Paarung aus zwei verschiedenen Signalgrundobjektprototypen der Prototypendatenbank 115 ermittelt werden. Es ergibt sich dann ein minimaler Prototypenabstand. Dieser wird in der Prototypendatenbank 115 oder im Abstandsermittler bevorzugt ebenfalls halbiert als halber minimaler Prototypenabstand abgelegt.

Wird beispielsweise dieser minimale halbe Prototypenabstand durch den von der Abstandsermittlung 112 ermittelten Abstand zwischen dem aktuellen Feature-Vektor-Signalwert des Feature-Vektorsignals 138 und einem Signalgrundobjektprototypen der Prototypendatenbank 115 unterschritten, so wird dieser Signalgrundobjektprototyp als erkannt gewertet. Es kann ab diesem Zeitpunkt ausgeschlossen werden, dass weitere im Verlauf einer weiter fortgesetzten Suche berechnete Abstände zu anderen Signalgrundobjektprototypen der Prototypendatenbank 115 noch kleinere Abstände liefern können. Die Suche kann dann abgebrochen werden, was die Zeit im Mittel halbiert und somit die Ressourcen des Sensors schont.

Die Berechnung des minimalen euklidischen Abstands kann dabei beispielsweise nach der folgenden Formel:

$$Dist_{FV\_CbE} = \underset{Cb\_cnt=Cb\_anz}{\overset{1}{Min}} \left[ \sum_{\dim\_cnt=\dim}^{1} \left( FV_{\dim\_cnt} - Cb_{Cb\_cnt,\,din\_cnt} \right)^2 \right]$$

Dabei steht dim_cnt für den Dimensions-Index der bis zur maximalen Dimension des Feature-Vektors 138 dim durchläuft.

$FV_{\dim\_cnt}$ steht für die den Parameterwert des Feature-Vektors-Signalwerts des Feature-Vektors 138 entsprechend des Index dim_cnt.

Cb_cnt steht für die Nummer des Signalgrundobjektprototyps in der Prototypendatenbank 115.

$Cb_{CB\_cnt,dim\_cnt}$ steht dementsprechend für den dim_cnt entsprechenden Parameterwert des Eintrags des Signalgrundobjektprototypen in der Prototypendatenbank 115, der dem Cb_cnt entsprechenden Signalgrundobjektprototypen zugeordnet ist.

$Dist_{FV\_CbE}$ steht für die erhaltene hier beispielhafte minimale euklidische Distanz. Bei der Suche nach der kleinsten euklidischen Distanz wird die Nummer Cb_cnt gemerkt, die den kleinsten Abstand produziert.

Zur Verdeutlichung wird ein z.B. Assembler-Code angeführt:

Anfang des Codes

```
Mov Cb_cnt,#Cb_anz        initialisiere Prototypendatenbank-Vector-Counter
Mov C, #0                 initialisiere Register C mit 0
Mov dist, maxvalue        initialisiere die Distanz mit Maximalwert
Mov num, not_valid_num    initialisiere die Nummer des nächsten Nachbarn mit nicht gültigem Wert
Mov Cb_adr, Cb_badr       initialisiere Prototypendatenbankadresse mit der Basisadresse der
                          Prototypendatenbank

Label_A: // next vector
    Mov SP, #0            initialisiere Zwischenspeicher
    Mov dim_cnt, #dim     initialisiere Dimensionszähler mit Feature-Vektordimension
    Label B: // next
    dimension
    MovA, $Cb_adr         lade Wert absolut von Prototypendatenbank-Adresse subtrahiere Wert absolut
    SubA, $FV_adr,        relativ von Feature Vektor Wert
    dim_cnt
    Mov B A               lade B Register mit Ergebnis
    MulA B                multipliziere A und B (=A²)
    AddA, SP              addiere Ergebnis zum Zwischenergebnis
    Mov SP, A             und merken
    Dec dim_cnt           nächste Vektorkomponente
    Inc Cb_adr            erhöhe Prototypendatenbankzeiger um eins
jnz dim_cnt, Label B      aber nur, wenn es nicht die letzte war
Cmp SP, dist             bewerte Prototypendatenbank-Eintrag (Signalgrundobjektprototypen)
jmpgt Label C
    Mov dist, SP          falls besserer Eintrag als bisheriges Optimum
    Mov num, Cb_cnt       Eintragsnummer und Abstand merken
Label C:
dec_Cb_cnt               nächster Prototypendatenbank-Eintrag
jnz Cb_cnt,Label A       aber nur wenn es nicht der letzte war
Ende des Codes
```

**EP 3 938 807 B1**

Das Vertrauensmaß für eine richtige Erkennung leitet sich aus der Streuung der zugrunde gelegten Basisdatenströme für einen Signalgrundobjektprototypen und dem Abstand des aktuellen Feature-Vektor-Werts des Feature-Vektorsignals 138 von deren Schwerpunkt her.

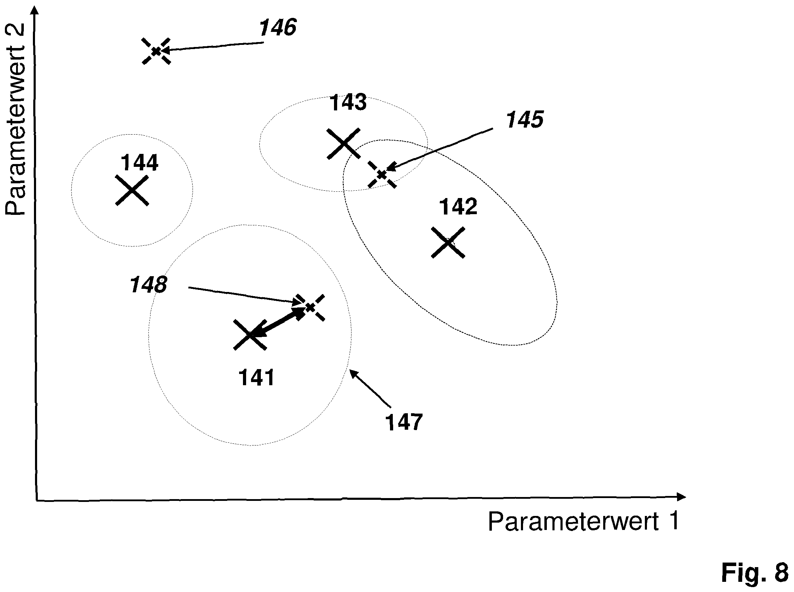

Fig. 8 demonstriert verschiedene Erkennungsfälle. Zur Vereinfachung ist die Darstellung für ein zweidimensionales Feature-Vektorsignal gewählt, bei dem jeder Feature-Vektorsignalwert einen ersten Parameterwert und einen zweiten Parameterwert umfasst. Dies dient hier nur dazu, die Methodik auf einem zweidimensionalen Blatt Papier besser darstellen zu können. In der Realität sind die Feature-Vektorsignalwerte des Feature-Vektorsignals 138 typischerweise immer multidimensional.

Es sind Schwerpunkte verschiedener Prototypen 141,142,143,144 eingezeichnet. In der Prototypendatenbank 115 kann nun, wie oben beschrieben, der halbe minimale Abstand dieser Signalgrundobjektprototypen in der Prototypendatenbank 115 eingespeichert sein. Dies wäre dann ein globaler Parameter, der für alle Signalgrundobjektprototypen der Prototypendatenbank 115 gleichermaßen gültig wäre. Diese Entscheidung wird mit Hilfe dieses minimalen Abstands durchgeführt. Sie setzt aber voraus, dass die Streuungen der Signalgrundobjektprototypen, die durch ihre Schwerpunktlagen 141,142,143,144 markiert sind, mehr oder weniger identisch sind. Ist die Abstandsermittlung (oder sonstige Bewertung) durch den Abstandsermittler 112 (oder Klassifikator) optimal, so ist dies auch der Fall. Dies entspräche einem Kreis um den Schwerpunkt 141,142,142,144 jedes der Signalgrundobjektprototypen der Prototypendatenbank 115.

Das lässt sich in der Realität aber nur selten erzielen. Eine Verbesserung der Erkennungsleistung lässt sich daher erzielen, wenn die Streubreite für den Signalgrundobjektprototypen der Prototypendatenbank 115 jeweils mitabgespeichert würde. Dies entspräche einem Kreis um jeden der Signalgrundobjektprototypen der Prototypendatenbank 115 mit einem für den Signalgrundobjektprototypen spezifischen Radius. Der Nachteil ist ein Anstieg der Rechenleistung.

Eine weitere Verbesserung der Erkennungsleistung lässt sich erzielen, wenn die Streubreite für den Signalgrundobjektprototypen der Prototypendatenbank 115 durch eine Ellipse modelliert wird. Hierzu müssen statt des Radius wie zuvor nun die Hauptachsendurchmesser der Streu-Ellipse und deren Verkippung gegen das Koordinatensystem in der Prototypendatenbank 115 für bevorzugt jeden der Signalgrundobjektprototypen der Prototypendatenbank 115 abgespeichert werden. Der Nachteil ist ein weiterer, massiver Anstieg der Rechenleistung und des Speicherbedarfes.

Natürlich lässt sich die Berechnung noch weiter verkomplizieren, was aber in der Regel den Aufwand nur massiv steigert und die Erkennerleistung für die Signalgrundobjektprototypen der Prototypendatenbank 115 nicht mehr wesentlich anhebt.

Es wird daher hier empfohlen, auf die einfachste der beschriebenen Möglichkeiten zurückzugreifen.

Die Lage der durch die Abstandsermittlung 112 in dem beispielhaft zweidimensionalen Parameterraum der Fig. 8 ermittelten aktueller Feature-Vektor-Signalwerte des Feature-Vektor-Signals 138 kann nun höchst unterschiedlich sein. So ist es denkbar, dass ein erster solcher Feature-Vektor-Signalwert 146 zu weit von den Schwerpunktkoordinaten 141,142,143,144 des Schwerpunkts irgendeines Signalgrundobjektprototypen der Prototypendatenbank 115 entfernt liegt. Dieser Abstandsschwellwert kann beispielsweise der besagte minimale halbe Prototypenabstand sein. Auch kann es sein, dass sich die Streubereiche der Signalgrundobjektprototypen um ihre jeweiligen Schwerpunkte 143,142 überlappen und ein z.B. zweiter ermittelter aktueller Feature-Vektor-Signalwert 145 des Feature-Vektor-Signals 138 in dem Überlappungsbereich liegt. In diesem Fall kann eine Hypothesenliste beide Signalgrundobjektprototypen mit unterschiedlichen Wahrscheinlichkeiten als beigefügtem Parameter (für unterschiedliche Abstände) enthalten. Es wird dann also nicht ein Signalgrundobjekt als das wahrscheinlichste an den Viterbi-Schätzer 113 übergeben, sondern ein Vektor aus möglicherweise vorliegenden Signalgrundobjekten an den Viterbi-Schätzer 113 übergeben. Aus der zeitlichen Abfolge dieser Hypothesenlisten sucht dann der Viterbi-Schätzer die mögliche Abfolge heraus, die die größte Wahrscheinlichkeit zu einer der vorgegebenen Signalgrundobjektfolgen in seiner Signalobjektdatenbank gegenüber allen möglichen Pfaden durch die als möglich erkannten Signalgrundobjekte 121 der vom Abstandsermittler 112 durch den Viterbi-Schätzer 113 empfangenen Hypothesenlisten aufweist. Dabei muss in einem solchen Pfad je Hypothesenliste genau ein erkannter Signalgrundobjektprototyp dieser Hypothesenliste durch diesen Pfad durchlaufen werden.

Im besten Fall liegt der aktuelle Feature-Vektor-Signalwert 148 im Streubereich (Schwellwertellipsoid) 147 um den Schwerpunkt 141 eines einzigen Signalgrundobjektprototyps 141 der damit sicher durch den Abstandsermittler 112 erkannt und als erkanntes Signalgrundobjekt 121 an den Viterbi-Schätzer 113 weitergegeben wird.

Es ist denkbar zur verbesserten Modellierung des Streubereichs eines einzelnen Signalgrundobjektprototyps, diesen durch mehrere hier kreisförmige Signalgrundobjektprototypen mit zugehörigen Streubereichen zu modellieren. Es können also mehrere Signalgrundobjektprototypen der Prototypendatenbank 115 denselben Signalgrundobjektprototypen im Verständnis einer Signalgrundobjektklasse darstellen. Die Gefahr dabei ist, dass sich Auf Grund der Aufteilung der Wahrscheinlichkeit eines Signalgrundobjektprototypens auf mehrere solcher Subsignalgrundobjektprototypen die Wahrscheinlichkeit des einzelnen Subsignalgrundobjektprototyps kleiner werden kann als die eines anderen Signalgrundobjektprototyp, dessen Wahrscheinlichkeit kleiner war als die des Ursprungssignalgrundobjektprototyps. Somit kann sich dieser andere Signalgrundobjektprototyp möglicherweise fälschlich durchsetzen.

Ein wesentliches Problem stellt des Weiteren die Rechenleistung dar, die zur Verfügung gestellt werden muss, um die Signalgrundobjektprototypen der Prototypendatenbank 115 sicher zu erkennen. Dies soll noch ein wenig diskutiert werden:
Ein entscheidender Punkt ist, dass der Rechenaufwand mit Cb_anz * dim, also mit der Anzahl der Code-Book und der Dimension steigt.

Bei einem nicht optimierten HMM-Erkenner beträgt die Anzahl der Assembler-befehle, die ausgeführt werden müssen, um eine Vektorkomponente zu berechnen, ca. 8 Schritte.

Die Anzahl A_Abst der notwendigen Assembler-Schritte zur Berechnung des Abstands eines einzelnen Signalgrundobjektprototyps CbE der Prototypendatenbank zu einem einzelnen Feature-Vektorsignalwert FV wird in etwa wie folgt berechnet:

$$A\_Abst = FV\_Dimension * 8 + 8$$

Dies führt zur Anzahl A_CB der Assembler-Schritte für die Ermittlung des Signalgrundobjektprototyps der Prototypendatenbank 115 mit dem geringsten Abstand:

$$A\_CB = Cb\_anz * (A\_Abst) + 4 = Cb\_anz * (FV\_Dimension * 8 + 8) + 4$$

Am Beispiel eines mittlerer HMM-Erkenners mit 50000 Signalgrundobjektprototypen (Anzahl der Signalgrundobjektprototyp-Einträge in der Prototypendatenbank=CB_anz) und 24 FV_Dimensionen (Anzahl der Parameterwerte in einem Feature-Vektor-Signalwert=Feature-Vektor-Dimension= FV_Dimension) beträgt die Anzahl der Schritte:

$$50000 * (24 * 8 + 8) + 4 \sim 10 \text{ Millionen Operationen pro}$$
$$\text{Feature-Vektorsignalwert des Feature-Vektorsignals 138}$$

Bei einer relativ niedrigen Abtastrate von 8kHz = 8000 FV pro Sekunde (Feature-Vektorsignalwerte des Feature-Vektorsignals 124 pro Sekunde) benötigt man schon eine Rechenleistung von 8GIpS (8 Milliarden Instruktionen pro Sekunde).

In Anbetracht der Herausforderungen zur Energieeinsparung in der Elektromobilität und/oder zur Reduktion des $CO_2$-Fotprints ist dies nicht akzeptabel.

Im Falle der Durchführung eines optimierten HMM-Erkennungsverfahrens durch den Abstandsermittler 112 bzw. den Klassifikator 112 wird daher, wie bereits erwähnt, der kleinste Abstand zwischen zwei Signalgrundobjektprototypen der Prototypendatenbank 115 vorberechnet und in der Prototypendatenbank 115 oder in der Abstandsberechnung 112 abgelegt. Dies hat den Vorteil, dass die Suche dann durch den Abstandsermittler 112 abgebrochen werden kann, wenn ein Abstand zwischen einem aktuellen Feature-Vektor-Signalwert des Feature-Vektor-Signals 138 und einem Signalgrundobjektprototypen der Prototypendatenbank 115 durch den Abstandsermittler 115 gefunden wurde, der kleiner als die Hälfte dieses kleinsten Abstands ist. Damit halbiert sich die mittlere Suchzeit für den Abstandsermittler 112. Weitere Optimierungen können vorgenommen werden, wenn die Prototypendatenbank 115 nach dem statistischen Vorkommen der Signalgrundobjektprototypen in realen Ultraschall-Echo-Signalen 1 sortiert wird. Hierdurch kann sichergestellt werden, dass die häufigsten Signalgrundobjektprototypen wesentlich schneller gefunden werden, was die Rechenzeit des Abstandsermittlers 112 bzw. Klassifikators 112 weiter verkürzt und den Stromverbrauch weiter senkt.

Für einen Abstandsermittler, der einen dermaßen optimierten HMM-Erkennungsprozess ausführt, stellt sich der Rechenleistungsbedarf nun wie folgt dar:
Wieder sind es 8 Schritte zur Berechnung des Abstands einer Vektor-Komponente. Die Schritte zur Berechnung des Abstands A_Abst eines Signalgrundobjektprototyp-Eintrags CbE in der Prototypendatenbank 115 zum aktuellen Feature-Vektorsignalwert FV des Feature-Vektorsignals 138 sind wieder:

$$A\_Abst = FV\_Dimension * 8 + 8$$

Die Anzahl der Schritte für die Ermittlung des Signalgrundobjektprototypen-Eintrags der Prototypendatenbank 115 mit dem geringsten Abstand A_CB mit Optimierung ist ein wenig höher:

$$A\_CB = Cb\_anz * (A\_Abst) + 4 = Cb\_anz * (FV\_Dimension * 8 + 10) + 4$$

Die zwei zusätzlichen Assembler-Befehle sind notwendig, um zu prüfen, ob sich der ermittelte Abstand zwischen dem aktuellen Feature-Vektorsignalwert und dem gerade untersuchten Signalgrundobjektprototypen der Prototypendatenbank 115 unterhalb des halben kleinsten Abstands zwischen den Signalgrundobjektprototypen der Prototypendatenbank 115 befindet.

Des Weiteren wird die Anzahl CB_Anz der Signalgrundobjektprototyp-Einträge der Prototypendatenbank 115 für mobile und energieautarke Applikationen auf 4000 Prototypendatenbank-Einträge von Signalgrundobjektprototypen in der Prototypendatenbank 115 oder noch geringer beschränkt.

Außerdem wird die Anzahl der Feature-Vektorsignalwerte pro Sekunde innerhalb des Feature-Vektor-Signals 138 durch die Filterung in dem Feature-Vektor-Extraktor 111 und Absenkung der Abtastrate in dem Feature-Vektor-Extraktor 111 abgesenkt.

Dies wird an einem einfachen Beispiel erläutert:
Der besagte Abstandsermittler 112 oder Klassifikator 112, der ein mittleres HMM-Erkennungsverfahren ausführt, wird nun mit einer Prototypendatenbank 115 mit nur noch einem knappen Zehntel der Einträge z.B. mit 4000 Einträgen CbE und weiterhin mit 24 Feature-Vektor-Signal-Dimensionen (also 24 Parametersignalen) betrieben.

Die Anzahl der Schritte beträgt nun

$$4000*(24*8+10)+4\sim\underline{808004}\ \text{Operationen pro Feature-Vektorsignalwert}$$

$$\text{des Feature-Vektorsignals 138}$$

Bei einer Absenkung der Feature-Vektorsignalwert-Rate auf 100 Feature-Vektorsignalwerte pro Sekunde, extrahiert aus einem 10 ms Zeitfenstern in dem Feature-Vektor-Extraktor 111 über beispielsweise je 80 Abtastwerte, und Abbruch der Suche wenn der Abstand des aktuellen Feature-Vektor-Signalwerts zur dem bearbeiteten Signalgrundobjektprototypen der Prototypendatenbank 115 unterhalb des halben kleinsten Prototypendatenbank-Eintrag-Abstands liegt, ergibt sich mindestens eine Halbierung des Aufwands bei geeigneter Sortierung der Prototypendatenbank 115.

Die erforderliche Rechenleistung sinkt dann auf <33DSP-Mips (33 Millionen Operationen pro Sekunde). In der Realität führt die Prototypendatenbank-Sortierung zu noch geringeren Rechenleistungsbedarfen von beispielsweise 30 Mips. Damit erst wird das System real-time fähig und in ein einzelnes IC und damit in einen Sensor überhaupt integrierbar.

Durch Vorselektion kann der Suchraum eingeschränkt werden. Eine Voraussetzung ist dabei eine Gleichverteilung der Daten = Schwerpunkte der Quadranten im geometrischen Quadrantenzentrum.

Die notwendige Verringerung des Umfangs der Prototypendatenbank 115 hat Vor- und Nachteile:
Eine Verringerung der Eintragsanzahl der Prototypendatenbank 115 erhöht sowohl die False-Acceptance-Rate FAR, also die falschen Signalgrundobjektprototypen, die als Signalgrundobjektprototypen akzeptiert werden, als auch die False-Rejection-Rate FRR, also die tatsächlich vorhandenen Signalgrundobjektprototypen, die nicht erkannt werden.

Auf der anderen Seite verringert sich hierdurch der Ressourcenbedarf (Rechenleistung, Chip-Flächen, Speicher, Stromverbrauch etc.).

Darüber hinaus kann die Vorgeschichte, d.h. die zuvor erkannten Signalgrundobjektprototypen, bei der Hypothesenbildung durch den Abstandsermittler 112 herangezogen werden. Ein geeignetes Modell hierfür ist das so genannte Hidden-Markov-Model HMM.

Für jeden Signalgrundobjektprototypen lässt sich somit ein Vertrauensmaß und ein Abstand zum gemessenen aktuellen Feature-Vektor-Signalwert des Feature-Vektor-Signals 138 herleiten, die vom Viterbi-Schätzer 113 auch weiterverarbeitet werden können. Auch ist es sinnvoll, jeweils eine Hypothesenliste für die erkannten Signalgrundobjektprototypen 121 auszugeben, die beispielsweise die zehn wahrscheinlichsten Signalgrundobjektprototypen mit der jeweiligen Wahrscheinlichkeit und Zuverlässigkeit der Erkennung enthält.

Da nicht jede zeitliche wie räumliche Signalgrundobjektsequenz einem Signalobjekt zugeordnet werden kann, ist es möglich, die zeitliche Aufeinanderfolge der Hypothesenlisten der aufeinanderfolgenden Frames durch einen Viterbi-Schätzer 113 auszuwerten.

Hierbei ist der Signalgrundobjektprototypen-Sequenzpfad durch die aufeinanderfolgenden Hypothesenlisten zu finden, der die höchste Wahrscheinlichkeit hat und in der Signalobjektdatenbank 116 des Viterbi-Schätzers 113 vorhanden ist.

Auch hierbei werden wiederum mindestens zwei Erkennungen geleistet:

1. Ist die wahrscheinlichste Folge von Signalgrundobjektprototypen eine der bereits eingespeicherten Folge von Signalgrundobjektprototypen oder nicht und mit welcher Wahrscheinlichkeit und Zuverlässigkeit?
2. Wenn sie eine der bereits gespeicherten Folge von Signalgrundobjektprototypen ist, welche ist es und mit welcher Wahrscheinlichkeit und Zuverlässigkeit?

Hierzu kann zum einen durch ein Lernprogramm ein solcher Prototype in Form eines Eintrags bestehend aus einer vorgegeben Folge von Signalgrundobjektprototypen eine Signalobjektdatenbank 116 eingegeben werden, zum anderen kann dies auch manuell über ein Type-In-Tool erfolgen, das die Eingabe dieser Folgen von Signalgrundobjektprototypen über eine Tastatur ermöglicht.

Mittels des Viterbi-Schätzers 113, kann aus der Abfolge der Hypothesenlisten des Abstandsermittlers 112 bzw. des Klassifikators 112 die wahrscheinlichste der vordefinierten Folgen von Signalgrundobjektprototypen für eine Folge von erkannten Signalgrundobjektprototypen 121 ermittelt werden. Die gilt insbesondere auch dann, wenn einzelne Signalgrundobjektprototypen auf Grund von Messfehlern durch den Abstandsermittler 112 bzw. den Klassifikator 112 falsch erkannt wurden. Insofern ist eine Übernahme von Folgen von Signalgrundobjektprototypenhypothesenlisten vom Abstandsermittler 112 bzw. Klassifikator 112, wie oben beschrieben, durch den Viterbi-Schätzer 113 sehr sinnvoll. Das Ergebnis ist das als wahrscheinlichstes erkanntes Signalobjekt 122 oder analog zur zuvor beschriebenen Emissionsberechnung des Abstandsschätzers 112 bzw. Klassifikators 112 eine Signalobjekthypothesenliste.

Als letztes sei die funktionale Komponente der Signalobjekt-Erkennungs-Maschine betrachtet. Diese ist in Fig. 7 als Viterbi-Schätzer 113 eingetragen. Diese Suche des Viterbi-Schätzers 113 greift auf die Signalobjektdatenbank 116 zu. Die Signalobjektdatenbank 116 wird zum einen durch ein Lerntool und zum anderen durch ein Werkzeug gespeist, bei denen diese Folgen von Signalgrundobjektprototypen durch textuelle Eingabe festgelegt werden können Die Möglichkeit eines Downloads in der Produktion sei hier nur der Vollständigkeit halber erwähnt.

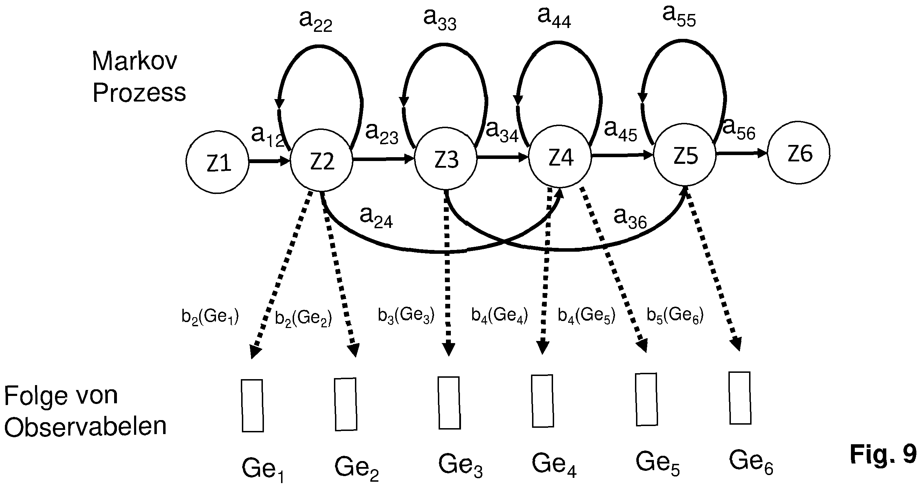

Basis der Sequenzerkennung für die zeitliche Folge der Signalgrundobjektprototypen im Viterbi-Schätzer 119 ist beispielhaft ein Hidden-Markov-Modell. Das Modell baut sich aus verschiedenen Zuständen auf. In dem in Fig. 9 angegebenen Beispiel werden diese Zustände durch nummerierte Kreise symbolisiert. In dem besagten Beispiel in Fig. 9 sind die Kreise von Z1 bis Z6 nummeriert. Zwischen den Zuständen bestehen Übergänge. Diese Übergänge werden in der Fig. 9 mit dem Buchstaben a und zwei Indizes i, j bezeichnet. Der erste Index i bezeichnet die Nummer des Ausgangsknotens der zweite Index j die Nummer des Zielknotens. Neben den Übergängen zwischen zwei verschiedenen Knoten bestehen auch Übergänge $a_{ii}$ oder $a_{jj}$, die wieder auf den Startknoten zurückführen. Darüber hinaus gibt es Übergänge, die es ermöglichen, Knoten zu überspringen. Aus der Sequenz ergibt sich somit jeweils eine Wahrscheinlichkeit, eine k-te Observable $b_k$ tatsächlich zu beobachten. Somit ergeben sich Folgen von Observablen, die mit vorberechenbaren Wahrscheinlichkeiten bk zu beobachten sind.

Wichtig ist dabei, dass ein jedes Hidden-Markov-Modell aus nicht beobachtbaren Zuständen $q^i$ besteht. Zwi-schen zwei Zuständen $q^i$ und $q^j$ besteht die Übergangswahrscheinlichkeit $a_{ij}$.

Somit lässt sich die Wahrscheinlichkeit p für den Übergang von $q^i$ auf $q^j$ schreiben als:

$$p\left(q_n^j \middle| q_{n-1}^i\right) \equiv a_{ij}$$

Dabei steht n für einen diskreten Zeitpunkt. Der Übergang findet also zwischen dem Schritt n mit Zustand q' und dem Schritt n+1 mit dem Zustand $q^j$ statt.

Die Emissionsverteilung $b_i(Ge)$ hängt vom Zustand $q^i$ ab. Wie bereits erläutert, ist dies die Wahrscheinlichkeit, die Elementargeste Ge (die Observable) zu beobachten, wenn sich das System (Hidden-Markov-Modell) im Zustand $q^i$ befindet:

$$p\left(Ge \middle| q^i\right) \equiv b_i(Ge)$$

Um das System starten zu können, müssen die Anfangszustände festgelegt sein. Dies geschieht durch einen Wahrscheinlichkeitsvektor $\pi_i$. Danach lässt sich angeben, dass ein Zustand $q^i$ mit der Wahrscheinlichkeit $\pi_i$ ein Anfangs-zustand ist:

$$p\left(q^i{}_1\right) \equiv \pi_i$$

Wichtig ist, dass für jede Folge von Signalgrundobjektprototypen ein neues Modell erstellt werden muss. In einem Modell M soll die Beobachtungswahrscheinlichkeit für eine zeitliche Beobachtungsfolge von Signalgrundobjekt-prototypen

$$\vec{Ge} = \left(Ge_1, Ge_2, ... Ge_N\right)$$

bestimmt werden.

Dies entspricht einer nicht unmittelbar beobachtbaren zeitlichen Zustandsfolge, die der folgenden Folge entspricht:

$$\vec{Q} = \left(q_1, q_2, ..... q_N\right)$$

Die von dem Modell M, der zeitlichen Zustandsfolge Q und der zeitlichen Beobachtungsfolge Ge abhängige Wahrscheinlichkeit p, diese Zustandsfolge Q zu beobachten, ist:

$$p\left(\vec{Ge}\,\middle|\,\vec{Q},M\right) = p\left(Ge_1, Ge_2, ... Ge_N \middle| q_1, q_2, ..... q_N\right)$$
$$= p\left(Ge_1 \middle| q_1\right) \cdot p\left(Ge_2 \middle| q_2\right) \cdot ........ p\left(Ge_N \middle| q_N\right)$$
$$= \prod_{n=1}^{N} p\left(Ge_n \middle| q_n\right)$$
$$= \prod_{n=1}^{N} b_n\left(Ge_n\right)$$

Damit ergibt sich als Wahrscheinlichkeit einer Zustandsfolge $\overline{Q} = (q_1, q_2, ..... q_N)$ im Modell M:

$$p\left(\vec{Q}\,\middle|\,M\right) = p\left(q_1, q_2, ..... q_N \middle| M\right)$$
$$= p\left(q_1\right) \cdot p\left(q_2 \middle| q_1\right) \cdot p\left(q_3 \middle| q_1, q_2\right) \cdot ..... p\left(q_N \middle| q_1, q_2, ... q_{N-1}\right)$$
$$= p\left(q_1\right) \prod_{n=2}^{N} p\left(q_n \middle| q_{n-1}\right)$$
$$= \pi_1 \prod_{n=2}^{N} a_{(n-1)n}$$

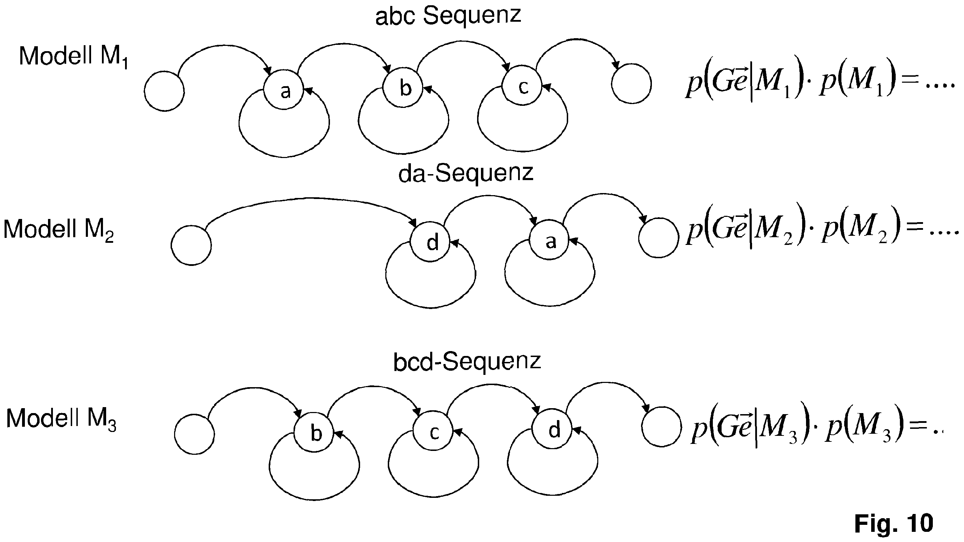

Somit ergibt sich als Wahrscheinlichkeit für die Erkennung eines Signalobjekts gleich einer Folge von Signalgrundobjektprototypen (siehe auch Fig. 10):

$$p\left(\vec{Ge}\,\middle|\,M_j\right) = \sum_{all\,Q_k} p\left(\vec{Ge}\,\middle|\,Q_k, M_j\right) p\left(\vec{Q}_k \middle| M_j\right)$$
$$= \sum_{all\,Q_k} \left(\prod_{n=1}^{N} b_n\left(Ge_n\right)\right)\left(\pi_1 \prod_{n=2}^{N} a_{(n-1)n}\right)$$

Dabei erfolgt die Bestimmung des wahrscheinlichsten Signalobjekt-Modells (Signalobjekt) für die beobachtete Emission Ge durch diese Summation der Einzelwahrscheinlichkeiten über alle möglichen Pfade $Q_k$, die zu dieser beobachteten Folge von Signalgrundobjektprototypen Ge führen.

$$p\left(\vec{Ge}\middle|M_j\right) = \sum_{all\,Q_k} p\left(\vec{Ge}\middle|Q_k, M_j\right) p\left(\vec{Q}_k\middle|M_j\right)$$

$$= \sum_{all\,Q_k}\left(\prod_{n=1}^{N} b_n(Ge_n)\right)\left(\pi_1 \prod_{n=2}^{N} a_{(n-1)n}\right)$$

Die Summierung über alle möglichen Pfade Q ist auf Grund des möglichen Rechenaufwands nicht unproblematisch. In der Regel wird daher sehr frühzeitig abgebrochen. Es wird daher vorgeschlagen, nur den wahrscheinlichsten Pfad $Q_k$ zu nutzen. Dies wird im Folgenden diskutiert.

Die Berechnung erfolgt durch rekursive Berechnung. Die Wahrscheinlichkeit $a_n(i)$ zum Zeitpunkt n das System im Zustand $q^i$ zu beobachten lässt sich wie folgt berechnen:

$$\alpha_n(i) = p\left(Ge_1, Ge_2, \ldots\ldots Ge_n; q_n = q^i\right) \equiv p\left(Ge_i^n, q_n^i\right)$$

$$\alpha_{n+1}(j) = \left[\sum_{i=1}^{S} \alpha_n(i) \cdot a_{ij}\right] b_j(Ge_{n+1})$$

Hierbei wird über alle S möglichen Pfade summiert, die in den Zustand $q^{i+1}$ hineinführen
Es wird dabei angenommen, dass die Gesamtwahrscheinlichkeit in den Zustand $q^i_{n+1}$ zu gelangen vom besten Pfad dominiert wird. Dann kann die Summe mit geringem Fehler vereinfacht werden.

$$\alpha_{n+1}^{*}(j) = \left[\max_{i}\left(\alpha_n^{*}(i) \cdot a_{ij}\right)\right] b_j(c_{n+1})$$

Durch Rückverfolgung vom letzten Zustand aus erhält man nun den besten Pfad.

Die Wahrscheinlichkeit dieses Pfades ist ein mathematisches Produkt. Daher reduziert eine logarithmische Berechnung das Problem auf ein reines Summationsproblem. Dabei entspricht die Wahrscheinlichkeit für die Erkennung eines Signalobjekts, was der Erkennung eines Modells $M_j$ entspricht, der Bestimmung des wahrscheinlichsten Signalobjekt-Modells für die beobachtete Emission X. Diese erfolgt nun ausschließlich über den besten möglichen Pfad Qbest

$$p\left(\vec{Ge}\middle|M_j\right) = \sum_{all\,Q_k}\left(\prod_{n=1}^{N} b_n(Ge_n)\right)\left(\pi_1 \prod_{n=2}^{N} a_{(n-1)n}\right)$$

Diese wird damit zu

$$p\left(\vec{Ge}\middle|M_j\right) = p\left(\vec{Ge}\middle|Q_{best}, M_j\right) p\left(\vec{Q}_{best}\middle|M_j\right)$$

$$= \exp\left(\ln(\pi_1) + \ln(b_1(Ge_1)) + \sum_{n=2}^{N} \ln(b_n(Ge_n)) + \ln(a_{(n-1)n})\right)$$

Es ist nun von besonderer Bedeutung, dass die Prototypendatenbank 115 nur Signalgrundobjektprototypen enthält.

Die erkannten Signalobjekte werden mit den erkannten Parametern anstelle der Abtastwerte übertragen. Dies führt zu einer Kompression der Daten ohne den Signalcharakter zu verlassen.

Es ist von besonderer Wichtigkeit, dass hier keine Erkennung von Hindernisobjekten stattfindet, die sich im Umfeld des Fahrzeugs befinden. Vielmehr werden Strukturen innerhalb des Ultraschall-Echo-Signals 1 erkannt und zur Komprimierung genutzt.

Erst dies ermöglicht die bewertungsfreie Rekonstruktion des Signals im Steuergerät nach dem Empfang der Daten.

Im Gegensatz zum Stand der Technik ist es also nicht das Ziel der vorliegenden Erfindung, Hindernisobjekte, die sich im Umfeld des Fahrzeugs befinden zu detektieren und zu Klassifizieren und dadurch eine Datenkompression herbeizuführen, sondern das Ultraschall-Echos-Signal 1 selbst möglichst verlustfrei durch Beschränkung auf anwendungsrelevante Signalformbestanteile zu komprimieren und zu übertragen.

Der Ultraschallsensor überträgt dann die so komprimierten Daten, bevorzugt nur die Kodierungen (Symbole) der so erkannten Prototypen, deren Amplitude und/oder zeitliche Streckung und den Auftretenszeitpunkt (Zeitstempel), an das Rechnersystem. Hierdurch wird die EMV Belastung durch die Datenübertragung über den Datenbus zwischen Ultraschallsensor und Rechnersystem minimiert und es können Statusdaten des Ultraschallsensors zur Systemfehlererkennung in den zeitlichen Zwischenräumen an das Rechnersystem über den Datenbus zwischen Ultraschallsensor und Rechnersystem übertragen werden, was die Latenzzeit verbessert. Im Zusammenhang mit der Erfindung wurde erkannt, dass des von Vorteil sein kann, die Übertragung der Daten über den Datenbus zu priorisieren. Diese Priorisierung betrifft aber nicht, wie aus dem Stand der Technik bekannt, die Priorisierung gegenüber anderen Busteilnehmern. Vielmehr ist es so, dass es sich bei der Datenverbindung zwischen dem Sensor und dem Rechnersystem, des Fahrzeugs in der Regel um Punkt-zu-Punkt-Verbindungen handelt. Hier ist daher vielmehr die Priorisierung dahingehend zu verstehen, welches Datum der vom Sensorsystem ermittelten Daten zeitlich als erstes Steuergerät übertragen werden muss. Meldungen sicherheitskritischer Fehler des Sensors an das Rechnersystem haben dabei die höchste Priorität, da diese die Gültigkeit der Messdaten des Ultraschallsensors mit hoher Wahrscheinlichkeit beeinträchtigen. Diese Daten werden vom Sensor an das Rechnersystem gesendet. Die zweithöchste Priorität haben Anfragen des Rechnersystems zur Durchführung sicherheitsrelevanter Selbsttests. Solche Befehle werden vom Rechnersystem an den Sensor gesendet. Die dritthöchste Priorität haben die Daten des Ultraschallsensors selbst, da die Latenzzeit nicht erhöht werden darf. Alle anderen Daten haben niedrigere Priorität für die Übertragung über den Datenbus,

Es ist besonders vorteilhaft, wenn das Verfahren zur Übertragung von Sensordaten, insbesondere eines Ultraschallsensors, von einem Sensor zu einem Rechnersystem, insbesondere in einem Fahrzeug, umfassend das Aussenden eines Ultraschall-Bursts mit einem Anfang 57 und Ende 56 des Aussendens des Ultraschall-Bursts und umfassend das Empfangen eines Ultraschallsignals und Bilden eines Empfangssignals für eine Empfangszeit $T_E$ zumindest ab dem Ende 56 des Aussendens des Ultraschall-Bursts sowie umfassend das Übertragen der komprimierten Daten über einen Datenbus, insbesondere einen Eindrahtdatenbus, an das Rechnersystem so gestaltet wird, dass die Übertragung 54 der Daten vom Sensor an das Rechnersystem mit einem Startbefehl 53 von dem Rechnersystem an den Ultraschallsensor über den Datenbus und vor dem Ende 56 des Aussendens des Ultraschall-Bursts beginnt oder nach einem Startbefehl 53 von dem Rechnersystem an den Sensor über den Datenbus und vor dem Anfang 57 des Aussendens des Ultraschall-Bursts beginnt. Die Übertragung 54 erfolgt dann nach dem Startbefehl 53 periodisch fortlaufend bis zum Ende der Datenübertragung 58. Dieses Ende der Datenübertragung 58 liegt dann zeitlich nach dem Ende der Empfangszeit $T_E$.

Eine weitere Variante des vorgeschlagenen Verfahrens sieht somit als ersten Schritt der Datenkompression das Bilden eines Feature-Vektor-Signals (Strom von Feature-Vektoren mit n Feature-Vektorwerten und n als Dimension des Feature-Vektors) aus dem Empfangssignal vor. Ein solches Feature-Vektor-Signal kann mehrere analoge und digitale Datensignale umfassen. Es stellt also eine zeitliche Folge von mehr oder weniger komplexen Daten/Signal-Strukturen dar. Im einfachsten Fall kann es als vektorielles Signal bestehend aus mehreren Teilsignalen aufgefasst werden.

Beispielsweise kann es sinnvoll sein, eine erste und/oder höhere zeitliche Ableitung des Empfangssignals oder das einfache oder mehrfache Integral des Empfangssignals zu bilden, die dann Teilsignale innerhalb des Feature-Vektor-Signals sind.

Es kann auch ein Hüllkurvensignal des Empfangssignals (Ultraschall-Echo-Signal) gebildet werden, das dann ein Teilsignal innerhalb des Feature-Vektor-Signals 138 sein kann.

Des Weiteren kann es sinnvoll sein, das Empfangssignal mit dem ausgesendeten Ultraschallsignal zu falten und so ein Korrelationssignal zu bilden, das dann ein Teilsignal innerhalb des Feature-Vektor-Signals sein kann. Dabei kann zum einen das Signal als ausgesendetes Ultraschallsignal verwendet werden, das zur Ansteuerung des Treibers für den Sender verwendet wurde, oder zum anderen beispielsweise ein Signal verwendet wurde, das am Sender gemessen wurde und so der tatsächlich abgestrahlten Schallwelle besser entspricht.

Schließlich kann es sinnvoll sein, durch Optimalfilter (englisch matched filter) das Auftreten vorbestimmter Signalobjekte zu detektieren und ein Optimalfiltersignal für das jeweilige Signalobjekt einiger der vorbestimmten Signalobjekte zu bilden. Unter Optimalfilter (engl. matched filter) versteht man hierbei ein Filter, welches das Signal-Rausch-Verhältnis (engl. signal to noise ratio, SNR) optimiert. In dem gestörten Ultraschallempfangssignal sollen die vordefinierten Signalobjekte erkannt werden. In der Literatur findet man auch häufig die Bezeichnungen Korrelationsfilter, Signal-angepasstes Filter (SAF) oder nur angepasstes Filter. Das Optimalfilter dient zur optimalen Bestimmung des Vorhandenseins (Detektion) der Amplitude und/oder der Lage einer bekannten Signalform, d.h. des vorbestimmten Signalobjekts, in Gegenwart von Störungen (Parameterschätzung). Diese Störungen können beispielsweise Signale anderer Ultraschallsender und/oder Bodenechos sein.

Die Optimalfilter-Ausgangssignale sind dann bevorzugt Teilsignale innerhalb des Feature-Vektor-Signals.

Bestimmte Ereignisse können in gesonderten Teilsignalen des Feature-Vektor-Signals signalisiert werden. Diese Ereignisse sind Signalgrundobjekte im Sinne dieser Erfindung. Signalgrundobjekte umfassen also nicht Signalformen, wie beispielsweise Rechteck-Pulse oder Wavelets oder Wellenzüge, sondern markante Punkte im Verlauf des Empfangssignals und/oder im Verlauf von daraus abgeleiteten Signalen, wie beispielsweise einem Hüllkurvensignal (Ultraschall-Echo-Signal), das beispielsweise durch Filterung aus dem Empfangssignal gewonnen werden kann.

Ein anderes Signal, das ein Teilsignal des Feature-Vektor-Signals sein kann, kann beispielsweise signalisieren, ob die Hüllkurve des Empfangssignals, das Ultraschall-Echo-Signal, einen vorgegeben dritten Schwellwert kreuzt. Es handelt sich also um ein Signal, dass das Vorliegen eines Signalgrundobjekts innerhalb des Empfangssignal und damit des Feature-Vektorsignals signalisiert.

Ein anderes Signal, das ein Teilsignal des Feature-Vektor-Signals sein kann, kann beispielsweise signalisieren, ob die Hüllkurve des Empfangssignals, das Ultraschall-Echo-Signal, einen vorgegeben vierten Schwellwert, der mit dem dritten Schwellwert identisch sein kann, aufsteigend kreuzt. Es handelt sich also um ein Signal, dass das Vorliegen eines Signalgrundobjekts innerhalb des Empfangssignal und damit des Feature-Vektorsignals signalisiert.

Ein anderes Signal, das ein Teilsignal des Feature-Vektor-Signals sein kann, kann beispielsweise signalisieren, ob die Hüllkurve des Empfangssignals, das Ultraschall-Echo-Signal, einen vorgegeben fünften Schwellwert, der mit dem dritten oder vierten Schwellwert identisch sein kann, abfallend kreuzt. Es handelt sich also um ein Signal, das das Vorliegen eines Signalgrundobjekts innerhalb des Empfangssignal und damit des Feature-Vektorsignals signalisiert.

Ein anderes Signal, das ein Teilsignal des Feature-Vektor-Signals sein kann, kann beispielsweise signalisieren, ob die Hüllkurve des Empfangssignals, das Ultraschall-Echo-Signal, ein Maximum oberhalb eines sechsten Schwellwerts, der mit den vorgenannten dritten bis fünften Schwellwerten identisch sein kann, aufweist. Es handelt sich also um ein Signal, das das Vorliegen eines Signalgrundobjekts innerhalb des Empfangssignal und damit des Feature-Vektorsignals signalisiert.

Ein anderes Signal, das ein Teilsignal des Feature-Vektor-Signals sein kann, kann beispielsweise signalisieren, ob die Hüllkurve des Empfangssignals, das Ultraschall-Echo-Signal, ein Minimum oberhalb eines siebten Schwellwerts, der mit den vorgenannten dritten bis sechsten Schwellwerten identisch sein kann, aufweist. Es handelt sich also um ein Signal, das das Vorliegen eines Signalgrundobjekts innerhalb des Empfangssignal und damit des Feature-Vektorsignals signalisiert.

Dabei wird bevorzugt ausgewertet, ob das zumindest eine vorausgehende Maximum des Ultraschall-Echo-Signals einen Mindestabstand zu dem Minimum hat, um eine Detektion von Rauschen zu vermeiden. Andere Filterungen sind an dieser Stelle denkbar. Auch kann geprüft werden, ob der zeitliche Abstand zwischen diesem Minimum und einem vorausgehenden Maximum größer ist, als ein erster zeitlicher Mindestabstand. Die Erfüllung dieser Bedingungen setzt jeweils ein Flag oder Signal, das selbst wieder bevorzugt ein Teilsignal des Feature-Vektor-Signals ist.

Ebenso sollte in analoger Weise überprüft werden, ob die zeitlichen und amplitudenmäßigen Abstände der anderen Signalobjekte gewissen Plausibilitätsanforderungen, wie zeitliche Mindestabstände und/oder Mindestabstände in der Amplitude genügen. Auch aus diesen Prüfungen können sich weitere, auch analoge, binäre oder digitale Teilsignale abgeleitet werden, die somit das Feature-Vektor-Signal in seiner Dimensionalität weiter vergrößern.

Gegebenenfalls kann das Feature-Vektor-Signal in einer Signifikanzsteigerungsstufe noch zu einem signifikanten Feature-Vektor-Signal z.B. durch eine lineare Abbildung oder ein Matrix-Polynom höherer Ordnung noch transformiert werden. In der Praxis hat sich aber gezeigt, dass dies zumindest für die heutigen Anforderungen noch nicht nötig ist.

Gemäß dem vorgeschlagenen Verfahren folgen das Erkennen von Signalobjekten und deren Klassifizieren in erkannte Signalobjektklassen innerhalb des Empfangssignals auf Basis des Feature-Vektor-Signals oder des signifikanten Feature-Vektor-Signals.

Liegt beispielsweise die Amplitude des Ausgangssignals eines Optimalfilters, und damit eines Teilsignals des Feature-Vektor-Signals oberhalb eines gegebenenfalls Optimalfilter spezifischen achten Schwellwerts, so kann das Signalobjekt, für dessen Detektion der Optimalfilter ausgelegt ist, als erkannt gelten. Dabei werden vorzugsweise auch andere Parameter berücksichtigt. Wurde beispielsweise ein Ultraschall-Burst mit ansteigender Frequenz während des Bursts gesendet (genannt Chirp-Up), so wird auch ein Echo erwartet, dass diese Modulationseigenschaft aufweist. Stimmt die Signalform des Ultraschall-Echo-Signals, beispielsweise eine dreieckige Signalform des Ultraschall-Echo-Signals, zeitlich mit einer erwarteten Signalform überein, aber nicht jedoch die Modulationseigenschaft, so handelt es sich eben nicht um ein Echo des Senders, sondern um ein Störsignal, das von anderen Ultraschallsendern herrühren kann oder aus Überreichweiten. Insofern kann das System dann zwischen Eigenechos und Fremdechos unterscheiden, wodurch ein und dieselbe Signalform zwei unterschiedlichen Signalobjekten, nämlich Eigenechos und Fremdechos, zugeordnet wird. Die Übertragung der Eigenechos über den Datenbus vom Sensor zum Rechnersystem erfolgt dabei vorzugsweise priorisiert gegenüber der Übertragung der Fremdechos, da erstere in der Regel sicherheitsrelevant sind und zweite in der Regel nicht sicherheitsrelevant sind.

Typischerweise wird jedem erkannten Signalobjekt zumindest ein Signalobjektparameter zugeordnet oder für dieses Signalobjekt bestimmt. Hierbei handelt es sich bevorzugt um einen Zeitstempel, der angibt, wann das Signalobjekt empfangen wurde. Dabei kann der Zeitstempel sich beispielsweise auf den zeitlichen Beginn des Signalobjekts im Empfangssignal oder das zeitliche Ende oder die zeitliche Lage des zeitlichen Schwerpunkts des Signalobjekts etc. beziehen. Auch sind andere Signalobjektparameter, wie Amplitude, Streckung etc. denkbar. In einer Variante des erfindungsgemäßen Verfahrens wird somit zumindest einer der zugeordneten Signalobjektparameter zusammen mit einem Symbol für die zumindest eine erkannte Signalobjektklasse übertragen. Der Signalobjektparameter ist bevorzugt ein Zeitwert als Zeitstempel und gibt eine zeitliche Position an, die geeignet ist, daraus auf die (Empfangs-)Zeit seit Aussendung eines vorausgegangenen Ultraschall-Bursts schließen zu können. Vorzugsweise erfolgt daraus später die Ermittlung eines ermittelten Abstands eines Objekts in Abhängigkeit von einem derart ermittelten und übertragenen Zeitwert.

Es folgt schließlich das priorisierte Übertragen der erkannten Signalobjektklassen in Form zugeordneter Symbole mit Zeitstempeln vorzugsweise jeweils zusammen mit den zugeordneten Signalobjektparametern. Die Übertragung kann auch in komplexeren Datenstrukturen (englisch: Records) erfolgen. Beispielsweise ist es denkbar, zuerst die Zeitpunkte der erkannten sicherheitsrelevanten Signalobjekte (z.B. identifizierte Hindernisse) zu übertragen und dann die erkannten Signalobjektklassen der sicherheitsrelevanten Signalobjekte. Hierdurch wird die Latenzzeit weiter verringert.

Das erfindungsgemäße Verfahren umfasst zumindest in einer Variante das Ermitteln eines Chirp-Werts als zugeordneten Signalobjektparameter, der angibt, ob es sich bei dem erkannten Signalobjekt um ein Echo eines Ultraschall-Sende-Bursts mit Chirp-Up oder ein Chirp-Down oder ein No-Chirp-Eigenschaften handelt. Chirp-Up bedeutet, dass die Frequenz des Empfangssignals innerhalb des Signalobjekts ansteigt. Chirp-Down bedeutet, dass die Frequenz des Empfangssignals innerhalb des Signalobjekts abfällt. No-Chirp bedeutet, dass die Frequenz des Empfangssignals innerhalb des Signalobjekts im Wesentlichen gleich bleibt. An dieser Stelle sei auf DE-B-10 2017 123 049, DE-B-10 2017 123 050, DE-B-10 2017 123 051 und DE-B-10 2017 123 052 hingewiesen, die vollumfänglicher Teil dieser Erfindung sind.

In einer Variante des erfindungsgemäßen Verfahrens wird somit auch ein Confidence-Signal durch Bildung der Korrelation, z.B. durch Bildung eines zeitkontinuierlichen oder zeitdiskreten Korrelationsintegrals, zwischen dem Empfangssignal oder statt des Empfangssignals mit einem aus dem Empfangssignal abgeleiteten Signal einerseits und einem Referenzsignal, beispielsweise dem Ultraschallsendesignal oder einem anderen erwarteten Wavelet, andererseits gebildet. Das Confidence-Signal ist dann typischerweise ein Teilsignal des Feature-Vektor-Signals, also eine Komponente des Feature-Vektors, der aus einer Folge vektorieller Abtastwerte (Feature-Vektor-Werte) besteht.

In einer Variante des erfindungsgemäßen Verfahrens wird auf dieser Basis auch ein Phasen-Signal gebildet, dass die Phasenverschiebung beispielsweise des Empfangssignals oder eines daraus gebildeten Signals (z.B. des Confidence-Signals) gegenüber einem Referenzsignal, beispielsweise dem Ultraschallsendesignal und/oder einem anderen Referenzsignal angibt. Das Phasen-Signal ist dann typischerweise ebenfalls ein Teilsignal des Feature-Vektor-Signals, also eine Komponente des Feature-Vektors, der aus einer Folge vektorieller Abtastwerte besteht.

In ähnlicher Weise kann in einer weiteren Variante des erfindungsgemäßen Verfahrens ein Phasen-Confidence-Signal durch Bildung der Korrelation zwischen dem Phasen-Signal oder einem daraus abgeleiteten Signal einerseits und einem Referenzsignal gebildet werden und als Teilsignal des Feature-Vektor-Signals verwendet werden. Das Phasen-Confidence-Signal ist dann typischerweise ebenfalls ein Teilsignal des Feature-Vektor-Signals, also eine Komponente des Feature-Vektors, der aus einer Folge vektorieller Abtastwerte besteht.

Bei der Auswertung des Feature-Vektor-Signals kann es dann sinnvoll sein, einen Vergleich des Phasen-Confidence-Signals mit einem oder mehreren Schwellwerten zur Erzeugung eines diskretisierten Phasen-Confidence-Signals durchzuführen, das selbst wieder ein Teilsignal des Feature-Vektor-Signals werden kann.

Die Auswertung des Feature-Vektor-Signals und/oder des signifikanten Feature-Vektor-Signals kann in einer Variante des vorgeschlagenen Verfahrens so erfolgen, dass ein oder mehrere Abstandswerte zwischen dem Feature-Vektor-Signal und einem oder mehreren Signalobjektprototypenwerten für erkennbare Signalobjektklassen gebildet werden. Ein solcher Abstandswert kann boolesch, binär, diskret, digital oder analog sein. Vorzugsweise werden alle Abstandswerte in einer nichtlinearen Funktion miteinander verknüpft. So kann bei einem erwarteten Chirp-Up-Echo in Dreiecksform ein empfangenes Chirp-Down-Echo in Dreiecksform verworfen werden. Dieses Verwerfen ist im Sinne der Erfindung ein nichtlinearer Vorgang.

Umgekehrt kann das Dreieck im Empfangssignal unterschiedlich ausgeprägt sein. Dies betrifft zuallererst die Amplitude des Dreiecks im Empfangssignal. Ist die Amplitude im Empfangssignal hinreichend, so liefert beispielsweise das diesem Dreieckssignal zugeordnete Optimalfilter ein Signal oberhalb eines vorgegeben neunten Schwellwerts. In dem Fall kann dann beispielsweise diese Signalobjektklasse (Dreieckssignal) einem erkannten Signalobjekt zum Zeitpunkt des Überschreitens zugeordnet werden. In dem Fall unterschreitet der Abstandswert zwischen dem Feature-Vektor-Signal und dem Prototypen (hier der neunte Schwellwert) einen oder mehrere vorbestimmte, binäre, digitale oder analoge Abstandswerte (hier 0= Kreuzung).

Bei einer weiteren Variante des erfindungsgemäßen Verfahrens handelt es sich bei mindestens einer Signalobjektklasse um Wavelets, die durch Schätzvorrichtungen (z.B. Optimalfilter) und/oder Schätzverfahren (z.B. Schätzprogramme, die in einem digitalen Signalprozessor ablaufen) geschätzt und damit detektiert werden. Mit dem Begriff Wavelet werden Funktionen bezeichnet, die einer kontinuierlichen oder einer diskreten Wavelet-Transformation zugrunde gelegt werden können. Das Wort "Wavelet" ist eine Neuschöpfung aus dem französischen "ondelette", das "kleine Welle" bedeutet und teils wörtlich ("onde"→"wave"), teils phonetisch ("-lette"→"-let") ins Englische übertragen wurde. Der Ausdruck "Wavelet" wurde in den 1980er Jahren in der Geophysik (Jean Morlet, Alex Grossmann) für Funktionen geprägt, welche die Kurzzeit-Fourier-Transformation verallgemeinern, wird jedoch seit Ende der 1980er Jahre ausschließlich in der heute üblichen Bedeutung verwendet. In den 1990er Jahren entstand ein regelrechter Wavelet-Boom, ausgelöst durch die Entdeckung von kompakten, stetigen (bis hin zu beliebiger Ordnung der Differenzierbarkeit) und orthogonalen Wavelets durch Ingrid Daubechies (1988) und die Entwicklung des Algorithmus der schnellen Wavelet-Transformation (FWT) mit Hilfe der Multiskalenanalyse (MultiResolution Analysis - MRA) durch Stephane Mallat und Yves Meyer (1989).

Im Gegensatz zu den Sinus- und Kosinus-Funktionen der Fourier-Transformation besitzen die meistverwendeten Wavelets nicht nur Lokalität im Frequenzspektrum, sondern auch im Zeitbereich. Dabei ist "Lokalität" im Sinne kleiner Streuung zu verstehen. Die Wahrscheinlichkeitsdichte ist das normierte Betragsquadrat der betrachteten Funktion bzw. von deren Fourier-Transformierten. Dabei ist das Produkt beider Varianzen immer größer als eine Konstante, analog zur Heisenberg'schen Unschärferelation. Aus dieser Einschränkung heraus entstanden in der Funktionalanalysis die Paley-Wiener-Theorie (Raymond Paley, Norbert Wiener), ein Vorläufer der diskreten Wavelet-Transformation, und die Calderón-Zygmund-Theorie (Alberto Calderön, Antoni Zygmund), die der kontinuierlichen Wavelet-Transformation entspricht.

Das Integral einer Wavelet-Funktion ist zwar immer 0, daher nimmt in der Regel die Wavelet-Funktion die Form von nach außen hinauslaufenden (kleiner werdenden) Wellen (also "Wellchen" = Ondelettes = Wavelets) an. Im Sinne dieser Erfindung sollen aber auch Wavelets zulässig sein, die ein von 0 verschiedenes Integral aufweisen. Hier sei beispielhaft die im Folgenden beschriebenen Rechteck und Dreiecks-Wavelets genannt. Diese weitere Interpretation des Begriffs "Wavelet" ist im amerikanischen Sprachraum verbreitet und von daher bekannt. Diese weitere Interpretation soll auch hier gelten.

Wichtige Beispiele für Wavelets mit einem Integral von 0 sind das Haar-Wavelet (Alfréd Haar 1909), die nach Ingrid Daubechies benannten Daubechies-Wavelets (um 1990), die ebenfalls von ihr konstruierten Coiflet-Wavelets und das eher theoretisch bedeutsame Meyer-Wavelet (Yves Meyer, um 1988).

Wavelets gibt es für Räume beliebiger Dimension, meist wird ein Tensorprodukt einer eindimensionalen Wavelet-Basis verwendet. Auf Grund der fraktalen Natur der Zwei-Skalen-Gleichung in der MRA haben die meisten Wavelets eine komplizierte Gestalt, die meisten haben keine geschlossene Form. Dies ist deswegen von besonderer Bedeutung, da das zuvor erwähnte Feature-Vektor-Signal ja mehrdimensional ist und daher die Verwendung multidimensionaler Wavelets zur Signalobjekterkennung zulässt.

Eine besondere Variante des vorgeschlagenen Verfahrens ist daher die Verwendung multidimensionaler Wavelets mit mehr als zwei Dimensionen zur Signalobjekterkennung. Insbesondere wird die Verwendung entsprechender Optimalfilter zur Erkennung solcher Wavelets mit mehr als zwei Dimensionen vorgeschlagen, um das Feature-Vektor-Signal um weitere zur Erkennung geeignete Teilsignale gegebenenfalls zu ergänzen.

Ein besonders geeignetes Wavelet ist beispielsweise ein Dreiecks-Wavelet. Dieses zeichnet sich durch einen Startzeitpunkt, einen dem Startzeitpunkt zeitlich nachfolgenden, zeitlich im Wesentlichen linearen Anstieg der Wavelet-Amplitude bis zu einem Maximum der Amplitude und einen dem Maximum des Dreiecks-Wavelets zeitlich nachfolgenden, im Wesentlichen linearen Abfall der Wavelet-Amplitude bis zu einem Ende des Dreiecks-Wavelets aus.

Ein weiteres besonders geeignetes Wavelet ist ein Rechteckwavelet, das im Sinne dieser Erfindung auch trapezförmige Wavelets mit einschließt. Ein Rechteck-Wavelet zeichnet sich durch einen Startzeitpunkt des Rechteck-Wavelets aus, dem ein Anstieg der Wavelet-Amplitude mit einer ersten zeitlichen Steilheit bis zu einem ersten Plateau-Zeitpunkt folgt. Dem ersten Plateau-Zeitpunkt des Rechteck-Wavelets folgt ein Verharren der Wavelet-Amplitude mit einer zweiten Steilheit der Wavelet-Amplitude bis zu einem zweiten Plateau-Zeitpunkt des Rechteck-Wavelets. Dem zweiten Plateau-Zeitpunkt folgt ein Abfall mit einer dritten zeitlichen Steilheit bis zum zeitlichen Ende des Rechteck-Wavelets. Dabei beträgt der Betrag der zweiten zeitlichen Steilheit weniger als 10% des Betrags der ersten zeitlichen Steilheit und weniger als 10% des Betrags der dritten zeitlichen Steilheit.

Statt der zuvor beschriebenen Wavelets ist auch die Verwendung anderer zweidimensionaler Wavelets, wie beispielsweise eines Sinushalbwellen-Wavelets möglich, das ebenfalls ein Integral ungleich 0 aufweist.

Es wird vorgeschlagen, dass bei Verwendung von Wavelets die zeitliche Verschiebung des betreffenden Wavelets des erkannten Signalobjekts als ein Signalobjektparameter verwendet wird. Beispielsweise kann durch Korrelation diese Verschiebung ermittelt werden. Es wird weiter vorgeschlagen , dass bei Verwendung von Wavelets der Zeitpunkt der Überschreitung des Pegels des Ausgangs eines zur Detektion des betreffenden Wavelets geeigneten Optimal-filters über einen vordefinierten zehnten Schwellwert für dieses Signalobjekt bzw. dieses Wavelet bevorzugt verwendet wird. Vorzugsweise werden das Ultraschall-Echo-Signal (die Hüllkurve) des Empfangssignals und/oder ein Phasensignal und/oder ein Confidence-Signal etc. ausgewertet.

Ein weiterer möglicher Signalobjektparameter, der ermittelt werden kann, ist eine zeitliche Kompression oder Dehnung des betreffenden Wavelets des erkannten Signalobjekts. Ebenso kann eine Amplitude des Wavelets des erkannten Signalobjekts ermittelt werden.

Im Rahmen der Erfindung wurde erkannt, dass es vorteilhaft ist, die Daten der erkannten Signalobjekte der sehr schnell eintreffenden Echos zuerst vom Sensor zum Rechnersystem zu übertragen und dann erst die nachfolgenden Daten der später erkannten Signalobjekte. Vorzugsweise werden dabei immer zumindest die erkannte Signalobjektklasse und ein Zeitstempel übertragen, der vorzugsweise angeben sollte, wann das Signalobjekt beim Sensor wieder eingetroffen ist. Im Rahmen des Erkennungsprozesses können den verschiedenen Signalobjekten, die für einen Abschnitt des Empfangssignals in Frage kommen, Score-Werte zugeordnet werden, die angeben, welche Wahrscheinlichkeit entsprechend dem verwendeten Schätzalgorithmus dem Vorliegen dieses Signalobjekts zugeordnet wird. Ein solcher Score-Wert ist im einfachsten Fall binär. Vorzugsweise handelt es sich bei dem Score jedoch um eine komplexe, reelle oder Integer-Zahl. Es kann sich beispielsweise um den ermittelten Abstand handeln. Sofern mehrere Signalobjekte einen hohen Score-Wert haben, ist es sinnvoll, in manchen Fällen auch die Daten erkannter Signalobjekte mit niedrigeren Score-Werten zu übertragen. Um dem Rechnersystem die richtige Handhabung zu ermöglichen, sollten für diesen Fall nicht nur das Datum (Symbol) des erkannten Signalobjekts und der Zeitstempel für das jeweilige Signalobjekt übertragen werden, sondern auch der ermittelte Score-Wert. Statt nur Datum (Symbol) des erkannten Signalobjekts und Zeitstempel für das diesem Symbol entsprechende Signalobjekt zu übertragen, kann zusätzlich auch das Datum (Symbol) des Signalobjekts mit dem zweitkleinsten Abstand und dessen Zeitstempel für das diesem zweitwahrscheinlichsten Symbol entsprechende Signalobjekt mit übertragen werden. Somit wird in diesem Fall eine Hypothesenliste aus zwei erkannten Signalobjekten und deren zeitlichen Positionen sowie zusätzlich zugeordneten Score-Werten an das Rechnersystem übertragen. Natürlich ist auch die Übertragung einer Hypothesenliste bestehend aus mehr als zwei Symbolen für mehr als zwei erkannte Signalobjekte und deren zeitlichen Positionen sowie zusätzlich zugeordneten Score-Werte an das Rechnersystem erfolgen.

Vorzugsweise erfolgt die Übertragung der Daten der erkannten Signalobjektklasse und der zugeordneten Daten wie beispielsweise Zeitstempel und Score-Werte der jeweiligen erkannten Signalobjektklassen, also der zugeordneten Signalobjektparameter, nach dem First-In-First-Out-(FIFO)-Prinzip. Dies stellt sicher, dass stets die Daten der Reflektionen der am nächsten liegenden Objekte zuerst übertragen werden und so der sicherheitskritische Fall des Zusammenstoßes des Fahrzeugs mit einem Hindernis priorisiert nach Wahrscheinlichkeit bearbeitet wird.

Neben der Übertragung von Messdaten kann auch die Übertragung von Fehlerzuständen des Sensors erfolgen. Dies kann auch während einer Empfangszeit $T_E$ geschehen, wenn der Sensor durch Selbsttestvorrichtungen feststellt, dass ein Defekt vorliegt und die zuvor übertragenen Daten potenziell fehlerhaft sein könnten. Somit wird sichergestellt, dass das Rechnersystem zum frühesten möglichen Zeitpunkt über eine Änderung der Bewertung der Messdaten Kenntnis erlangen kann und diese verwerfen oder anders behandeln kann. Dies ist von besonderer Bedeutung für Notbremssysteme, da eine Notbremsung ein sicherheitskritischer Eingriff ist, der nur dann eingeleitet werden darf, wenn die zugrundeliegenden Daten einen entsprechenden Vertrauenswert besitzen. Dem gegenüber wird daher die Übertragung der Messdaten, also beispielsweise des Datums der erkannten Signalobjektklasse und/oder die Übertragung des mindestens einen zugeordneten Signalobjektparameters zurückgestellt und damit niedriger priorisiert. Natürlich ist ein Abbruch der Übertragung bei Auftreten eines Fehlers im Sensor denkbar. In manchen Fällen kann es aber auch so sein, dass ein Fehler möglich erscheint, aber nicht sicher vorliegt. Insofern ist in solchen Fällen unter Umständen die Fortsetzung einer Übertragung angezeigt. Die Übertragung sicherheitskritischer Fehler des Sensors erfolgt somit vorzugsweise höher priorisiert.

Neben den bereits beschriebenen Wavelets mit einem Integrationswert von 0 und den zusätzlich hier als Wavelet bezeichneten Signalabschnitten mit einem Integrationswert verschieden von 0 können auch bestimmte Zeitpunkt im Verlauf des Empfangssignals als Signalgrundobjekt im Sinne der Erfindung aufgefasst werden, die zu einer Datenkompression verwendet werden können und anstelle von Abtastwerten des Empfangssignals übertragen werden können. Diese Untermenge in der Menge möglicher Signalgrundobjekte wird im Folgenden als Signalzeitpunkte bezeichnet. Die Signalzeitpunkte sind also im Sinne der Erfindung eine spezielle Form der Signalgrundobjekte.

Ein erster möglicher Signalzeitpunkt und damit ein Signalgrundobjekt ist ein Kreuzen der Amplitude des Ultraschall-Echo-Signals 1 mit der Amplitude eines elften Schwellwertsignals SW in aufsteigender Richtung.

Ein zweiter möglicher Signalzeitpunkt und damit ein Signalgrundobjekt ist ein Kreuzen der Amplitude des Ultraschall-Echo-Signals 1 mit der Amplitude eines zwölften Schwellwertsignals SW in absteigender Richtung.

Ein dritter möglicher Signalzeitpunkt und damit ein Signalgrundobjekt ist ein Maximum der Amplitude des Ultraschall-Echo-Signals 1 oberhalb der Amplitude eines dreizehnten Schwellwertsignals SW.

Ein vierter möglicher Signalzeitpunkt und damit ein Signalgrundobjekt ist ein Minimum der Amplitude des Ultraschall-Echo-Signals 1 oberhalb der Amplitude eines vierzehnten Schwellwertsignals SW.

Gegebenenfalls kann es sinnvoll sein, für diese vier beispielhaften Typen von Signalzeitpunkten und für weitere Typen von Signalzeitpunkten signalzeitpunkttyp-spezifische Schwellwertsignale SW zu verwenden.

Die zeitliche Abfolge von Signalgrundobjekten ist typischerweise nicht beliebig. Dies wird vorteilhaft genutzt, da bevorzugt nicht die Signalgrundobjekte, die einfacherer Natur sind, übertragen werden sollen, sondern erkannte Muster von Abfolgen dieser Signalgrundobjekten, die dann die eigentlichen Signalobjekte darstellen. Wird beispielsweise ein Dreiecks-Wavelet im Ultraschall-Echo-Signal 1 ausreichender Amplitude erwartet, so kann zusätzlich zu einem entsprechenden Mindestpegel am Ausgang eines für die Detektion eines solchen Dreiecks-Wavelets geeigneten Optimal-Filters

1. das Auftreten eines ersten möglichen Signalzeitpunkts mit einem Kreuzen der Amplitude des Ultraschall-Echo-Signals 1 mit der Amplitude eines Schwellwertsignals SW in aufsteigender Richtung und daran zeitlich anschließend
2. das Auftreten eines dritten möglichen Signalzeitpunkts mit einem Maximum der Amplitude des Ultraschall-Echo-Signals 1 oberhalb der Amplitude eines Schwellwertsignals SW und daran zeitlich anschließend
3. das Auftreten eines zweiten möglichen Signalzeitpunkts mit einem Kreuzen der Amplitude des Ultraschall-Echo-Signals 1 mit der Amplitude eines Schwellwertsignals SW in absteigender Richtung

in zeitlicher Korrelation zum Überschreiten des besagten Mindestpegels am Ausgang des besagten Optimal-Filters erwartet werden. Das Signalobjekt eines Dreiecks-Wavelets besteht in diesem Beispiel also in der vordefinierten Abfolge dreier Signalgrundobjekte, die erkannt und durch ein Symbol ersetzt und als dieses Symbol bevorzugt zusammen mit seinem Auftretenszeitpunkt, dem Zeitstempel übertragen werden. Dieses Überschreiten des besagten Mindestpegels am Ausgang des besagten Optimal-Filters ist übrigens ein weiteres Beispiel für einen fünften möglichen Signalzeitpunkt und damit ein weiteres mögliches Signalgrundobjekt.

Die sich somit ergebende Gruppierung und zeitliche Abfolge von erkannten Signalgrundobjekten kann selbst, beispielsweise durch einen Viterbi-Decoder, als eine vordefinierte, erwartete Gruppierung oder zeitliche Abfolge von Signalgrundobjekten erkannt werden und kann somit selbst wieder ein Signalgrundobjekt darstellen. Somit ist ein sechster möglicher Signalzeitpunkt und damit ein Signalgrundobjekt das Auftreten einer solchen vordefinierten Gruppierung und/oder zeitliche Abfolge von anderen Signalgrundobjekten.

Wird eine solche Gruppierung von Signalgrundobjekten oder zeitliche Abfolge solcher Signalobjektklassen in Form eines Signalobjekts erkannt, so folgt das Übertragen des Symbols dieser erkannten zusammenfassenden Signalobjektklasse und zumindest des einen zugeordneten Signalobjektparameters vorzugsweise an Stelle der Übertragung der einzelnen Signalgrundobjekte, da hierdurch erhebliche Datenbuskapazität gespart wird. Es mag jedoch auch Fälle geben, in denen beides übertragen wird. Hierbei wird das Datum (Symbol) der Signalobjektklasse eines Signalobjekts übertragen, das eine vordefinierte zeitliche Abfolge und/oder Gruppierung von anderen Signalgrundobjekten ist. Um eine Kompression zu erreichen, ist es vorteilhaft, wenn zumindest eine Signalobjektklasse (Symbol) zumindest eines dieser anderen Signalgrundobjekte nicht übertragen wird.

Eine zeitliche Gruppierung von Signalgrundobjekten liegt insbesondere dann vor, wenn der zeitliche Abstand dieser Signalgrundobjekte einen vordefinierten Abstand nicht überschreitet. Im zuvor erwähnten Beispiel sollte die Laufzeit des Signals im Optimalfilter bedacht werden. Typischerweise dürfte das Optimalfilter langsamer als die Komparatoren sein. Daher sollte der Wechsel im Ausgangssignal des Optimalfilters in einem festen zeitlichen Zusammenhang zu dem zeitlichen Auftreten der relevanten Signalzeitpunkte stehen.

Es wird hier also ein Verfahren zur Übertragung von Sensordaten, insbesondere eines Ultraschallsensors, von einem Sensor zu einem Rechnersystem, insbesondere in einem Fahrzeug, vorgeschlagen, das mit dem Aussenden eines Ultraschall-Bursts und dem Empfangen eines Ultraschallsignals und dem Bilden eines zeitdiskreten Empfangssignals bestehend aus einer Folge von Abtastwerten beginnt. Jedem Abtastwert ist dabei ein zeitliches Datum (Zeitstempel) zugeordnet. Es folgt die Bestimmung von mindestens zwei Parametersignalen jeweils betreffend das Vorliegen jeweils eines dem jeweiligen Parametersignal zugeordneten Signalgrundobjekts mit Hilfe mindestens eines geeigneten Filters (z.B. eines Optimalfilters) aus der Folge von Abtastwerten des Empfangssignals. Die sich ergebenden Parametersignale (Feature-Vektor-Signale) sind ebenfalls als zeitdiskrete Folge von jeweiligen Parametersignalwerten (Feature-Vektor-Werte) ausgebildet, die jeweils mit einem Datum (Zeitstempel) korreliert sind. Somit ist bevorzugt jedem Parametersignalwert (Feature-Vektor-Wert) genau ein zeitliches Datum (Zeitstempel) zugeordnet. Diese Parametersignale zusammen werden im Folgenden als Feature-Vektor-Signal bezeichnet. Das Feature-Vektor-Signal ist somit als zeitdiskrete Folge von Feature-Vektor-Signalwerten mit jeweils n Parametersignalwerten ausgebildet ist, die aus den Parametersignalwerten und weiteren Parametersignalwerten mit jeweils gleichem zeitlichem Datum (Zeitstempel) bestehen. Hierbei ist n die Dimensionalität der einzelnen Feature-Vektor-Signalwerte, die bevorzugt von einem Feature-Vektorwert zum nächsten Feature-Vektorwert gleich sind. Jedem so gebildeten Feature-Vektor-Signalwert wird dieses jeweilige zeitliche Datum (Zeitstempel) zugeordnet. Es folgt die Auswertung des zeitlichen Verlaufs des Feature-Vektor-Signals in dem sich ergebenden n-dimensionalen Phasenraum sowie das Schließen auf ein erkanntes Signalobjekt unter Ermittlung eines Bewertungswerts (z.B. des Abstands). Wie zuvor erläutert, besteht dabei ein Signalobjekt aus einer zeitlichen Abfolge von Signalgrundobjekten. Dem Signalobjekt ist dabei typischerweise vordefiniert ein Symbol zugeordnet. Anders ausgedrückt wird hier geprüft, ob der Punkt, auf den das n-dimensionale Feature-Vektor-Signal im n-dimensionaten Phasenraum zeigt, bei seinem Wege durch den n-dimensionalen Phasenraum in vorbestimmter zeitlicher Abfolge sich vorbestimmten Punkten in diesem n-dimensionalen Phasenraum näher als ein vorgegebener Maximalabstand nähert. Das Feature-Vektor-Signal hat also einen zeitlichen Verlauf. Es wird dann ein Bewertungswert (z.B. ein Abstand) berechnet, der beispielsweise die Wahrscheinlichkeit für das Vorliegen einer bestimmten Abfolge wiedergeben kann. Es erfolgt dann der Vergleich dieses Bewertungswerts, dem wieder ein zeitliches Datum (Zeitstempel) zugeordnet ist, mit einem Schwellwertvektor unter Bildung eines booleschen Resultats, dass einen ersten und einen zweiten Wert haben kann. Wenn dieses boolesche Resultat für dieses zeitliche Datum (Zeitstempel) den ersten Wert hat, erfolgt ein Übertragen des Symbols des Signalobjekts und des diesem Symbol zugeordneten zeitlichen Datums (Zeitstempel) von dem Sensor zu dem Rechnersystem. Gegebenenfalls können je nach erkanntem Signalobjekt weitere Parameter übertragen werden.

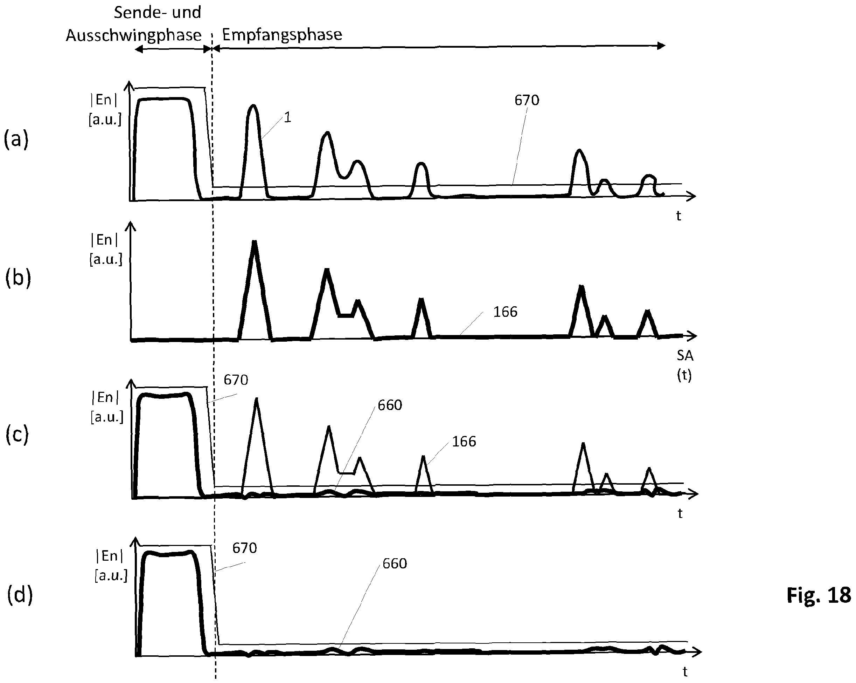

Besonders vorteilhaft ist die Rekonstruktion eines rekonstruierten Ultraschall-Echo-Signal-Modells 610 aus den erkannten Signalobjekten 122. Dieses Ultraschall-Echo-Signal-Modells 610 wird aus den summierend linear überlagerten Signalverlaufsmodellen der einzelnen erkannten Signalobjekte erzeugt. Anschließend wird es von dem Ultraschall-Echo-Signal 1 abgezogen. Es wird hierdurch ein Restsignal 660 gebildet. Hierdurch werden dem mit höherer Wahrscheinlichkeit erkanntem selektieren Signalobjekt ähnliche Signalobjekte besser unterdrückt. Die schwächeren Signalobjekte treten in dem Restsignal 660 besser hervor und können besser erkannt werden (siehe auch Fig. 18). Es ist somit bevorzugt auch eine Subtraktion des aus den erkennten Signalobjekten rekonstruierten Ultraschall-Echo-Signal-Modells 610 von dem Ultraschall-Echo-Signal 1 zur Bildung eines Restsignals 660 vorgesehen. Das so gebildete Restsignal 660 wird dann wieder für die Bildung des Feature-Vektor-Signals 138 verwendet und das nächste Signalobjekt mit der nächsten höheren Wahrscheinlichkeit erkannt. Da das zuerst erkannte Signalobjekt entsprechend seiner Gewichtung aus dem Eingangssignal entfernt wurde, kann es diese Erkennung nicht mehr beeinflussen. Somit liefert dieser Form der Erkennung ein besseres Ergebnis.

Diese Erkennungsmethode ist aber in der Regel langsamer. Daher ist es sinnvoll erst eine direkte erste Objekterkennung ohne Subtraktion schon während der noch laufenden Messung durchzuführen und dann nach Erfassung aller Abtastwerte einer Ultraschall-Echo-Antwort des Umfelds des Fahrzeug in Folge nach dem Aussenden eines Ultraschallpulses oder eines Ultraschallbursts eine nochmalige Mustererkennung mit Subtraktion des Ultraschall-Echo-Signal-Modells 610 durchzuführen, die zwar länger dauert, dafür aber präziser ist.

Bevorzugt wird diese reduzierende Klassifikation des Ultraschall-Echo-Signals 1 in Signalobjekte mit Hilfe des Ultraschall-Echo-Signal-Modells 610 dann beendet, wenn die Beträge der Abtastwerte des Restsignals 660 unter den Beträgen einer vorgegebenen Schwellwertkurve liegen.

Besonders bevorzugt erfolgt die Datenübertragung im Fahrzeug über einen seriellen bidirektionalen Eindraht-Datenbus. Die elektrische Rückleitung wird hierbei bevorzugt durch die Karosserie des Fahrzeugs sichergestellt. Vorzugsweise werden die Sensordaten strommoduliert an das Rechnersystem gesendet. Die Daten zur Steuerung des Sensors werden durch das Rechnersystem vorzugsweise spannungsmoduliert an den Sensor gesendet. Es wurde erkannt, dass die Verwendung eines PSI5-Datenbusses und/oder eines DSI3-Datenbusses für die Datenübertragung besonders geeignet ist. Des Weiteren wurde erkannt, dass es besonders vorteilhaft ist, die Übertragung der Daten an das Rechnersystem mit einer Übertragungsrate von > 200 kBit/s und vom Rechnersystem zu dem mindestens einen Sensor mit einer Übertragungsrate > 10 kBit/s, vorzugsweise 20 kBit/s vorzunehmen. Des Weiteren wurde erkannt, dass die Übertragung von Daten von dem Sensor an das Rechnersystem mit einem Sendestrom auf den Datenbus moduliert werden sollte, dessen Stromstärke weniger als 50 mA, bevorzugt weniger als 5 mA, bevorzugt weniger als 2,5 mA betragen sollte. Für diese Betriebswerte müssen diese Busse entsprechend angepasst werden. Das Grundprinzip bleibt aber bestehen.

Für die Durchführung der zuvor beschriebenen Verfahren wird ein Rechnersystem mit einer Datenschnittstelle zu dem besagten Datenbus, vorzugsweise dem besagten Eindrahtdatenbus, benötigt, das die Dekompression der auf diese Weise komprimierten Daten unterstützt. In der Regel wird das Rechnersystem jedoch keine vollständige Dekompression vornehmen, sondern beispielsweise lediglich den Zeitstempel und den erkannten Signalobjekttyp auswerten. Der Sensor, der zur Durchführung eines der zuvor beschrieben Verfahren benötigt wird, weist mindestens einen Sender und mindestens einen Empfänger zur Erzeugung eines Empfangssignals auf, die auch als ein oder mehrere Transducer kombiniert vorliegen können. Des Weiteren weist er zumindest Vorrichtungen zur Verarbeitung und Kompression des Empfangssignals auf sowie eine Datenschnittstelle zur Übertragung der Daten über den Datenbus, vorzugsweise den besagten Eindrahtdatenbus, an das Rechnersystem auf. Für die Kompression weist die Vorrichtung zur Kompression vorzugsweise zumindest eine der folgenden Teilvorrichtungen auf:

- Optimalfilter,
- Komparatoren,
- Schwellwertsignalerzeugungsvorrichtungen zur Erzeugung eines oder mehrerer Schwellwertsignale SW,

- Differenzierer zur Bildung von Ableitungen,
- Integrierer zur Bildung integrierter Signale,
- sonstige Filter,
- Hüllkurvenformer zur Erzeugung eines Hüllkurvensignals (Ultraschall-Echo-Signal) aus dem Empfangssignal,
- Korrelationsfilter zum Vergleich des Empfangssignals oder von daraus abgeleiteten Signalen mit Referenzsignalen.

In einer besonders einfachen Form wird das vorgeschlagene Verfahren zur Übertragung von Sensordaten, insbesondere eines Ultraschallsensors, von einem Sensor zu einem Rechnersystem, insbesondere in einem Fahrzeug, wie folgt ausgeführt:

Es beginnt mit dem Aussenden eines Ultraschall-Bursts. Es folgt das Empfangen eines Ultraschallsignals, also typischerweise eine Reflektion und das Bilden eines zeitdiskreten Empfangssignals bestehend aus einer zeitlichen Folge von Abtastwerten. Dabei ist jedem Abtastwert ein zeitliches Datum (Zeitstempel) zugeordnet. Dieses gibt typischerweise den Zeitpunkt der Abtastung wieder. Auf Basis dieses Datenstroms erfolgt die Bestimmung eines ersten Parametersignals einer ersten Eigenschaft mit Hilfe eines ersten Filters aus der Folge von Abtastwerten des Empfangssignals. Bevorzugt wird dabei das Parametersignal wieder als zeitdiskrete Folge von Parametersignalwerten ausgebildet. Jedem Parametersignalwert wird wieder genau ein zeitliches Datum (Zeitstempel) zugeordnet. Bevorzugt entspricht dieses Datum dem jüngsten zeitlichen Datum eines Abtastwertes, der zur Bildung dieses jeweiligen Parametersignalwertes benutzt wurde. Zeitlich parallel dazu erfolgt bevorzugt die Bestimmung mindestens eines weiteren Parametersignals einer diesem weiteren Parametersignal zugeordneten Eigenschaft mit Hilfe eines diesem weiteren Parametersignal zugeordneten weiteren Filters aus der Folge von Abtastwerten des Empfangssignals, wobei die weiteren Parametersignale jeweils wieder als zeitdiskrete Folgen von weiteren Parametersignalwerten ausgebildet sind. Auch hier wird jedem weiteren Parametersignalwert jeweils das gleiche zeitliche Datum (Zeitstempel) wie dem entsprechenden Parametersignalwert zugeordnet.

Das erste Parametersignal und die weiteren Parametersignale werden zusammen im Folgenden als Feature-Vektor-Signal bezeichnet. Dieses Feature-Vektor-Signal (oder auch Parametervektorsignal) stellt somit eine zeitdiskrete Folge von Feature-Vektor-Signalwerten dar, die aus den Parametersignalwerten und weiteren Parametersignalwerten mit jeweils gleichem zeitlichem Datum (Zeitstempel) bestehen. Somit kann jedem so gebildeten Feature-Vektor-Signalwert (= Parametersignalwert) dieses jeweilige zeitliche Datum (Zeitstempel) zugeordnet werden.

Es erfolgt bevorzugt dann quasikontinuierlich der Vergleich der Feature-Vektor-Signalwerte eines zeitlichen Datums (Zeitstempels) mit einem Schwellwertvektor, der bevorzugt ein Prototypenvektor ist, unter Bildung eines booleschen Resultats, dass einen ersten und einen zweiten Wert haben kann, Beispielsweise ist es denkbar, den Betrag des aktuellen Feature-Vektor-Signalwerts, der beispielsweise eine erste Komponente eines Feature-Vektor-Signalwerts darstellt, mit einem fünfzehnten Schwellwert, der eine erste Komponente des Schwellwertvektors darstellt, zu vergleichen und das boolesche Resultat auf einen ersten Wert zusetzen, wenn der Betrag des Feature-Vektor-Signalwerts kleiner ist als dieser fünfzehnte Schwellwert, und auf einen zweiten Wert, wenn das nicht der Fall ist. Hat das boolesche Resultat einen ersten Wert, so ist es dann weiter denkbar, den Betrag des weiteren Feature-Vektor-Signalwerts, der beispielsweise eine weitere Komponente dieses Feature-Vektor-Signals darstellt, mit einem weiteren Schwellwert, der eine weitere Komponente des Schwellwertvektors darstellt, zu vergleichen und das boolesche Resultat auf dem ersten Wert zu belassen, wenn der Betrag des weiteren Feature-Vektor-Signalwerts kleiner ist als dieser weitere Schwellwert, und das boolesche Resultat auf den zweiten Wert zu setzen, wenn dies nicht der Fall ist. Auf diese Weise können alle weiteren Feature-Vektor-Signalwerte überprüft werden. Natürlich sind auch andere Klassifikatoren denkbar. Auch ist der Vergleich mit mehreren verschiedenen Schwellwertvektoren möglich. Diese Schwellwertvektoren stellen also die Prototypen vorgegebener Signalformen dar. Sie entstammen der besagten Bibliothek. Jedem Schwellwertvektor ist wieder bevorzugt ein Symbol zugeordnet.

Als letzter Schritt folgt dann in diesem Fall das Übertragen des Symbols und gegebenenfalls auch der Feature-Vektor-Signalwerte und des dem Symbol bzw. dem Feature-Vektor-Signalwert zugeordneten zeitlichen Datums (Zeitstempels) von dem Sensor zu dem Rechnersystem, wenn das boolesche Resultat für dieses zeitliche Datum (Zeitstempel) den ersten Wert hat.

Somit werden alle anderen Daten nicht mehr übertragen. Des Weiteren werden durch die mehrdimensionale Auswertung Störungen vermieden.

Auf dieser Basis wird somit ein Sensorsystem vorgeschlagen, mit mindestens einem Rechnersystem, das zur Durchführung eines der zuvor vorgestellten Verfahren in der Lage ist und mit mindestens zwei Sensoren die ebenfalls zur Durchführung eines der zuvor vorgestellten Verfahren in der Lage sind, so dass diese mindestens zwei Sensoren mit dem Rechnersystem durch Signalobjekterkennung kommunizieren können und auch in die Lage versetzt sind, Fremdechos kompaktiert zu übertragen und diese Informationen zusätzliche dem Rechnersystem zur Verfügung zu stellen. Das Sensorsystem ist dementsprechend dazu typischerweise vorgesehen, dass die Datenübertragung zwischen den mindestens zwei Sensoren und dem Rechnersystem entsprechend den zuvor beschriebenen Verfahren abläuft oder ablaufen kann. Innerhalb der mindestens zwei Sensoren des Sensorsystems wird also typischerweise jeweils ein Ultraschallempfangssignal, also mindestens zwei Ultraschallempfangssignale, mittels eines der zuvor vorgeschlagenen Verfahren komprimiert und an das Rechnersystem übertragen. Dabei werden innerhalb des Rechnersystems die mindestens zwei Ultraschallempfangssignale zu rekonstruierten Ultraschallempfangssignalen rekonstruiert. Das Rechnersystem führt dann mit Hilfe von rekonstruierten Ultraschallempfangssignalen eine Objekterkennung von Objekten im Umfeld der Sensoren durch. Die Sensoren führen diese Objekterkennung im Gegensatz zum Stand der Technik also nicht durch.

Das Rechnersystem führt bevorzugt zusätzlich mit Hilfe der rekonstruierten Ultraschallempfangssignalen und zusätzlicher Signale weiterer Sensoren, insbesondere der Signale von Radar-Sensoren, eine Objekterkennung von Objekten im Umfeld der Sensoren durch.

Als letzten Schritt erstellt bevorzugt das Rechnersystem aus Basis der erkannten Objekte eine Umfeldkarte für die Sensoren oder eine Vorrichtung, deren Teil die Sensoren sind.

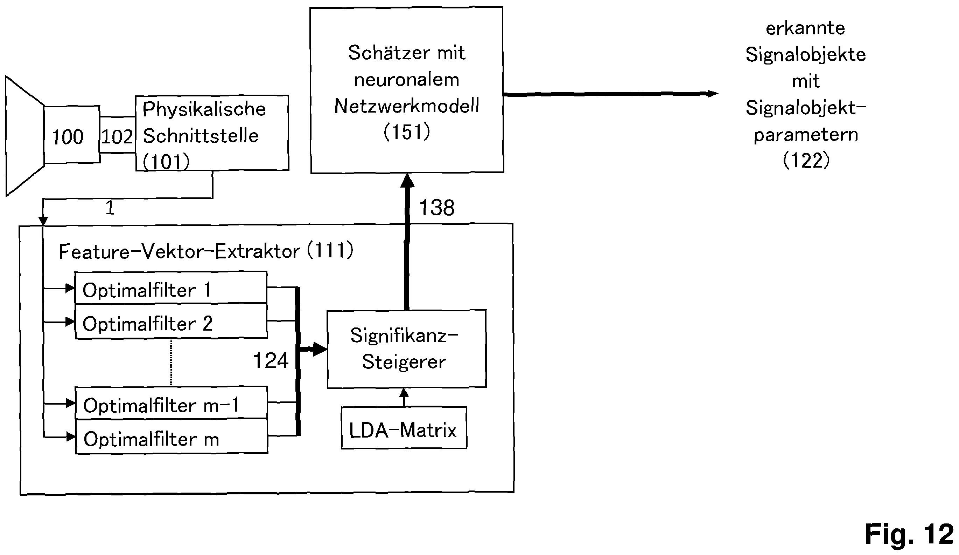

Das vorgeschlagene Ultraschallsensorsystem, wie es beispielhaft in den Fign. 7 und 12 dargestellt ist, umfasst somit bevorzugt einen Ultraschallwandler 100, einen Feature-Extraktor 111 und mit einem Schätzer 150,151 oder Klassifikator und eine physikalische Schnittstelle 101. Der Ultraschallwandler 100 ist bevorzugt dazu vorgesehen und/oder eingerichtet, ein akustisches Ultraschallwellensignals zu empfangen und davon abhängig ein Ultraschallwandlersignal 102 zu bilden. Der Feature-Vektor-Extraktor 111 ist dazu vorgesehen und/oder eingerichtet, aus dem Ultraschallwandlersignal 102 ein Feature-Vektor-Signal 138 zu bilden. Das Ultraschallsensorsystem ist bevorzugt dazu eingerichtet und vorgesehen, mittels des Schätzers 151,150 Signalobjekte in dem Ultraschall-Echo-Signal 1 zu erkennen und in Signalobjektklassen zu klassifizieren, wobei eine Signalobjektklasse auch nur ein Signalobjekt umfassen kann. Bevorzugt werden dabei jedem somit erkannten und klassifizierten Signalobjekt 122 zumindest ein zugeordneter Signalobjektparameter und ein Symbol entsprechend der diesem Signalobjekt zuerkannten Signalobjektklasse zugeordnet oder für jedes somit erkannte und klassifizierte Signalobjekt 122 zumindest ein zugeordneter Signalobjektparameter und ein Symbol für dieses Signalobjekt bestimmt. Zumindest das Symbols einer erkannten Signalobjektklasse 122 und zumindest des einen zugeordneten Signalobjektparameters dieser erkannten Signalobjektklasse 122 werden über einen Datenbus an ein übergeordnetes Rechnersystem übertragen.

Bevorzugt weist der Schätzer 150 einen Abstandsermittler 112 und eine Prototypendatenbank 115 auf. Ebenso weist bevorzugt der Schätzer 150 einen Viterbi-Schätzer und eine Signalobjektdatenbank auf. Auch kann der Schätzer 151 ein neuronales Netzwerkmodell verwenden.

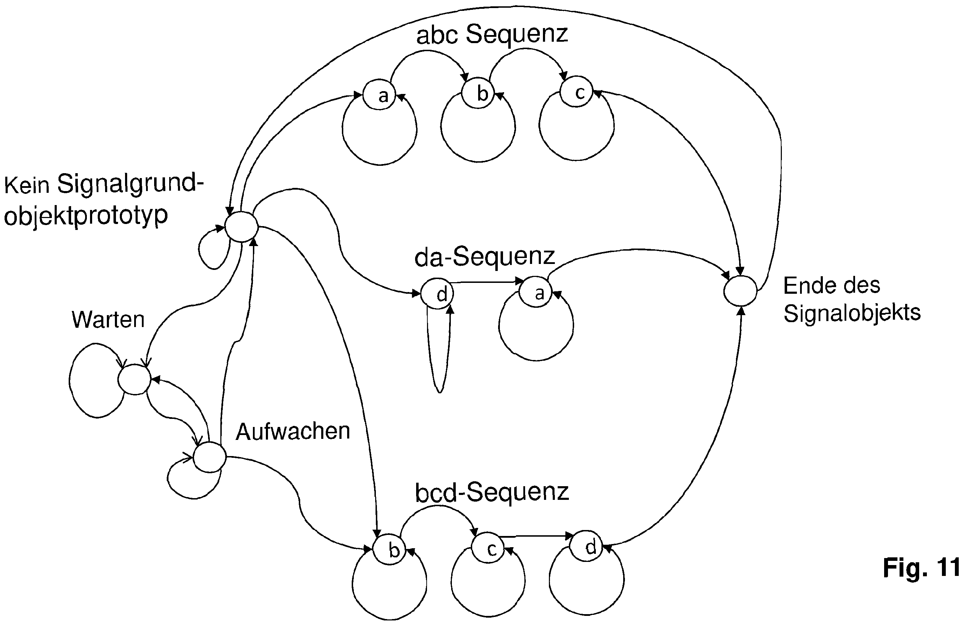

Ein vorgeschlagenes Verfahren zum Betreiben eines Ultraschallsensors umfasst daher die Schritte entsprechend Fig. 11:

- Warten auf ein Ultraschallempfangssignal, das vom Grundrauschen verschieden ist,
- Wechsel in einen Zustand "kein Signalobjektgrundprototyp", falls das Ultraschallempfangssignal von Grundrauschen verschieden ist, und Durchführung eines Verfahrens zum Erkennen und zum Klassifizieren von Signalgrundprototypen,
- Wechsel in eine Folge von Zuständen, die den Signalgrundprototypen einer vorgegebenen Folge von Signalgrundprototypen zugeordnet sind, wenn der erste Signalgrundprototyp dieser Folge erkannt wird,
- Folgen der Folge der Signalgrundprototypen bis das Ende der Folge von Signalgrundprototypen erreicht ist,
- Schließen auf das Vorliegen eines dieser Folge von Signalgrundprototypen und auf ein dieser Folge zugeordnetes Signalobjekt, wenn das Ende dieser Folge von Signalgrundprototypen erreicht ist und Signalisierung dieses Signalobjekts,
- Abbruch (nicht in Fig. 11 eingezeichnet) dieser Folge bei Zeitüberschreitung und/oder bei einfache oder mehrfacher Detektion eines Signalgrundprototypen an einer Position dieser Folge, an der dieser Signalgrundprototyp nicht erwartet wird oder an der in der folgenden Position dieser Signalgrundprototyp nicht erwartet wird,
- Rücksprung in den Zustand "kein Signalobjektgrundprototyp".

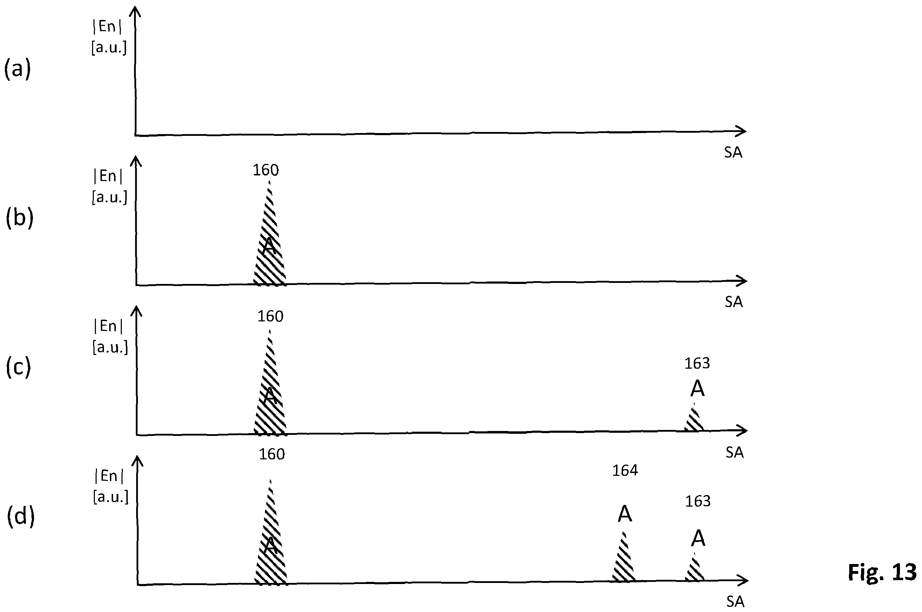

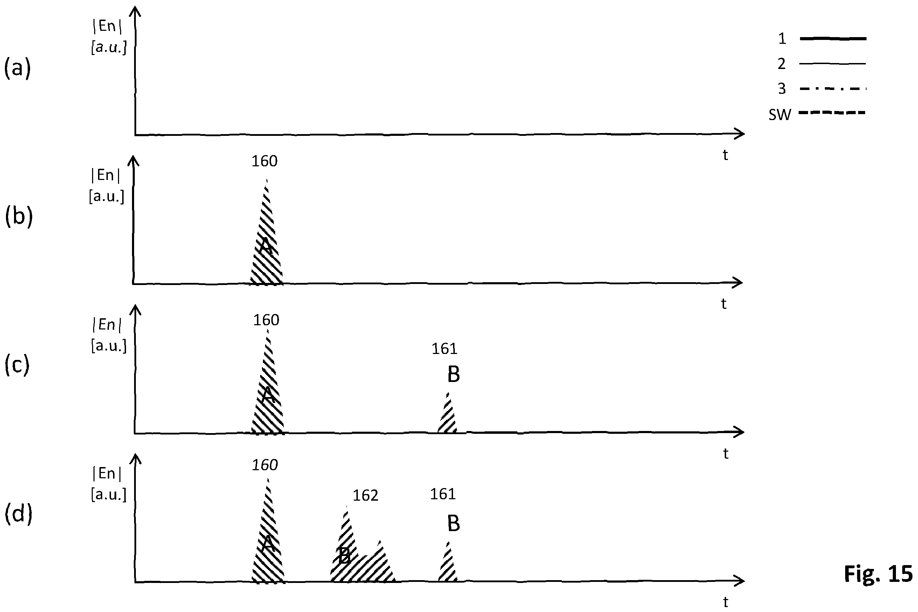

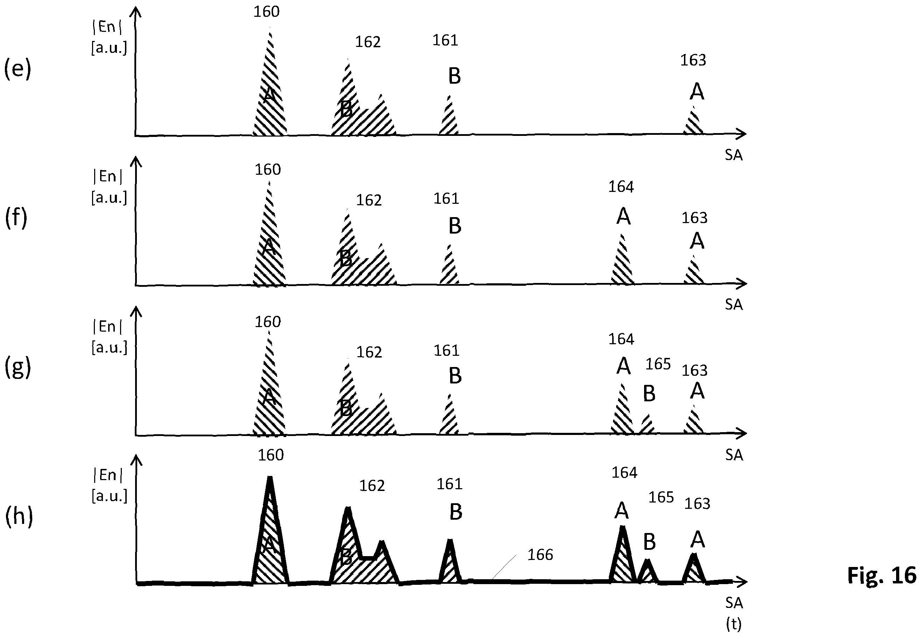

Dem oben beschriebenen Kompressionsverfahren entspricht ein zugehöriges Dekompressionsverfahren, das bevorzugt zur Dekompression von auf diese signalobjektorientierte Weise komprimierten und übertragenen Ultraschallempfangsdaten im Steuerrechner nach deren Empfang vom Sensor über den Datenbus verwendet wird. Nach dem Empfangen neuer zu dekomprimierenden Daten im Steuerrechner vom Sensor kommend erfolgt ein Bereitstellen eines Ultraschall-Echo-Signal-Modells, das zunächst kein Signal aufweist (Fig. 15a). Dieses Ultraschall-Echo-Signal-Modell wird nun signalobjektweise durch aufeinanderfolgende Addition des jeweiligen prototypischen, parametrisierten Signalverlaufs der Signalobjekte 160, die in den Ultraschallempfangsdaten enthalten sind, das Ultraschall-Echo-Signal-Modell 610 langsam aufgefüllt und dem gemessenen Signalverlauf angenähert. Bevorzugt werden nur die Signalverläufe von Signalobjekten aufaddiert, die vorgegebene Bedingungen, wie beispielsweise eine vorgegebene Chirp-Richtung erfüllen (Fig. 13b). Selbstverständlich ist auch eine Aufsummierung ohne eine Selektionsbedingung möglich (Fign. 15 und 16). Aus den so aufsummierten Signalverläufen der durch den Sensor erkannten Signalverläufe der prototypischen Signalobjekte wird auf Basis des Ultraschall-Echo-Signal-Modells im Steuerrechner des Sensors bevorzugt das rekonstruierte Ultraschallempfangssignal gebildet, was in Form der Bildung von Abtastwerten einer rekonstruierten Hüllkurve des Empfangssignals (Ultraschall-Echo-Signal) geschehen kann. Dieses rekonstruierte Ultraschallempfangssignal (rekonstruiertes Ultraschall-Echo-Signal) kann dann im Steuerrechner für kompliziertere Verfahren wie Sensorfusion wesentlich besser verwendet werden als vermeintliche Hindernisobjektdaten, die von dem Sensor an das Steuergerät übertragen werden.

Eine solche komprimierte Übertragung von Daten über den Datenbus zwischen Sensor und Rechnersystem senkt zum einen die Datenbuslast und damit die Kritizität gegenüber EMV-Anforderungen und schafft zum anderen freie Datenbuskapazitäten z.B. während der Empfangszeit für die Übertragung von Steuerbefehlen vom Rechnersystem zum Sensor und zur Übertragung von Statusinformationen und sonstigen Daten vom Sensor zum Rechnersystem. Die vorgeschlagene Priorisierung stellt dabei sicher, dass sicherheitsrelevante Daten zuerst übertragen werden und so keine unnötigen Totzeiten des Sensors entstehen.

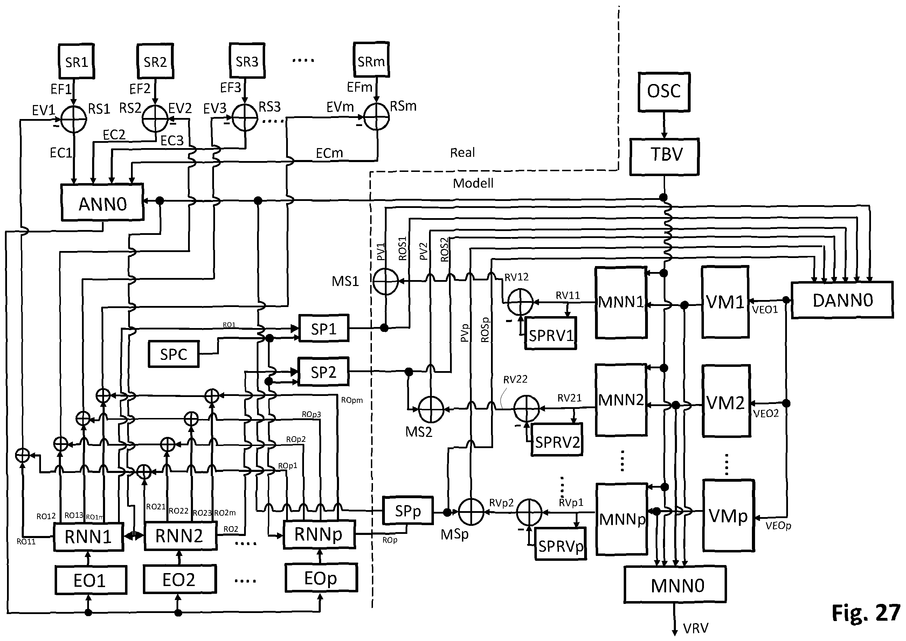

Die Erfindung, die wie beansprucht in Fig. 27 dargestellt ist, wird nachfolgend näher erläutert.

Fig. 1 zeigt den prinzipiellen Ablauf der Signalkompression und der Übertragung.

Fig. 2 zeigt detaillierter den prinzipiellen Ablauf der Signalkompression und der Übertragung.

Fig. 3a zeigt ein herkömmliches Ultraschall-Echo-Signal 1 und dessen konventionelle Auswertung.

Fig. 3b zeigt ein herkömmliches Ultraschall-Echo-Signal 1 und dessen Auswertung, wobei die Amplitude mitübertragen wird.

Fig. 3c zeigt ein Ultraschall-Echo-Signal, wobei die Chirp-Richtung enthalten ist.

Fig. 3d zeigt erkannte Signalobjekte (Dreieckssignale) in dem Signal der Fig. 1c unter Verwurf nicht erkannter Signalanteile.

Fig. 4e zeigt die bekannte konventionelle Übertragung.

Fig. 4f zeigt die bekannte Übertragung analysierter Daten nach vollständigem Empfang des Ultraschallechos.

Fig. 4g zeigt die Übertragung komprimierter Daten, wobei in diesem Beispiel Symbole für Signalgrundobjekte weitestgehend ohne Kompression entsprechend dem Stand der Technik übertragen werden.

Fig. 5h zeigt die Übertragung komprimierter Daten, wobei in diesem Beispiel Symbole für Signalgrundobjekte zu Symbolen für Signalobjekte komprimiert werden.

Fig. 6 zeigt die Übertragung komprimierter Daten, wobei in diesem Beispiel Symbole für Signalgrundobjekte zu Symbolen für Signalobjekte komprimiert werden, wobei nicht nur das Hüllkurvensignal (Ultraschall-Echo-Signal) sondern auch das Confidence-Signal ausgewertet wird.

Fig. 7 zeigt eine Vorrichung in Form eines Ultraschallsensors mit Erkennung von Signalobjekten die Datenschnittstelle, der Datenbus und das Steuergerät sind zur Vereinfachung nicht eingetragen.

Fig. 8 dient der Erläuterung der Selektion der Signalgrundobjektprototypen der Prototypendatenbank 115 durch den Abstandsermittler 112.

Fig- 9 dient der Erläuterung des HMM-verfahrens, das durch den Viterbi-Schätzer 113 angewandt wird, um das Signalobjekt als wahrscheinlichste Folge von Signalgrundobjektprototypen auf Grund einer Folge von erkannten Signalgrundobjektprototypen 121 als erkanntes Signalobjekt 122 zu identifizieren.

Fig. 10 zeigt eine Zustandsabfolge im Viterbi-Schätzer 113 für die Erkennung eines einzelnen Signalobjekts.

Fig. 11 zeigt eine bevorzugte Zustandsabfolge im Viterbi-Schätzer 113 für die kontinuierliche Erkennung eines von Signalobjekte, wie sie typischerweise für die Erkennung bei Aufgaben des autonomen Fahrens notwendig ist.

Fig. 12 zeigt eine alternative Ausgestaltung mit einem Schätzer 151, der ein neuronales Netzwerkmodell ausführt.

Fig. 13 zeigt die Dekompression der übertragenen Hüllkurve des Ultraschallsignals (Ultraschall-Echo-Signal) auf die Chirp-Down-Signalanteile beschränkt.

Fig. 14 zeigt die Dekompression der übertragenen Hüllkurve des Ultraschallsignals (Ultraschall-Echo-Signal) auf die Chirp-Up-Signalanteil beschränkt.

Fign. 15 und 16 zeigen die Dekompression der übertragenen Hüllkurve des Ultraschallsignals (Ultraschall-Echo-Signal) mit Chirp-Up-Signalanteilen und Chirp-Down-Signalanteilen.

Fig. 17 zeigt das Originalsignal (a), das rekonstruierte Signal (b) und deren Überlagerung (c).

Fig. 18 zeigt die Signalverläufe gemäß Fig. 17 und zusätzlich noch das Schwellwertsignal, anhand dessen, wie in Fig. 18d zu sehen ist, zur Beendigung der Dekompression eingesetzt wird.

Fig. 19 zeigt eine verbesserte Vorrichtung zur verbesserten Kompression.

Fig. 20 zeigt eine alternative Verbesserungsvorrichtung zur nochmals verbesserten Signaldatenkompression.

Fig. 21 zeigt eine Übersicht der Hauptkomponenten eines Sensorsystems zur Erfassung des Umfelds eines Fahrzeugs mit Erkennung von Hindernisobjekten einschließlich der Vorhersage der Veränderung dieser Hindernisobjekte relativ zum Fahrzeug in den Totzeiten des Sensorsystems.

Fign. 22 bis 25 zeigen detaillierte Blockschaltdiagramme zur Verdeutlichung verschiedener Verfahren für die Datenkompression (bei jeweils gleichbleibender Datendekompression), wie sie Gegenstand der entsprechend bezeichneten Blöcke der Fig. 21 sein können.

Fig. 26 zeigt eine nochmalige Übersichtsdarstellung.

Fig. 27 zeigt ein erfindungsgemäßes Beispiel für ein Blockschaltbild für die Blöcke "Erkennen von p Hindernisobjekten" und "Vorhersagemodell" der Fig. 21 bzw. für den mit "Fig. 24" bezeichneten Block der Fig. 26.

Fig. 28 zeigt die zeitliche Korrespondenz der Intervalle des Sendens, Ausschwingens und Empfangens bei einem Ultraschall-Transducer des Messsystems und dem Prognoseintervall für die Vorhersage der Veränderung von erkannten realen Hindernisobjekten zwischen zwei aufeinanderfolgenden Zeitpunkten, zu denen die Hindernisobjekte auf Basis von Messwerten geliefert und damit die Prognose aktualisiert wird.

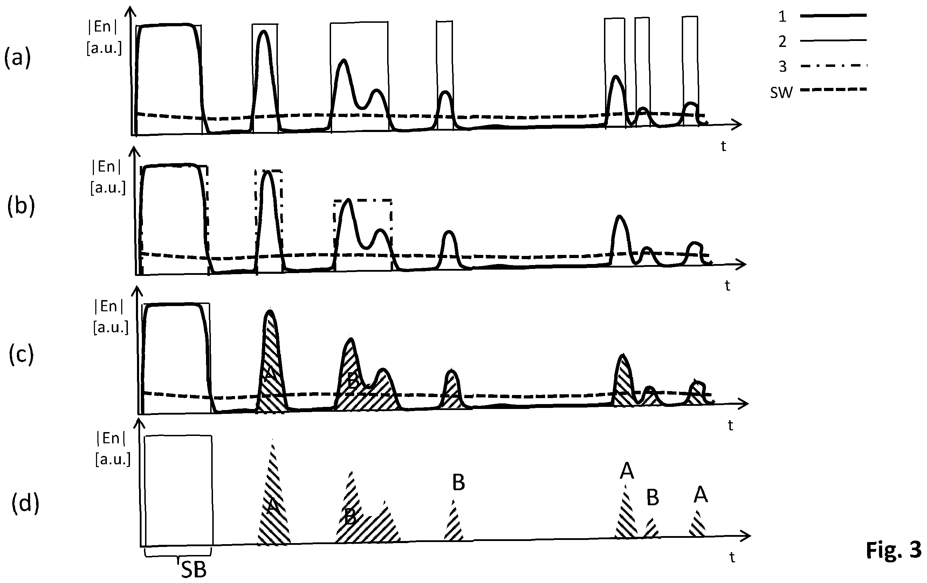

Fig. 3a zeigt den zeitlichen Verlauf eines herkömmliches Ultraschall-Echo-Signal 1 und dessen konventionelle Auswertung in frei gewählten Einheiten für die Koordinatenkreuzachsen. Beginnend mit dem Aussenden des Sende-Bursts SB wird ein Schwellwertsignal SW mitgeführt. Immer dann, wenn das Hüllkurvensignal (Ultraschall-Echo-Signal 1) des Ultraschallempfangssignals das Schwellwertsignal SW übersteigt, wird der Ausgang 2 auf logisch 1 gesetzt. Es handelt sich um eine zeitlich analoge Schnittstelle mit einem digitalen Ausgangspegel.

Die weitere Auswertung wird dann im Steuergerät des Sensors übernommen. Eine Signalisierung von Fehlern oder eine Steuerung des Sensors ist über diese dem Stand der Technik entsprechende analoge Schnittstelle nicht möglich.

Fig. 3b zeigt den zeitlichen Verlauf eines herkömmliches Ultraschall-Echo-Signal 1 und dessen konventionelle Auswertung in frei gewählten Einheiten für die Koordinatenkreuzachsen. Beginnend mit dem Aussenden des Sende-Bursts SB wird ein Schwellwertsignal SW mitgeführt. Immer dann, wenn das Hüllkurvensignal (Ultraschall-Echo-Signal 1) des Ultraschallempfangssignals das Schwellwertsignal SW übersteigt, wird der Ausgang 2 nun jedoch auf einen Pegel entsprechend der Amplitude der erfassten Reflektion gesetzt. Es handelt sich um eine zeitlich analoge Schnittstelle mit einem analogen Ausgangspegel. Die weitere Auswertung wird dann im Steuergerät des Sensors übernommen. Eine Signalisierung von Fehlern oder eine Steuerung des Sensors ist über diese dem Stand der Technik entsprechende analoge Schnittstelle nicht möglich.

Fig. 3c zeigt zur Erläuterung das Ultraschall-Echo-Signal, wobei die Chirp-Richtung (z.B. A=Chirp-Up; B=Chirp-down) markiert ist.

In Fig. 3d wird das Prinzip der symbolischen Signalübertragung erläutert. Statt des Signals aus Fig. 3c werden hier beispielhaft nur zwei Typen von Dreiecksobjekten übertragen. Konkret sind das ein erstes Dreiecksobjekt A für den Chirp-Up-Fall und ein zweites Dreiecksobjekt B für den Chirp-Down-Fall. Gleichzeitig werden der Zeitpunkt und die Amplitude des Dreiecksobjekts übertragen. Erfolgt nun auf Basis dieser Daten eine Rekonstruktion des Signals, so erhält man ein Signal entsprechend Fig. 3d. Aus diesem Signal wurden die Signalanteile entfernt, die nicht den Dreieckssignalen entsprachen. Es erfolgen somit ein Verwurf nicht erkannter Signalanteile und eine massive Datenkompression.

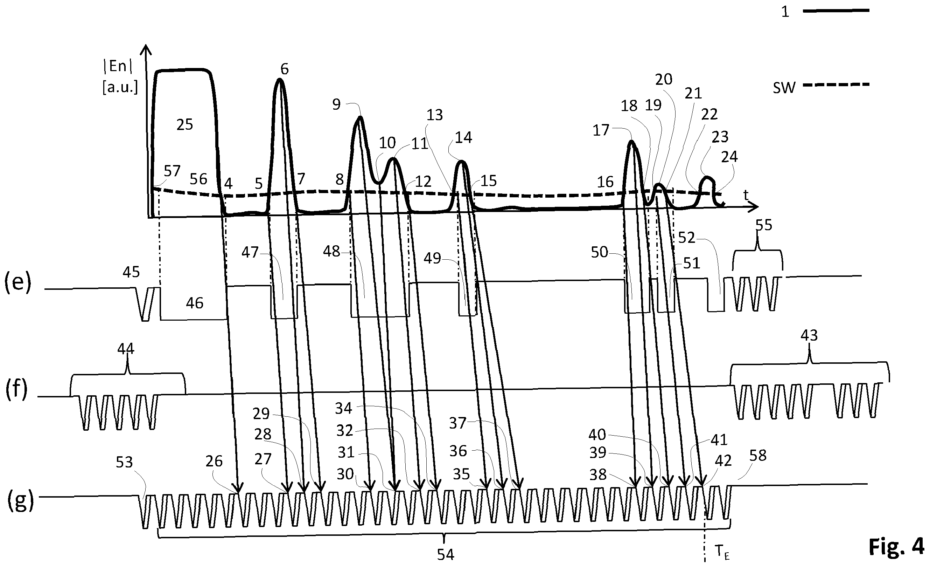

Fig. 4e zeigt die konventionelle analoge Übertragung der Schnittpunkte des Ultraschall-Echo-Signals 1 des Ultraschallempfangssignals mit dem Schwellwertsignal SW.

Fig. 4f zeigt die Übertragung analysierter Daten nach vollständigem Empfang des Ultraschallechos.

Fig. 4g zeigt die Übertragung komprimierter Daten, wobei in diesem Beispiel Symbole für Signalgrundobjekte weitestgehend ohne Kompression übertragen werden.

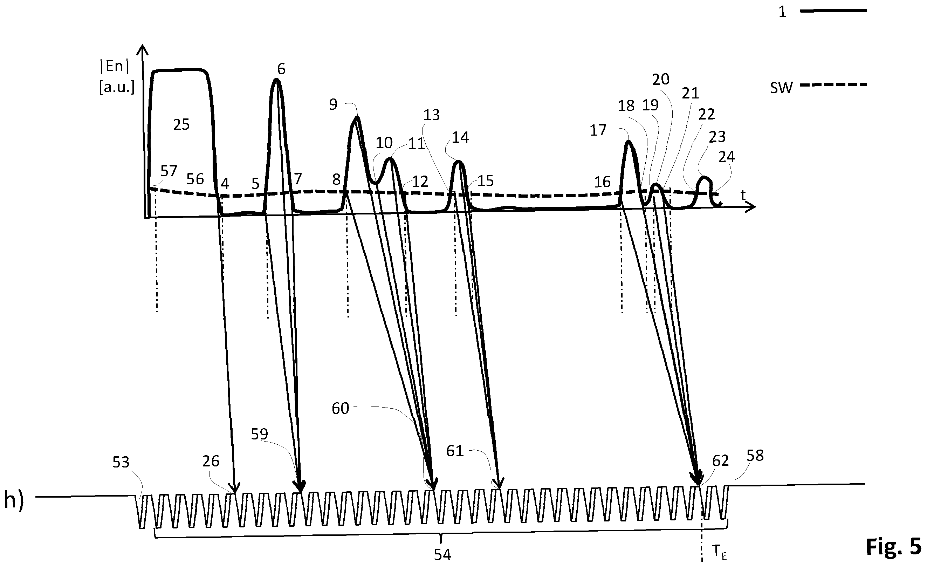

Fig. 5h zeigt die Übertragung komprimierter Daten, wobei in diesem Beispiel Symbole für Signalgrundobjekte zu Symbolen für Signalobjekte komprimiert werden. Zuerst wird ein erstes Dreiecksobjekt 59 mit dieses kennzeichnender zeitlicher Abfolge einer Schwellwertüberschreitung gefolgt von einem Maximum und einer Schwellwertunterschreitung erkannt und übertragen. Dann wird eine Doppelspitze mit Sattelpunkt 60 über dem Schwellwertsignal erkannt. Kennzeichnend ist hier die Abfolge einer Überschreitung des Schwellwertsignals SW durch das Ultraschall-Echo-Signal 1 gefolgt von einem Maximum des Ultraschall-Echo-Signals 1 gefolgt von einem Minimum oberhalb des Schwellwertsignals SW gefolgt von einem Maximum oberhalb des Schwellwertsignals SW gefolgt von einer Unterschreitung des Schwellwertsignals SW. Nach der Erkennung wird das Symbol für diese Doppelspitze mit Sattelpunkt übertragen. Dabei wird ein Zeitstempel mitübertragen. Bevorzugt werden auch weitere Parameter der Doppelspitze mit Sattelpunkt mitübertragen wie z.B. die Positionen der Maxima und des Minimums oder ein Skalierungsfaktor. Es folgt dann wieder die Erkennung eines Dreieckssignals als Signalgrundobjekt als Überschreitung des Schwellwertsignals SW durch das Ultraschall-Echo-Signal 1 gefolgt von einem Maximum des Ultraschall-Echo-Signals 1 gefolgt von einem Unterschreiten des Schwellwertsignals SW durch das Ultraschall-Echo-Signal 1. Es folgt dann wieder die Erkennung einer Doppelspitze, wobei nun aber das Minimum des Ultraschall-Echo-Signals 1 unter dem Schwellwertsignal SW liegt. Diese Doppelspitze kann also beispielsweise gegebenenfalls als separates Signalobjekt behandelt werden. Wie leicht erkennbar, führt diese Behandlung des Signals zu einer massiven Datenreduktion.

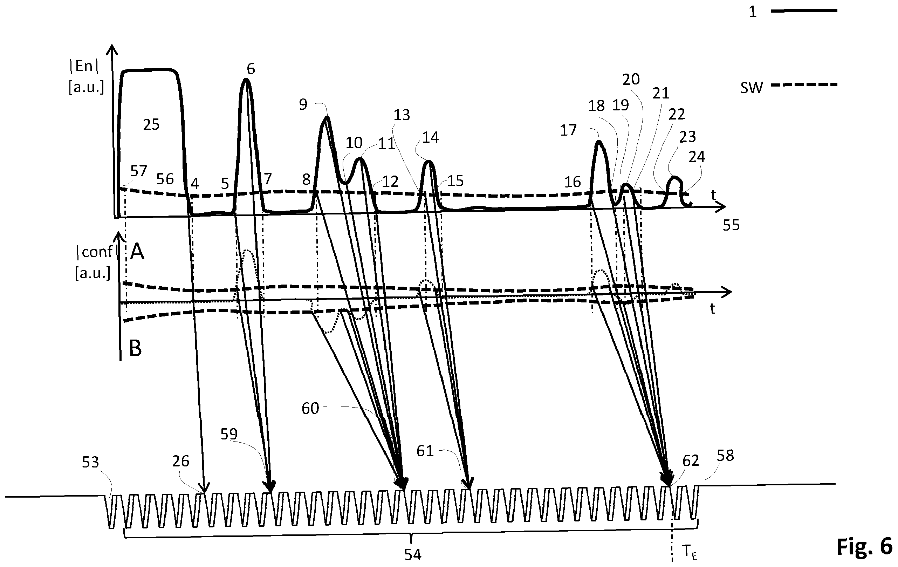

Fig. 6 zeigt die Übertragung komprimierter Daten entsprechend Fig. 3, wobei in diesem Beispiel nicht nur das Hüllkurvensignal (Ultraschall-Echo-Signal 1), sondern auch das Confidence-Signal ausgewertet wird.

Fig. 7 zeigt eine Vorrichtung in Form eines Ultraschallsensors mit Erkennung von Signalobjekten die Datenschnittstelle, der Datenbus und das Steuergerät sind zur Vereinfachung nicht eingetragen. Der Ultraschallwandler 100 wird mittels eines Ultraschallwandlersignals 102 durch eine physikalische Schnittstelle 101 angesteuert und vermessen. Die physikalische Schnittstelle 101 dient zum Treiben des Ultraschallwandlers 100 und zum Aufbereiten der vom Ultraschallwandler 100 empfangenen Ultraschallwandlersignale 102 zum Ultraschall-Echo-Signal 1 für die anschließende Signalobjektklassifikation. Bevorzugt ist das Ultraschall-Echo-Signal 1 ein digitalisiertes Signal mit zeitlich beabstandeten Abtastwerten. Der Feature-Vektor-Extraktor 111 verfügt über verschiedene Vorrichtungen, hier beispielhaft n Optimalfilter (Optimalfilter 1 bis Optimalfilter n) mit n als ganzer positiver Zahl. Die Ausgänge der Optimalfilter bilden das Zwischenparametersignal 123. Statt der Optimalfilter oder ergänzend zu diesen können auch je nach Anwendungsfall

- Integratoren und/oder
- Differenzierer und/oder
- Filter und/oder
- Logarithmierer und/oder
- FF- und DFFT-Vorrichtungen und/oder
- Korrelatoren und/oder
- Demodulatoren, die ihr Eingangssignal mit einem vorgegebenen Signal multiplizieren und dann filtern, und/oder
- andere signalverarbeitende Teilvorrichtungen und/oder
- deren Kombinationen

eingesetzt werden, die dann das n-dimensionale Zwischenparametersignal 123 erzeugen. Die mit "Optimalfilter" bezeichneten Blöcke in den Zeichnungen sind insofern nur als Platzhalter für solche Signalverarbeitungsblöcke zu verstehen. Auch kann ein solcher mit "Optimalfilter" bezeichneter Signalverarbeitungsblock auch mehr als einen Ausgang haben, der zu dem n-dimensionalen Zwischenparametersignal 123 also mehrfach mit mehr als einem Signal beiträgt. Ein z.B. nachfolgender Signifikanzsteigerer dient dazu, den n-dimensionalen Raum des Zwischenparametersignals 123 auf einen m-dimensionalen Raum des Feature-Vektor-Signals 138 abzubilden. Dabei ist m eine ganze positive Zahl. In der Regel ist m kleiner als n. Dies dient zum einen dazu, dass die Selektivität der Parameterwerte, aus denen sich jeder Feature-Vektor-Signalwert des Feature-Vektor-Signals 138 ergibt, maximiert wird. Dies geschieht bevorzugt durch eine lineare Abbildung mit Hilfe eines im Labor mit statistischen Verfahren bestimmten Offset-Werts, der zu den Werten der Zwischenparametersignal addiert wird, und einer so genannten LDA Matrix, mit der der jeweilige Vektor der jeweiligen Abtastwerte der Zwischenparametersignale 123 jeweils zum Feature-Vektor-Signal 138 multipliziert wird. Der Abstandsermittler 112 vergleicht bevorzugt jeden sich so ergebenden Feature-Vektor-Signalwert des Feature-Vektor-Signals 138 mit jedem Signalgrundobjektprototypen der Prototypendatenbank 115. Die Prototypendatenbank 115 enthält hierfür für jeden der Signalgrundobjektprototypen der Prototypendatenbank 115 einen Eintrag mit einem Schwerpunktvektor z.B. 141,142,143,144 des jeweiligen Signalgrundobjektprototypen der Prototypendatenbank 115. Bevorzugt wird ein Abstand des aktuell untersuchten Feature-Vektor-Signalwerts des Feature-Vektor-Signals 138 zu dem gerade untersuchten Schwerpunktvektor der Prototypendatenbank 115 durch den Abstandsermittler 112 berechnet. Der Abstandsermittler 112 kann aber auch auf andere Weise eine Bewertung der Ähnlichkeit zwischen dem Schwerpunktvektor z.B. 141,142,143,144 des jeweiligen Signalgrundobjektprototypen der Prototypendatenbank 115 und dem aktuell untersuchten Feature-Vektor-Signalwert des Feature-Vektor-Signals 138 in Form eines Bewertungswerts, der hier der Einfachheit halber stets als Abstand bezeichnet wird, berechnen. Der Abstandsermittler 112 ermittelt auf diese Weise, ob ein Schwerpunktvektor z.B. 141,142,143,144 der Signalgrundobjektprototypen der Prototypendatenbank 115 dem aktuellen Feature-Vektor-Signalwert des Feature-Vektor-Signals 138 ausreichend ähnlich ist, also einen ausreichend geringen Abstand hat und, falls dies der Fall ist, welcher Schwerpunktvektor z.B. 141,142,143,144 der Signalgrundobjektprototypen der Prototypendatenbank 115 dem aktuellen Feature-Vektor-Signalwert des Feature-Vektor-Signals 138 am ähnlichsten ist, also den geringsten Abstand hat. Gegebenenfalls ermittelt der Abstandsermittler 112 eine Liste von Schwerpunktvektoren z.B. 141,142,143,144 der Signalgrundobjektprototypen der Prototypendatenbank 115, die dem aktuellen Feature-Vektor-Signalwert des Feature-Vektor-Signals 138 ausreichend ähnlich sind, also einen ausreichend geringen Abstand haben. Bevorzugt werden diese nach Abstand geordnet und mit ihrem zugehörigen Abstand als Hypothesenliste an den Viterbi-Schätzer weitergegeben. Die Weitergabe des Erkennungsergebnisses des Abstandsermittlers (der hier auch als Klassifikator bezeichnet wird) erfolgt im Falle eines einzelnen erkannten Signalgrundobjekts 121 als Symbol (z.B. als Prototypendatenbankadresse, die auf den erkannten Signalgrundobjektprototypen der Prototypendatenbank 115 zeigt.) und im Falle einer Hypothesenliste bevorzugt als Liste von Paaren aus einem Symbol des erkannten Signalgrundobjekts (z.B. der Prototypendatenbankadresse, die auf den erkannten Signalgrundobjektprototypen der Prototypendatenbank 115 zeigt,-.) und des Abstands zum Schwerpunkt dieses erkannten Signalgrundobjekts. Der Viterbi-Schätzer sucht dann die Folge aus Signalgrundobjektprototypen, die einer vordefinierten Abfolge von Signalgrundobjektprototypen in seiner Signalobjektdatenbank 116 am besten entspricht. Hierbei werden Übereinstimmungen beispielsweise positiv gezählt und Nichtübereinstimmungen negativ gezählt, so dass sich für eine zeitliche Folge von erkannten Signalgrundobjektprototypen ein Bewertungswert für jeden Eintrag der Signalobjektdatenbank 116 ergibt. Im Falle von Hypothesenlisten überprüft der Viterbi-Schätzer bevorzugt alle möglichen Pfade durch die zeitliche Sequenz von Hypothesenlisten. Bevorzugt ermittelt er sein Bewertungsergebnis unter Berücksichtigung der zuvor ermittelten Abstände. Dies kann beispielsweise durch Division der hinzuaddierten Werte durch den Abstand vor der Addition bei der Bildung des Bewertungswerts geschehen. Auf diese Weise ermittelt der Viterbi-Schätzer die erkannten Signalobjekte 122, die dann, gegebenenfalls mit geeigneten Parametern versehen, über den Datenbus übertragen werden. Wichtig ist, dass es bei dieser Vorgehensweise nicht um das Erkennen von physikalisch im Messraum des Ultraschallwandlers 100 vorhandene Objekte und das Übertragen dieser Information geht, sondern um das Erkennen von Strukturen innerhalb des Ultraschall-Echo-Signals 1 und deren Übertragung.

Fig. 8 dient der Erläuterung der Selektion der Signalgrundobjektprototypen der Prototypendatenbank 115 durch den Abstandsermittler 112.

Die Lage der durch die Abstandsermittlung 112 in dem in diesem Ausführungsbeispiel zweidimensionalen Parameterraum der Fig. 8 ermittelten aktueller Feature-Vektor-Signalwerte des Feature-Vektor-Signals 138 kann höchst unterschiedlich sein. So ist es denkbar, dass ein solcher erster Feature-Vektor-Signalwert 146 zu weit von den Schwerpunktkoordinaten 141,142,143,144 des Schwerpunkts irgendeines Signalgrundobjektprototypen der Prototypendatenbank 115 entfernt liegt. Dieser Abstandsschwellwert kann beispielsweise der besagte minimale halbe Prototypenabstand unter den Signalgrundobjektprototypen der Prototypendatenbank 115 sein. Auch kann es sein, dass sich die Streubereiche von Signalgrundobjektprototypen der Prototypendatenbank 115 um ihre jeweiligen Schwerpunkte 143,142 überlappen und ein zweiter ermittelter aktueller Feature-Vektor-Signalwert 145 des Feature-Vektor-Signals 138 in einem solchen Überlappungsbereich liegt. In diesem Fall kann eine Hypothesenliste beide Signalgrundobjektprototypen mit wegen unterschiedlicher Abstände unterschiedlichen Wahrscheinlichkeiten als beigefügtem Parameter enthalten. Bevorzugt werden diese Wahrscheinlichkeiten durch die Abstände dargestellt. Es wird dann also nicht ein (einziges) Signalgrundobjekt als das wahrscheinlichste an den Viterbi-Schätzer 113 übergeben, sondern ein Vektor aus möglicherweise vorliegenden Signalgrundobjekten an den Viterbi-Schätzer 113 übergeben. Aus der zeitlichen Abfolge dieser Hypothesenlisten sucht dann der Viterbi-Schätzer 113 die mögliche Abfolge heraus, die die größte Wahrscheinlichkeit zu einer der vorgegebenen Signalgrundobjektfolgen in seiner Signalobjektdatenbank gegenüber allen möglichen Pfaden durch die als möglich erkannten Signalgrundobjekte 121 der vom Abstandsermittler 112 durch den Viterbi-Schätzer 113 empfangenen Hypothesenlisten aufweisen. Dabei muss in einem solchen Pfad je Hypothesenliste genau ein erkannter Signalgrundobjektprototyp dieser Hypothesenliste durch diesen Pfad durchlaufen werden.

Im besten Fall liegt der aktuelle Feature-Vektor-Signalwert 148 im Streubereich (Schwellwertellipsoid) 147 um den Schwerpunkt 141 eines einzigen Signalgrundobjektprototyps 141, der damit sicher durch den Abstandsermittler 112 erkannt und als erkanntes Signalgrundobjekt 121 an den Viterbi-Schätzer 113 weitergegeben wird.

Es ist denkbar, zur verbesserten Modellierung des Streubereichs eines einzelnen Signalgrundobjektprototyps, diesen durch mehrere hier kreisförmige Signalgrundobjektprototypen mit zugehörigen Streubereichen zu modellieren. Es können also mehrere Signalgrundobjektprototypen der Prototypendatenbank 115 denselben Signalgrundobjektprototypen einer Signalgrundobjektklasse darstellen.

Der Abstandsermittler 112 vergleicht bevorzugt jeden sich so ergebenden Feature-Vektor-Signalwert des Feature-Vektor-Signals 138 mit jedem Signalgrundobjektprototypen der Prototypendatenbank 115. Die Prototypendatenbank 115 enthält hierfür für jeden der Signalgrundobjektprototypen der Prototypendatenbank 115 einen Eintrag mit einem Schwerpunktvektor z.B. 141,142,143,144 des jeweiligen Signalgrundobjektprototypen der Prototypendatenbank 115. Bevorzugt wird ein Abstand des aktuell untersuchten Feature-Vektor-Signalwerts des Feature-Vektor-Signals 138 zu dem aktuell untersuchten Schwerpunktvektor der Prototypendatenbank 115 durch den Abstandsermittler 112 berechnet. Der Abstandsermittler 112 kann aber auch auf andere Weise eine Bewertung der Ähnlichkeit zwischen dem Schwerpunktvektor z.B. 141,142,143,144 des jeweiligen Signalgrundobjektprototypen der Prototypendatenbank 115 und dem aktuell untersuchten Feature-Vektor-Signalwert des Feature-Vektor-Signals 138 in Form eines Bewertungswerts, der hier der Einfachheit halber stets als Abstand benannt wird, berechnen. Der Abstandsermittler 112 ermittelt auf diese Weise, ob ein Schwerpunktvektor z.B. 141,142,143,144 der Signalgrundobjektprototypen der Prototypendatenbank 115 dem aktuellen Feature-Vektor-Signalwert des Feature-Vektor-Signals 138 ausreichend ähnlich ist, also einen ausreichend geringen Abstand hat und, falls dies der Fall ist, welcher Schwerpunktvektor z.B. 141,142,143,144 der Signalgrundobjektprototypen der Prototypendatenbank 115 dem aktuellen Feature-Vektor-Signalwert des Feature-Vektor-Signals 138 am ähnlichsten ist, also den geringsten Abstand hat. Gegebenenfalls ermittelt der Abstandsermittler 112 eine Liste von Schwerpunktvektoren z.B. 141,142,143,144 der Signalgrundobjektprototypen der Prototypendatenbank 115, die dem aktuellen Feature-Vektor-Signalwert des Feature-Vektor-Signals 138 ausreichend ähnlich sind, also einen ausreichend geringen Abstand haben.

Fig. 9 dient der Erläuterung des HMM-Verfahrens, das durch den Viterbi-Schätzer 113 angewandt wird, um das Signalobjekt als wahrscheinlichste Folge von Signalgrundobjektprototypen auf Grund einer Folge von erkannten Signalgrundobjektprototypen 121 als erkanntes Signalobjekt 122 zu identifizieren. Die Fig. 9 ist oben im Text erläutert.

Fig. 10 zeigt eine Zustandsabfolge im Viterbi-Schätzer 113 für die Erkennung eines einzelnen Signalobjekts. Die Fig. 10 ist oben im Text erläutert.

Fig. 11 zeigt eine bevorzugte Zustandsabfolge im Viterbi-Schätzer 113 für die kontinuierliche Erkennung eines von Signalobjekte, wie sie typischerweise für die Erkennung bei Aufgaben des autonomen Fahrens notwendig ist. Die Fig. 11 ist oben im Text erläutert.

Fig. 12 zeigt eine alternative Ausgestaltung mit einem Schätzer 151, der als ein neuronales Netzwerkmodell ausgeführt ist. Die Datenschnittstelle, der Datenbus und das Steuergerät sind zur Vereinfachung nicht eingetragen. Der Ultraschallwandler 100 wird mittels eines Ultraschallwandlersignals 102 durch eine physikalische Schnittstelle 101 angesteuert und vermessen. Die physikalische Schnittstelle 101 dient zum Treiben des Ultraschallwandlers 100 und zum Aufbereiten des vom Ultraschallwandler 100 empfangenen Ultraschallwandlersignals 102 zum Ultraschall-Echo-Signal 1 für die anschließende Signalobjektklassifikation. Bevorzugt ist das Ultraschall-Echo-Signal 1 ein digitalisiertes Signal aus einer zeitlichen Folge von Abtastwerten. Der Feature-Vektor-Extraktor 111 verfügt wieder über verschiedene Vorrichtungen, hier beispielhaft über n Optimalfilter (Optimalfilter 1 bis Optimalfilter n, mit n als ganzer positiver Zahl). Die Ausgänge der Optimalfilter bilden das Zwischenparametersignal 123. Statt der Optimalfilter oder ergänzend zu diesen können auch Integratoren, Filter, Differenzier, Logarithmierer und/oder andere signalverarbeitende Teilvorrichtungen und deren Kombinationen je nach Anwendungsfall eingesetzt werden, die dann das n-dimensionale Zwischenparametersignal 123 erzeugen. Ein vorteilhafterweise verwendeter Signifikanzsteigerer dient dazu, den n-dimensionalen Raum des Zwischenparametersignals 123 auf einen m-dimensionalen Raum des Feature-Vektor-Signals 138 abzubilden. Dabei ist m eine ganze positive Zahl. In der Regel ist m kleiner als n. Dies dient zum einen dazu, die Selektivität der Parameterwerte, aus denen sich jeder Feature-Vektor-Signalwert des Feature-Vektor-Signals 138 ergibt, zu maximieren. Dies geschieht bevorzugt durch eine lineare Abbildung mit Hilfe eines im Labor mit statistischen Verfahren bestimmten Offset-Werts, der zu den Werten der Zwischenparametersignal addiert wird, und einer so genannten LDA Matrix, mit der der jeweilige Vektor der jeweiligen Abtastwerte der Zwischenparametersignale 123 jeweils zum Feature-Vektor-Signal 138 multipliziert wird. Der Schätzer 151 versucht dann, mit Hilfe eines neuronalen Netzwerkmodells 151 die Signalobjekte in dem Datenstrom der Feature-Vektors-Signalwerte des Feature-Vektorsignals 138 zu erkennen. Die jedem Signalgrundobjektprototypen und die Signalobjekte sind dabei über die Vernetzung der Knoten innerhalb des neuronalen Netzwerkmodells und dessen Parametrisierung innerhalb des neuronalen Netzwerkmodells kodiert. Der Schätzer 151 gibt dann die erkannten Signalobjekte 122 aus.

Fig. 13 zeigt die Dekompression des übertragenen Hüllkurvensignals (Ultraschall-Echo-Signal 1) des Ultraschallempfangssignals auf Chirp-Down-Signale beschränkt.

Als erstes wird ein Ultraschall-Echo-Signal-Modell erzeugt, dass kein Signal aufweist. (Fig. 13a). Das Ultraschall-Echo-Signal-Modell ist mit einem Modellparameter SA parametrisiert, der z.B. mit der Zeit t seit dem Aussenden des Ultraschallpulses oder -bursts korreliert ist.

Dann wird dieses Ultraschall-Echo-Signal-Modell bevorzugt durch Addition um das mit Datenübertragungspriorität 1 vom Sensor an das Steuergerät übertragene erste Signalobjekt 160, das eine Dreiecksform mit Chirp-Down A beschreibt, geeignet parametrisiert ergänzt (Fig. 13b).

Das mit Datenübertragungspriorität 2 übertragene zweite Signalobjekt 161 in Dreiecksform mit Chirp-Up Charakteristik B wird für die Rekonstruktion des Chirp-Down-Signals hier nicht berücksichtigt.

Das mit Datenübertragungspriorität 3 übertragene dritte Signalobjekt 162 in Doppelspitzenform mit Chirp-Up Charakteristik B wird für die Rekonstruktion des Chirp-Down-Signals hier nicht berücksichtigt.

Dann wird das bereits ergänzte Ultraschall-Echo-Signal-Modell bevorzugt durch Addition um das mit Datenübertragungspriorität 4 vom Sensor an das Steuergerät übertragene vierte Signalobjekt 163, das eine Dreiecksform mit Chirp-Down A beschreibt, geeignet parametrisiert ergänzt (Fig. 13c).

Dann wird das bereits ergänzte Ultraschall-Echo-Signal-Modell bevorzugt durch Addition um das mit Datenübertragungspriorität 5 vom Sensor an das Steuergerät übertragene fünfte Signalobjekt 164, das eine Dreiecksform mit Chirp-Down A beschreibt, geeignet parametrisiert ergänzt (Fig. 13d).

Das mit Datenübertragungspriorität 6 übertragene sechste Signalobjekt 165 in Doppelspitzenform mit Chirp-Up Charakteristik B wird für die Rekonstruktion des Chirp-Down-Signals hier nicht berücksichtigt.

Das sich ergebende rekonstruierte Hüllkurvensignal ist das rekonstruierte Chirp-Down-Ultraschall-Echo-Signal.

Anschließend wird das so dekomprimierte und rekonstruierte Ultraschall-Echo-Signal typischerweise für die Objekterkennung im Steuergerät oder an einer anderen Stelle im Fahrzeug verwendet.

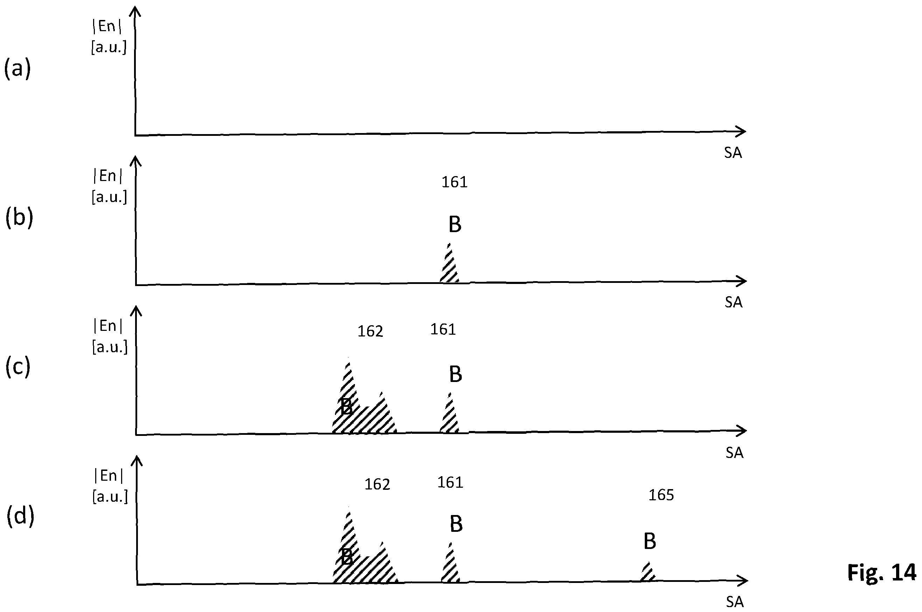

Fig. 14 zeigt die Dekompression des übertragenen Hüllkurvensignals (Ultraschall-Echo-Signals 1) des Ultraschallempfangssignals auf die Chirp-Up-Signale beschränkt.

Als erstes wird ein Ultraschall-Echo-Signal-Modell erzeugt, dass kein Signal aufweist. (Fig. 14a). Das Ultraschall-Echo-Signal-Modell ist mit einem Modellparameter SA parametrisiert, der z.B. mit der Zeit t seit dem Aussenden des Ultraschallpulses oder -bursts korreliert ist.

Das mit Datenübertragungspriorität 1 übertragene erste Signalobjekt 160 in Dreiecksform mit Chirp-Down-Charakteristik A wird für die Rekonstruktion des Chirp-Up-Signals hier nicht berücksichtigt.

Dann wird dieses Ultraschall-Echo-Signal-Modell bevorzugt durch Addition um das mit Datenübertragungspriorität 2 vom Sensor an das Steuergerät übertragene zweite Signalobjekt 161, das eine Dreiecksform mit Chirp-Up B beschreibt, geeignet parametrisiert ergänzt (Fig. 14b).

Dann wird dieses Ultraschall-Echo-Signal-Modell bevorzugt durch Addition um das mit Datenübertragungspriorität 3 vom Sensor an das Steuergerät übertragene dritte Signalobjekt 161, das eine Doppelspitzenform mit Chirp-Up B beschreibt, geeignet parametrisiert ergänzt (Fig. 14c).

Das mit Datenübertragungspriorität 4 übertragene vierte Signalobjekt 162 in Dreiecksform mit Chirp-Down-Charakteristik A wird für die Rekonstruktion des Chirp-Up-Signals hier nicht berücksichtigt.

Das mit Datenpriorität 5 übertragene fünfte Signalobjekt 163 in Dreiecksform mit Chirp-Down-Charakteristik A wird für die Rekonstruktion des Chirp-Up-Signals hier nicht berücksichtigt.

Dann wird dieses Ultraschall-Echo-Signal-Modell bevorzugt durch Addition um das mit Datenübertragungspriorität 6 vom Sensor an das Steuergerät übertragene sechste Signalobjekt 165, das eine Dreiecksform mit Chirp-Up B beschreibt, geeignet parametrisiert ergänzt (Fig. 14d).

Das sich ergebende rekonstruierte Hüllkurvensignal ist das rekonstruierte Chirp-Up-Ultraschall-Echo-Signal.

Anschließend wird das so dekomprimierte und rekonstruierte Ultraschall-Echo-Signal typischer Weise für die Objekterkennung im Steuergerät oder an einer anderen Stelle im Fahrzeug verwendet.

Fign. 15 und 16 zeigen die Dekompression des übertragenen Hüllkurvensignals (Ultraschall-Echo-Signal 1) des Ultraschallempfangssignals mit Chirp-Up-Signaten und Chirp-Down-Signalen.

Als erstes wird ein Ultraschall-Echo-Signal-Modell erzeugt, dass kein Signal aufweist. (Fig. 15a). Das Ultraschall-Echo-Signal-Modell ist mit einem Modellparameter SA parametrisiert, der z.B. mit der Zeit t seit dem Aussenden des Ultraschallpulses oder -bursts korreliert ist.

Dann wird dieses Ultraschall-Echo-Signal-Modell bevorzugt durch Addition um das mit Datenübertragungspriorität 1 vom Sensor an das Steuergerät übertragene erste Signalobjekt 160, das eine Dreiecksform mit Chirp-Down A beschreibt, geeignet parametrisiert ergänzt (Fig. 15b).

Dann wird dieses Ultraschall-Echo-Signal-Modell bevorzugt durch Addition um das mit Datenübertragungspriorität 2 vom Sensor an das Steuergerät übertragene zweite Signalobjekt 161, das eine Dreiecksform mit Chirp-Up B beschreibt, geeignet parametrisiert ergänzt (Fig. 15c).

Dann wird dieses Ultraschall-Echo-Signal-Modell bevorzugt durch Addition um das mit Datenübertragungspriorität 3 vom Sensor an das Steuergerät übertragene dritte Signalobjekt 162, das eine Doppelspitzenform mit Chirp-Up B beschreibt, geeignet parametrisiert ergänzt (Fig. 15d).

Dann wird dieses Ultraschall-Echo-Signal-Modell bevorzugt durch Addition um das mit Datenübertragungspriorität 4 vom Sensor an das Steuergerät übertragene vierte Signalobjekt 163, das eine Dreiecksform mit Chirp-Down A beschreibt, geeignet parametrisiert ergänzt (Fig. 16d).

Dann wird dieses Ultraschall-Echo-Signal-Modell bevorzugt durch Addition um das mit Datenübertragungspriorität 5 vom Sensor an das Steuergerät übertragene fünfte Signalobjekt 164, das eine Dreiecksform mit Chirp-Down A beschreibt, geeignet parametrisiert ergänzt (Fig. 16f).

Dann wird dieses Ultraschall-Echo-Signal-Modell bevorzugt durch Addition um das mit Datenübertragungspriorität 6 vom Sensor an das Steuergerät übertragene sechste Signalobjekt 165, das eine Dreiecksform mit Chirp-Up B beschreibt, geeignet parametrisiert ergänzt (Fig. 16g).

Zur Verdeutlichung ist in Fig. 16h das rekonstruierte Hüllkurvensignal fett eingezeichnet. Ansonsten stimmt Fig. 16h mit der Fig. 16g überein.

Das sich ergebende rekonstruierte Hüllkurvensignal ist das rekonstruierte Chirp-Up-/Chirp-Down-Ultraschall-Echo-Signal.

Anschließend wird das so dekomprimierte und rekonstruierte Ultraschall-Echo-Signal typischerweise für die Objekterkennung im Steuergerät oder an einer anderen Stelle im Fahrzeug verwendet.

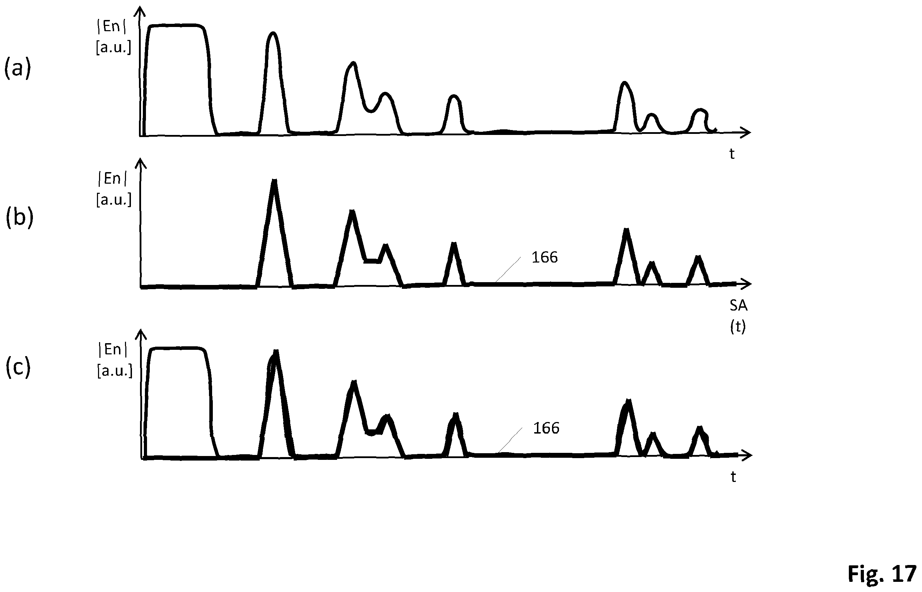

Fig. 17 zeigt das Originalsignal (a), das rekonstruierte Signal (b) und deren Überlagerung (c). Die Abweichungen zwischen dem rekonstruierten Ultraschall-Echo-Signal 166 und dem Ultraschall-Echo-Signal sind bei richtigem Vorgehen und geschickter Wahl der Signalgrundobjekte und Signalobjekte nur sehr gering.

In Fig. 18 ist zusätzlich zu den drei Diagrammen der Fig. 17 auch das Schwellwertsignal 670 gezeigt. Anhand von Diagramm d der Fig. 18 erkennt man, dass der Prozess der Extraktion von Merkmalen aus dem Echosignal abgeschlossen ist, da nämlich das Restsignal 660 kleiner ist als das Schwellsignal 670.

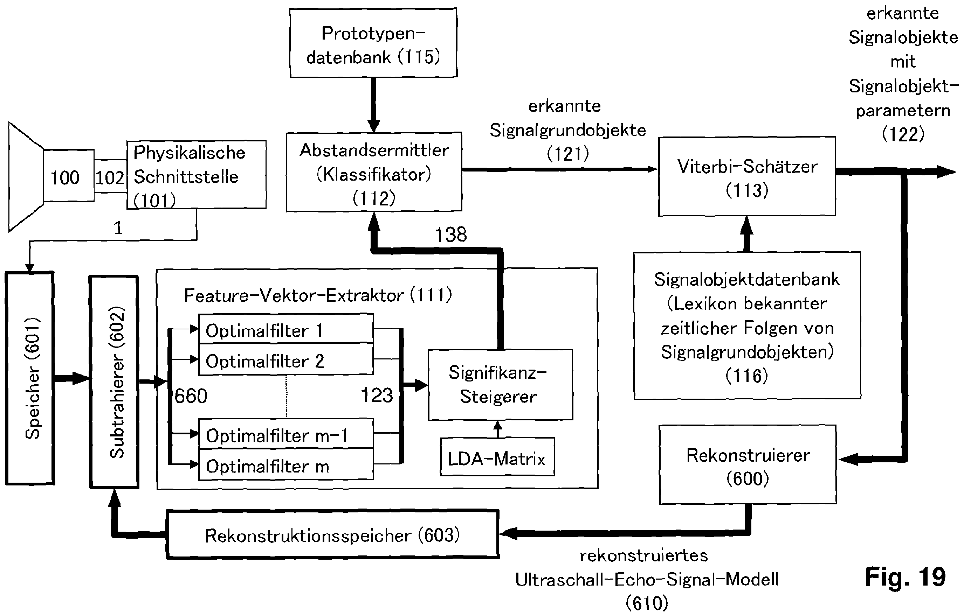

Fig. 19 zeigt eine Vorrichtung zur verbesserten Kompression. Der in den Fign. 13 bis 17 in seiner Funktion erläuterte Rekonstruierer 600 kann nicht nur im Steuergerät eingesetzt werden, sondern auch im Sensor selbst vor der Datenübertragung. Hierzu erzeugt der Rekonstruierer 600 ein rekonstruiertes Ultraschall-Echo-Signal-Modell 610 wie in den Fign. 13 bis 17 je nach Zweck dargestellt. Dieses wird von dem zuvor empfangenen Ultraschall-Echo-Signal 1 in einem Subtrahierer 602 abgezogen. Hierzu wird das Ultraschall-Echo-Signal 1 bevorzugt in Form digitaler Abtastwerte in einem Speicher 601 bevorzugt zeitlich geordnet abgelegt. Dabei korrespondiert ein abgelegter Abtastwert des Ultraschall-Echo-Signals 1 bevorzugt mit genau einem Wert des rekonstruierten Ultraschall-Echo-Signal-Modells 610, das bevorzugt ebenfalls in einem Rekonstruktionsspeicher 603 abgelegt ist. Der Rekonstruktionsspeicher 603 kann Teil des Rekonstruierers 600 sein. Dieser zusätzliche Rückkopplungszweig 600,610,603,602,601 kann auch für andere Klassifizierer wie beispielsweise für die Vorrichtung der Fig. 12 verwendet werden.

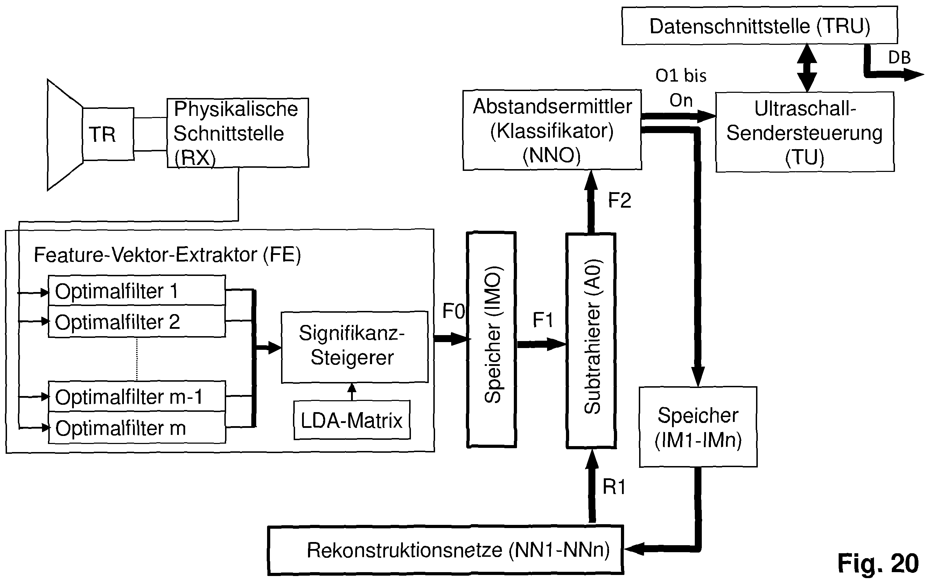

In Fig. 20 ist eine ähnliche Vorrichtung wie in Fig. 18 gezeigt, wobei allerdings die Anordnung der Blöcke der Fig. 19 in Fig. 20 geändert ist.

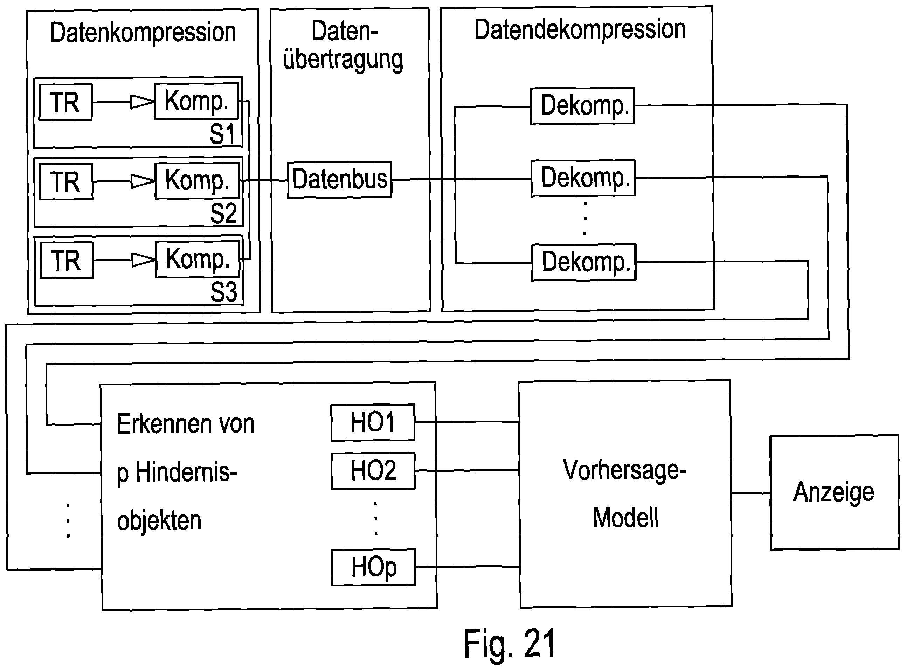

Eine Übersicht über die Einzelkomponenten eines Systems für die Erkennung von Hindernisobjekten im Umfeld beispielsweise eines Fahrzeugs zeigt Fig. 21. Das System umfasst zunächst die Datenkompression von Sensorsignaldaten von Sensoren S1,S2,Sm anhand von Signalverlaufscharakteristika, wobei diese Datenkompression erfolgt, ohne dass untersucht wird bzw. untersucht werden kann, welche realen Hindernisobjekte auf Grund der Sensorsignale existieren. Die so komprimierten Sensorsignaldaten werden über einen Datenbus an eine Datenverarbeitungseinheit übertragen, in der die Datendekompression, das Erkennen der real existierenden Hindernisobjekte und eine Vorhersage von deren Veränderungen während mehrerer Prognoseintervalle durchgeführt wird. Durch eine Anzeige lassen sich die Ergebnisse der Untersuchungen signalisieren, und zwar entweder optisch und/oder akustisch und/oder durch Anzeige von die erkannten Hindernisobjekte symbolisierenden Piktogrammen o.dgl. und/oder taktil.

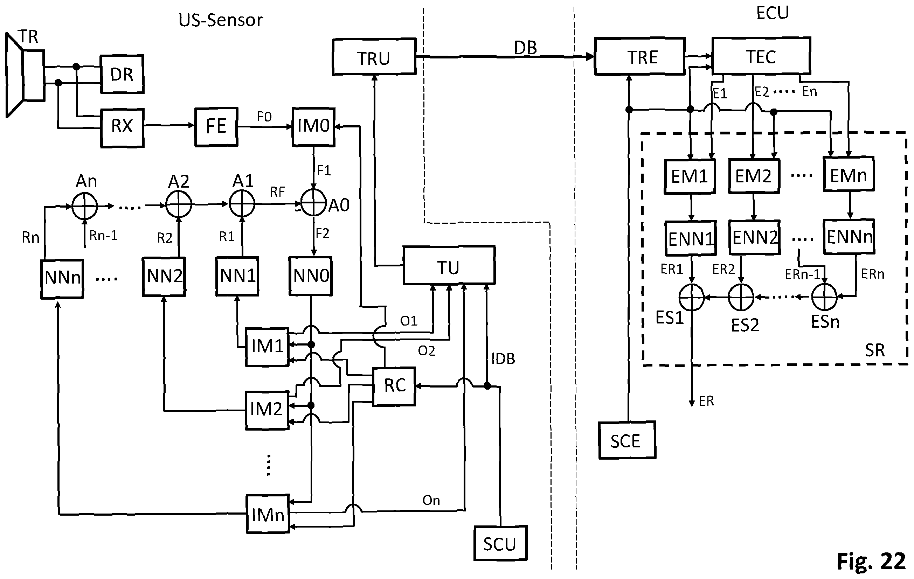

Anhand von Fig. 22 wird nachfolgend der Vorgang der Kompression und der Übertragung der Daten an eine Datenverarbeitungseinheit ECU beschrieben.

Fig. 22 zeigt das Empfangen und Komprimieren der Ultraschallsignale in einem Ultraschallsensor mit einem Treiber DK für einen US-Wandler TR und mit einem Empfänger RX, die Übertragung der komprimierten Daten über einen Datenbus DB an eine Datenverarbeitungseinheit ECU und die Dekompression der komprimierten Daten in der Datenverarbeitungseinheit ECU.

Im Folgenden wird das Empfangen von Ultraschallsignalen und die Signalverarbeitung im Ultraschallsensor beschrieben.

Der Ultraschallwandler TR wird von dem Treiber DR angesteuert, der zu diesem Zweck z.B. von der Datenverarbeitungseinheit ECU Ansteuersignale erhält. Der mit dem Ultraschallwandler TR und mit dem Treiber DR verbundene Empfänger RX bereitet die empfangenen Ultraschallsignale so auf, dass eine an den Empfänger RX angeschlossene Feature-Extraktion FE durchgeführt werden kann. Das Ergebnis der Feature-Extraktion FE ist ein Gesamtmerkmalsvektorsignal F0, das in einem nullten Zwischenspeicher IM0 gespeichert wird. Dieser nullte Zwischenspeicher IM0 übergibt das Gesamtmerkmalsvektorsignal F1 an einen nullten Summierer A0, von dem das Gesamtmerkmalsvektorsignal F1 an ein künstliches neuronales Signalobjekterkennungsnetz NN0 gegeben wird, das trainiert ist, um aus dem Gesamtmerkmalsvektorsignal F1 einzelne Signalobjekte zu erkennen.

Der Ultraschallsensor umfasst ferner einen ersten Zwischenspeicher IM1 und einen zweiten Zwischenspeicher IM2 und weitere, in Fig. 1 nicht dargestellte Zwischenspeicher mit aufsteigender Nummerierung, bis zu einem n-ten Zwischenspeicher IMn. Hierbei und im Folgenden ist n eine natürliche Zahl größer gleich 2 und repräsentiert die Anzahl speicherbarer, erkennbarer Signalobjekte. Der nullte Zwischenspeicher IM0 bis hin zum n-ten Zwischenspeicher IMn werden von einer Erkennungssteuerung RC gesteuert, die wiederum von einer Systemsteuerung SCU gesteuert wird.

Der erste Zwischenspeicher IM1 speichert ein erstes erkanntes Signalobjekt 01. Der zweite Zwischenspeicher IM2 speichert ein zweites erkanntes Signalobjekt O2. Der n-te Zwischenspeicher IMn speichert ein n-tes erkanntes Signalobjekt On. Das erste erkannte Signalobjekt O1 wird von dem ersten Zwischenspeicher IM1 an ein erstes künstliches neuronales Einzelrekonstruktionsnetz NN1 als Eingabewert übergeben. Das zweite erkannte Signalobjekt O2 wird von dem zweiten Zwischenspeicher IM2 an ein zweites künstliches neuronales Einzelrekonstruktionsnetz NN2 als Eingabewert übergeben. Das n-te erkannte Signalobjekt On wird von dem n-ten Zwischenspeicher IMn an ein n-tes künstliches neuronales Einzelrekonstruktionsnetz NNn als Eingabewert übergeben.

Das erste neuronale Einzelrekonstruktionsnetz NN1 rekonstruiert aus dem ersten erkannten Signalobjekt O1 ein erstes rekonstruiertes Einzelmerkmalsvektorsignal R1. Das zweite neuronale Einzelrekonstruktionsnetz NN2 rekonstruiert aus dem zweiten erkannten Signalobjekt O2 ein zweites rekonstruiertes Einzelmerkmalsvektorsignal R2. Das n-te neuronale Einzelrekonstruktionsnetz NNn rekonstruiert aus dem n-ten erkannten Signalobjekt On ein n-tes rekonstruiertes Einzelmerkmalsvektorsignal Rn.

Die rekonstruierten Einzelmerkmalsvektorsignale R1,R2,...,Rn werden zu einem rekonstruierten Gesamtmerkmalsvektorsignal RF summiert. Hierzu wird das n-te rekonstruierte Einzelmerkmalsvektorsignal Rn an einem n-ten Summierer An zu einem (n-1)-ten rekonstruierten Einzelmerkmalsvektorsignal Rn-1 addiert. Entsprechend wird jedes i-te rekonstruierte Einzelmerkmalsvektorsignal an einem i-ten Summierer zu einem (i-1)-ten rekonstruierten Merkmalsvektorsignal addiert, wobei i jede natürliche Zahl zwischen 1 und n ist. Somit wird das zweite rekonstruierte Einzelmerkmalsvektorsignal R2 an einem zweiten Summierer A2 addiert und das erste rekonstruierte Einzelmerkmalsvektorsignal R1 wird an einem ersten Summierer A1 addiert. Das Ergebnis der Addition aller rekonstruierten Einzelmerkmalsvektorsignale ist ein rekonstruiertes Merkmalsvektorsignal RF.

Der rekonstruierte Merkmalsvektorsignal RF wird an dem nullten Summierer A0 von dem Gesamtmerkmalsvektorsignal F1 subtrahiert. Das Ergebnis ist ein Merkmalsvektorrestsignal F2, das von dem nullten Summierer A0 als Eingabewert an das neuronale Signalobjekterkennungsnetz NN0 übergeben wird.

Das neuronale Signalobjekterkennungsnetz NN0 erkennt aus dem Merkmalsvektorrestsignal F2 die Objekte. Das erste erkannte Signalobjekt O1 wird an den ersten Zwischenspeicher IM1 übergeben. Das zweite erkannte Signalobjekt O2 wird an den zweiten Zwischenspeicher IM2 übergeben und so weiter, bis schließlich das n-te erkannte Signalobjekt On an den n-ten Zwischenspeicher IMn übergeben wird.

Die Subtraktion des rekonstruierten Merkmalsvektorsignals RF von dem Gesamtmerkmalsvektorsignal F1 und die daran anschließende Objekterkennung und Rekonstruktion des Gesamtmerkmalsvektorsignals F1 mit Hilfe der neuronalen Einzelrekonstruktionsnetzen NN1,NN2,...,NNn wird so lange durchgeführt, bis das rekonstruierte Merkmalsvektorsignal RF identisch mit dem Gesamtmerkmalsvektorsignal F1 ist, d.h. bis das Merkmalsvektorrestsignal F2 gleich Null ist. Dies bedeutet, dass die Signalobjekte aus dem Gesamtmerkmalsvektorsignal F1 von dem neuronalen Signalobjekterkennungsnetz NN0 richtig erkannt wurden.

Das erste erkannte Signalobjekt O1 wird von dem ersten Zwischenspeicher IM1 an eine Ultraschall-Sendersteuerung TU übergeben. Das zweite erkannte Signalobjekt O2 wird von dem zweiten Zwischenspeicher IM2 an die Ultraschall-Sendersteuerung TU übergeben. Das n-te erkannte Signalobjekt On wird von dem n-ten Zwischenspeicher IMn an die Ultraschall-Sendersteuerung TU übergeben. Die Ultraschall-Sendersteuerung TU übergibt die komprimierten, erkannten Signalobjekte an eine Datenbus-Schnittstelle TRU des Datenbus DB), über den die komprimierten Daten an eine Datenbus-Schnittstelle TRE der Datenverarbeitungseinheit ECU übertragen werden.

Die Erkennungssteuerung RC und die Ultraschall-Sendersteuerung TU werden über einen internen Datenbus IDB von der Ultraschall-Systemsteuerung SCU angesteuert.

Anhand des rechten Teils der Fig. 22 wird nachfolgend die Dekompression der Daten innerhalb der Datenverarbeitungseinheit ECU erläutert.

Die Datenbus-Schnittstelle TRE der Datenverarbeitungseinheit ECU übergibt die über den Datenbus DB empfangenen Daten an eine Steuerung TEC der Datenverarbeitungseinheit ECU.

Die Steuerung TEC der Datenverarbeitungseinheit ECU übergibt die über die Datenbus-Schnittstelle TRE empfangenen, ein erstes übertragenes Signalobjekt E1 repräsentierenden Daten an einen ersten Zwischenspeicher EM1 und die über die Datenbus-Schnittstelle TRE empfangenen, ein zweites übertragenes Signalobjekt E2 repräsentierenden Daten an einen zweiten Zwischenspeicher EM2 der Datenverarbeitungseinheit ECU. Entsprechend werden die empfangenen, ein i-tes übertragenes Signalobjekt repräsentierenden Daten an einen i-ten Zwischenspeicher der Datenverarbeitungseinheit ECU übertragen, wobei i eine natürliche Zahl zwischen 2 und n ist. Auch hier ist n die Anzahl der speicherbaren, erkannten Signalobjekte. Schließlich werden die empfangenen, ein n-tes übertragenes Signalobjekt En repräsentierenden Daten an einen n-ten Zwischenspeicher EMn der Datenverarbeitungseinheit ECU übertragen.

Das erste übertragene Signalobjekt E1 wird von dem ersten Zwischenspeicher EM1 der Datenverarbeitungseinheit ECU an ein erstes neuronales Einzeldekompressionsnetz ENN1 der Datenverarbeitungseinheit ECU als Eingabewert übergeben. Das zweite übertragene Signalobjekt E2 wird von dem zweiten Zwischenspeicher EM2 der Datenverarbeitungseinheit ECU an ein zweites neuronales Einzeldekompressionsnetz ENN2 der Datenverarbeitungseinheit ECU als Eingabewert übergeben. Das n-te übertragene Signalobjekt En wird von dem n-ten Zwischenspeicher EMn der Datenverarbeitungseinheit ECU an ein n-tes neuronales Einzeldekompressionsnetz ENNn der Datenverarbeitungseinheit ECU als Eingabewert übergeben.

Die neuronalen Einzelrekonstruktionsnetze ENN1,ENN2,...,ENNn der Datenverarbeitungseinheit ECU sind genauso parametrisiert, wie die entsprechenden neuronalen Einzelrekonstruktionsnetze NN1,NN2,...,NNn im Ultraschallsensor. Das erste neuronale Einzeldekompressionsnetz ENN1 der Datenverarbeitungseinheit ECU ist genauso parametrisiert wie das erste neuronale Einzelrekonstruktionsnetz NN1 im Ultraschallsensor. Das zweite neuronale Einzeldekompressionsnetz ENN2 der Datenverarbeitungseinheit ECU ist genauso parametrisiert wie das zweite neuronale Einzelrekonstruktionsnetz NN2. Entsprechend ist das i-te neuronale Einzeldekompressionsnetz ENNn der Datenverarbeitungseinheit ECU genauso parametrisiert wie das i-te neuronale Einzelrekonstruktionsnetz NNn im Ultraschallsensor, wobei i eine natürliche Zahl zwischen 1 und n ist. Schließlich ist das n-te neuronale Einzeldekompressionsnetz ENNn der Datenverarbeitungseinheit ECU genauso parametrisiert wie das n-te neuronale Einzelrekonstruktionsnetz NNn. Auch hier entspricht n der Anzahl der speicherbaren, erkennbaren Objekte.

Das erste neuronale Einzeldekompressionsnetz ENN1 der Datenverarbeitungseinheit ECU rekonstruiert aus den übertragenen Daten für das erste übertragene Signalobjekt E1 ein erstes rekonstruiertes Einzelmerkmalsvektorsignal ER1. Das zweite neuronale Einzeldekompressionsnetz ENN2 der Datenverarbeitungseinheit ECU rekonstruiert aus den übertragenen Daten für das zweite übertragene Signalobjekt E2 ein zweites rekonstruiertes Einzelmerkmalsvektorsignal ER2. Das n-te neuronale Einzeldekompressionsnetz ENNn der Datenverarbeitungseinheit ECU rekonstruiert aus den übertragenen Daten für das n-te übertragene Signalobjekt En ein n-tes rekonstruiertes Einzelmerkmalsvektorsignal ERn.

Das erste rekonstruierte Einzelmerkmalsvektorsignal ER1 in der Datenverarbeitungseinheit ECU und das zweite rekonstruierte Einzelmerkmalsvektorsignal ER2 in der Datenverarbeitungseinheit ECU und alle weiteren rekonstruierten Einzelmerkmalsvektorsignale in der Datenverarbeitungseinheit ECU bis einschließlich dem n-ten rekonstruierten Einzelmerkmalsvektorsignals ERn werden zu einem rekonstruierten Gesamtmerkmalsvektorsignal ER in der Datenverarbeitungseinheit ECU summiert.

Hierzu wird das n-te rekonstruierte Einzelmerkmalsvektorsignal ERn an einem n-ten Summierer ESn der Datenverarbeitungseinheit ECU zu einem (n-1)-ten rekonstruierten Einzelmerkmalsvektorsignal ERn-1 addiert. Entsprechend wird jedes i-te rekonstruierte Einzelmerkmalsvektorsignal an einem i-ten Summierer der Datenverarbeitungseinheit ECU zu einem (i-1)-ten rekonstruierten Einzelmerkmalsvektorsignal addiert, wobei i jede natürliche Zahl zwischen 1 und n ist. Somit wird das zweite rekonstruierte Einzelmerkmalsvektorsignal ER2 an einem zweiten Summierer ES2 der Datenverarbeitungseinheit ECU addiert und das erste rekonstruierte Einzelmerkmalsvektorsignal ER1 wird an einem ersten Summierer ES1 der Datenverarbeitungseinheit ECU addiert. Das Ergebnis der Addition aller rekonstruierten Einzelmerkmalsvektorsignale ist das rekonstruierte Gesamtmerkmalsvektorsignal ER der Datenverarbeitungseinheit ECU.

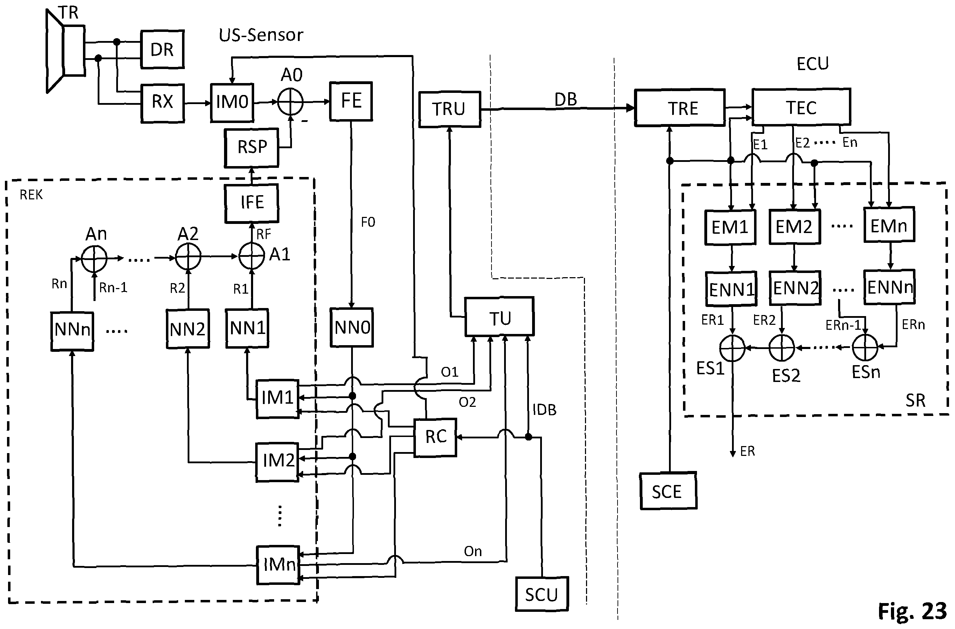

In Fig. 23 ist eine Alternative für das Kompressionsverfahren beschrieben, das zuvor bezogen auf den linken Teil der Fig. 22 erläutert worden ist. Bei dieser Variante wird das Sensorsignal, das vom Empfänger RX des US-Sensors kommt, in dem Zwischenspeicher IM0. Nach der wie zuvor beschriebenen Extraktion eines Signalobjekt mit Hilfe des neuronalen Signalobjekterkennungsnetzes NN0 erfolgt die Abspeicherung dieses Signalobjekts in einem dafür vorgesehenen Zwischenspeicher und die Erzeugung des Einzelmerkmalsvektors R1,R2,...,Rn durch ein dem Zwischenspeicher zugeordnetes neuronales Einzelrekonstruktionsnetz NN1,NN2,...,NNn. Nun erfolgt eine Rücktransformation des betreffenden Einzelmerkmalsvektorsignals in den Zeitbereich, und zwar mit Hilfe einer sozusagen "inversen" Merkmalsextraktion IFE, die zu einer Darstellung des Signalobjekts im Zeitbereich, also zu einem Kurvenverlauf führt. Dieser Kurvenverlauf wird nun von dem Sensorsignal subtrahiert, so dass sich ein Restsensorsignal bildet, das nach einer Merkmalsextraktion FE als Gesamtmerkmalsvektorrestsignal dem Signalobjekterkennungsnetz zugeführt wird. Der zuvor beschriebene Prozess wiederholt sich dann entsprechend.

Der zuvor beschriebene iterative Prozess der sukzessiven Einzelextraktion von Signalobjekten kann in entsprechender Weise auch für den obigen anhand von Fig. 22 beschriebenen Datenkompressionsprozess erfolgen. In dem Fall wird von dem Gesamtmerkmalsvektorsignal jeweils schrittweise ein Einzelmerkmalsvektorsignal subtrahiert. Dies kann auch durch Verwendung lediglich eines einzigen neuronalen Einzelrekonstruktionsnetzes erfolgen, statt jedem Zwischenspeicher ein separates Einzelrekonstruktionsnetz zuzuordnen.

Mit REK ist in Fig. 23 angedeutet, welche Komponenten zum sogenannten Rekonstruierer gehören, der beispielsweise in Fig. 19 mit dem Bezugszeichen 600 bezeichnet ist. Insoweit entspricht also der gestrichelte Block REK in Fig. 23 dem Rekonstruierer 600 gemäß Fig. 19. Dem Rekonstruktionsspeicher RSP entspricht der Rekonstruktionsspeicher 603 der Fig. 19.

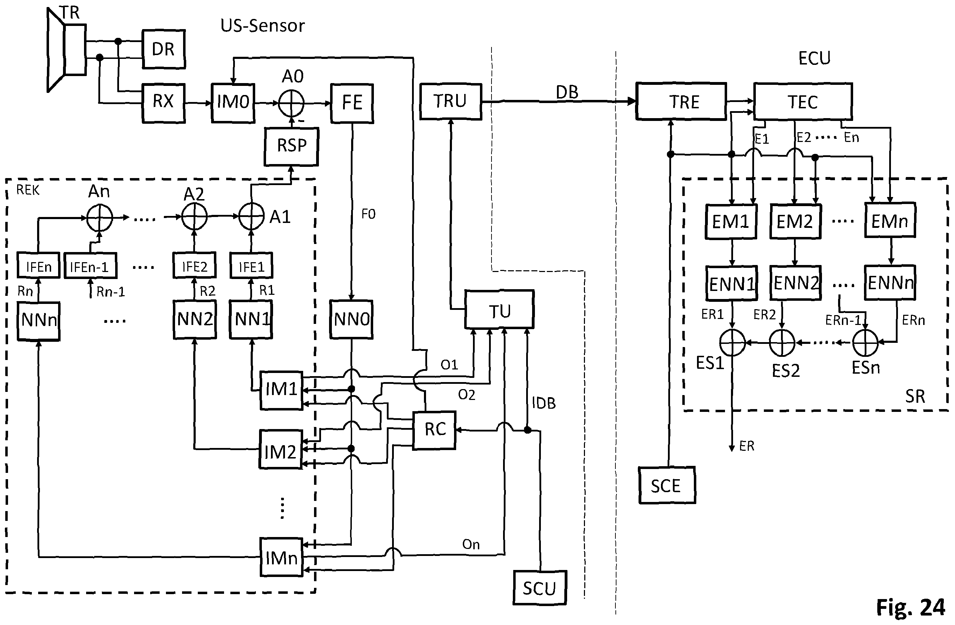

Anhand von Fig. 24 wird nachfolgend eine weitere Variante der Datenkompression beschrieben, wie sie zuvor anhand der linken Hälften der Fign. 22 und 23 für andere Verfahren beschrieben worden ist. Auch hier wird, wie im Zusammenhang mit Fig. 23 beschrieben, eine Rücktransformation in den Zeitbereich durchgeführt. Im Unterschied zur Rücktransformation bei dem Verfahren gemäß Fig. 23 allerdings werden die einzelnen Einzelmerkmalsvektorsignale R1,R2,Rn-1,Rn jeweils in einer eigenen inversen Feature-Extraktion IFE1,IFE2,...,IFEn-1,IFEn in den Zeitbereich rücktransformiert und jeweils in dem Rekonstruktionsspeicher RSP abgespeichert, um dort gegebenenfalls Schritt für Schritt akkumuliert zu werden, und zwar nach jeder Subtraktion vom Sensorsignal und der Erkennung eines potentiellen weiteren Signalobjekts im Restsensorsignal.

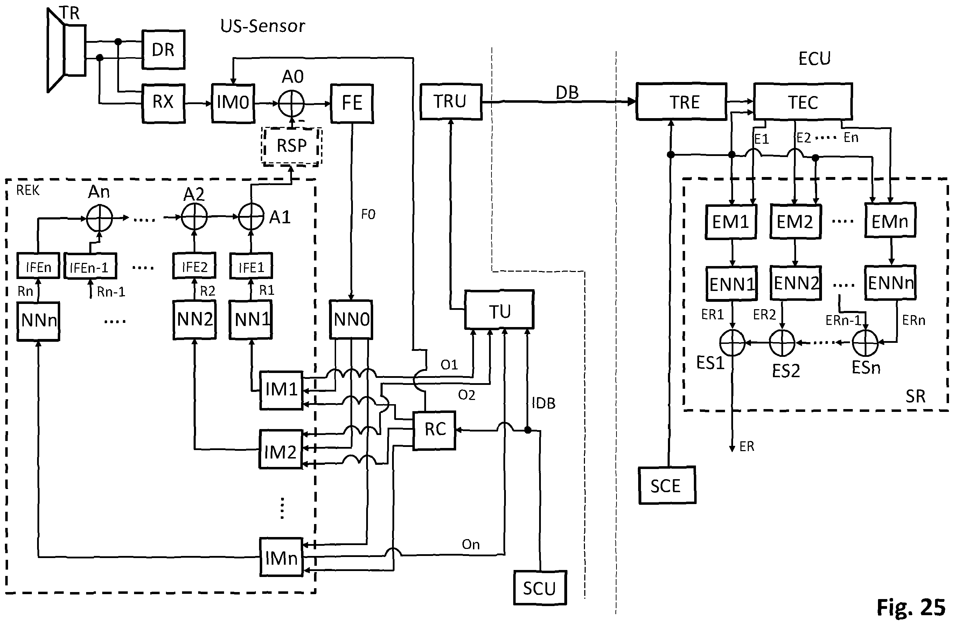

Der Aufbau des Rekonstruierers REK gemäß Fig. 23 lässt sich auch einsetzen, um beispielsweise statt einer seriellen sequentiellen Signalobjektextraktion bzw. -erkennung diesen Vorgang parallel durchzuführen. Dies ist in Fig. 25 gezeigt. Das neuronale Signalobjekterkennungsnetz NN0 ist mit den einzelnen Zwischenspeichern IM1,IM2,...,IMn über jeweils getrennte Leitungen verbunden. Die Rücktransformation der von den neuronalen Einzelrekonstruktionsnetzen NN1,NN2,...,NNn erzeugten Einzelmerkmalsvektorsignale R1,R2,Rn-1,Rn in den Zeitbereich erfolgt wieder durch eigene inverse Feature-Extraktionen IFE1,IFE2,IFEn-1,IFEn. Es wird die Summe all der rücktransformierten Signalobjekte (d.h. der entsprechenden Kurvenverläufe) gebildet. Das Ergebnis kann, braucht aber nicht zwingend in einem Rekonstruktionsspeicher RSP abgelegt werden bzw. abgelegt zu werden.

Die anhand des Ausführungsbeispiels gemäß Fig. 25 gezeigte Möglichkeit der Parallelverarbeitung der Signalobjektextraktion lässt sich in analoger Weise auch bei den Ausführungsbeispielen nach den Fign. 22 bis 24 realisieren. Das neuronale Signalobjekterkennungsnetz NN0 wäre dann jeweils mit den Zwischenspeichern IM1,IM2,...,IMn durch separate Leitungen verbunden.

Will man die Signalobjekterkennung schrittweise, also sukzessive durchführen, wie es anhand der Fign. 22 bis 24 gezeigt ist, so sollte man noch für eine Steuerung der Verteilung der sukzessiv ermittelten Signalobjekte auf die Zwischenspeicher sorgen. Damit wird sichergestellt, dass in einem Zwischenspeicher nur ein einziges Signalobjekt abgelegt ist, das im Laufe des Prozesses auch nicht überschrieben wird.

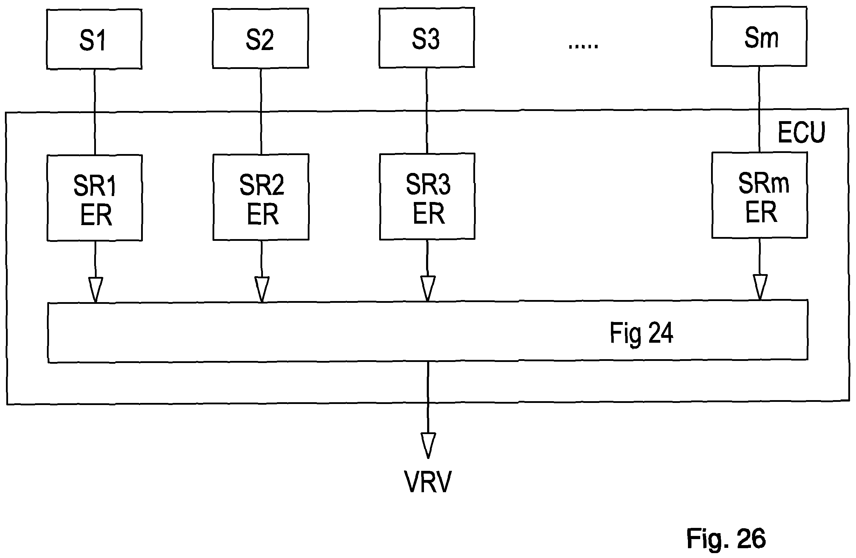

Anhand der Fign. 26 und 27 wird nachfolgend die Erkennung von Hindernisobjekten anhand der rekonstruierten Gesamtmerkmalsvektorsignalen EF1,EF2,...,EFm mehrerer Sensoren S1,S2,S3,...,Sm beschrieben, wobei in Fig. 27 ferner in Form eines Blockschaltbildes ein Modellteil (rechter Teil der Fig. 27) gezeigt ist, mit dem sich Vorhersagen über die Veränderung der Hindernisobjekte hinsichtlich deren Relativposition zum einem Fahrzeug auf Grund einer Relativbewegung beider angeben lässt.

Fig. 26 zeigt schematisch mehrere Sensoren S1,S2,S3,...,Sm, deren komprimierte Sensorsignaldaten an eine Datenverarbeitungseinheit ECU übertragen werden. Diese Datenverarbeitungseinheit ECU kann die gleiche sein wie die zuvor genannte Datenverarbeitungseinheit oder eine davon getrennte sein. Den übertragenen komprimierten Sensorsignaldaten jedes Sensors zugeordnet wird eine Rekonstruktion und damit eine Dekomprimierung der Sensorsignaldaten durchgeführt (siehe bei SR1ER,SR2ER,SR3ER,...,SRmER). Die jeweiligen rekonstruierten Gesamtmerkmalsvektorsignale EF1,EF2,...,EFm werden einem mit Fig. 27 bezeichneten Funktionsblock zugeführt, dessen Ausgang ein virtuelles Realitätsvektorsignal ist, das für jeweils einen gegebenen Zeitpunkt das Umfeld eines Fahrzeugs beispielsweise in Form einer Umfeldkarte beschreibt,

Fig. 27 zeigt ein erfindungsgemäßes Blockschaltbild, welches im linken Teil einen Realteil und im rechten Teil einen Modellteil umfasst. Die Eingangsgrößen der Fig. 27 sind mehrere, hier m, rekonstruierte Gesamtmerkmalsvektorsignale ER der Datenverarbeitungseinheit ECU für m verschiedene Sensoren S1,S2,S3,...,Sm oder m verschiedene Sensorsysteme. Um eine Verwechslung mit den Bezugszeichen ER1 bis Ern der Fig. 22 zu vermeiden, sind die zu verschiedenen Zeitpunkten rekonstruierten Gesamtmerkmalsvektorsignale der m Sensoren S1 bis Sm mit den Bezugszeichen EF1,EF2 bis EFm bezeichnet.

Innerhalb des Realteils werden die rekonstruierten Gesamtmerkmalsvektorsignale EF1,EF2 bis EFm, die die Signale der verschiedenen Sensoren S1,S2,S3,...,Sm repräsentieren (nachfolgend als Gesamtmerkmalsvektorsignale eines Sensors bezeichnet), verarbeitet, um Hindernisobjekte HO1,HO2,...,HOp zu erkennen. Im Modellteil werden auf Basis der im Realteil erkannten Hindernisobjekte HO1,HO2,...,HOp Vorhersagen über die räumlichen Positionen der Hindernisobjekte zwischen den Messzeitpunkten gemacht, die mit höherer Abtastrate ausgelesen werden können. Das Problem, das damit gelöst werden soll, ist, dass trotz nicht beliebig kurzer Zeitabstände der Ultraschallmessungen zwischen dem Aussenden zeitlich aufeinanderfolgender Ultraschallpulse (Burst) eine Aussage über die Veränderung der Hindernisobjekte hinsichtlich ihrer Lage relativ zum Fahrzeug getroffen werden soll. Der Modellteil simuliert also quasi die Realität, so dass das Fahrzeug beim autonomen Fahren auch zwischen den Ultraschallmessungen navigieren kann, also ohne dass Ultraschallpulse zu bestimmten Zeitpunkten ausgesendet werden. Die tatsächliche Messrate sollte so hoch wie möglich gewählt werden, um das Modell nach jeder Messung mit den realen Messwerten abzugleichen und so möglichst nahe an der Realität zu halten. Dieser Abgleich erfolgt durch das Zusammenspiel zwischen dem Realteil und dem Modellteil. Das in Fig. 27 gezeigte Blockschaltbild kann bevorzugt in einer Datenverarbeitungseinheit ECU wie z.B. einem Ultraschallmesssystem-Steuergerät eines Fahrzeugs implementiert werden.

Zunächst wird das Blockschaltbild des Realteils, also des rechten Teils der Fig. 27 beschrieben.

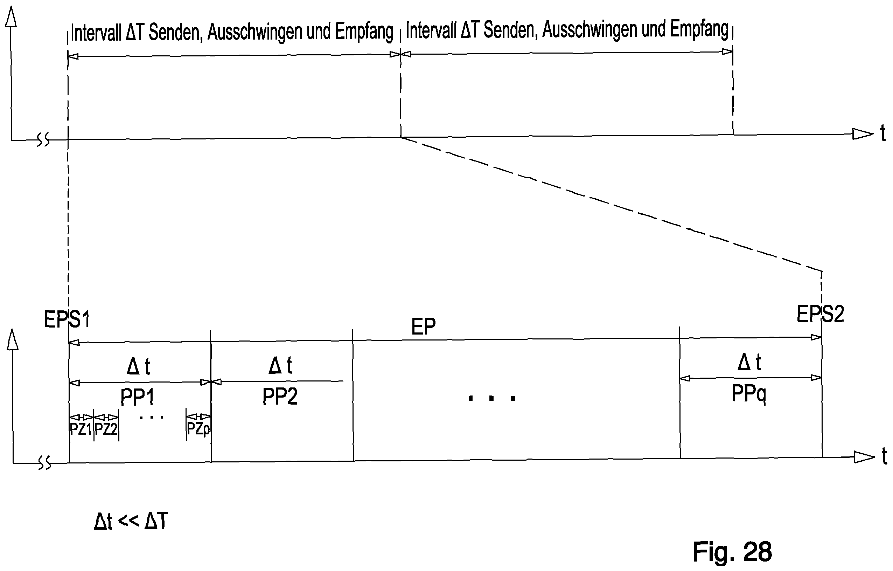

Das Verfahren im Realteil läuft zyklisch in Erkennungsperioden EP ab, die in Zyklen unterteilt sind (siehe Fig. 28).

Von einem rekonstruierten Gesamtmerkmalsvektorsignal EF für das Sensorsignal des ersten Sensors S1 (nachfolgend mit Gesamtmerkmalsvektorsignal eines Sensors bezeichnet) wird an einem ersten Summierer RS1 ein erstes rekonstruiertes Merkmalsvektorsignal EV1 des Realteils abgezogen. Als kompaktere Ausdrucksweise wird in diesem Text der Begriff "Sensor" verwendet. Es ist jedoch dem Fachmann bewusst, dass sich auch ein Sensorsystem wie ein Sensor verhalten kann, so dass mit der Bezeichnung "Sensor" immer auch "Sensorsystem" gemeint ist. Das Ergebnis der Subtraktion ist das erste korrigierte Merkmalsvektorsignal EC1 als ein Eingabewert für ein neuronales Gesamthinderniserkennungsnetz ANNO. Es wird also nur das Ergebnis der Subtraktion an das künstliche neuronale Gesamthinderniserkennungsnetz ANNO weitergegeben, das von dem schon vorhandenen Hindernisobjekt-Erkennungsergebnis in Form des ersten rekonstruierten Merkmalsvektorsignals EV1 abweicht. Zu Beginn einer Erkennungsperiode wird der Wert des ersten rekonstruierten Merkmalsvektorsignals EV1 daher auf Null gesetzt, so dass dieser in dieser Phase keine Veränderung erzeugt.

Von dem rekonstruierten Gesamtmerkmalsvektorsignal EF2 des zweiten Sensors S2 wird an einem zweiten Summierer RS2 ein zweites rekonstruiertes Merkmalsvektorsignal EV2 abgezogen. Das Ergebnis der Subtraktion ist das zweite korrigierte Merkmalsvektorsignal EC2 als ein Eingabewert für das neuronale Gesamthinderniserkennungsnetz ANNO. Es wird also nur das Ergebnis der Subtraktion an das neuronale Gesamthinderniserkennungsnetz ANNO weitergegeben, das von dem schon vorhandenen Hindernisobjekt-Erkennungsergebnis in Form des zweiten rekonstruierten Merkmalsvektorsignals EV2 abweicht. Zu Beginn einer Erkennungsperiode wird der Wert des zweiten rekonstruierten Merkmalsvektorsignals EV2 daher auf Null gesetzt, so dass dieser in dieser Phase keine Veränderung erzeugt.

Von dem rekonstruierten Gesamtmerkmalsvektorsignal EF3 des dritten Sensors S3 wird an einem dritten Summierer RS3 ein drittes rekonstruiertes Merkmalsvektorsignal EV3 abgezogen. Das Ergebnis der Subtraktion ist das dritte korrigierte Merkmalsvektorsignal EC3 als ein Eingabewert für das neuronale Gesamthinderniserkennungsnetz ANNO. Es wird also nur das Ergebnis der Subtraktion an das neuronale Gesamthinderniserkennungsnetz ANNO weitergegeben, das von dem schon vorhandenen Hindernisobjekt-Erkennungsergebnis in Form des dritten rekonstruierten Merkmalsvektorsignals EV3 abweicht. Zu Beginn einer Erkennungsperiode wird der Wert des dritten rekonstruierten Merkmalsvektorsignals EV3 daher auf Null gesetzt, so dass dieser in dieser Phase keine Veränderung erzeugt.

Von einem rekonstruierten Gesamtmerkmalsvektorsignal EFm des m-ten Sensors Sm wird an einem m-ten Summierer RSm ein m-tes rekonstruiertes Merkmalsvektorsignal EVm abgezogen. Das Ergebnis der Subtraktion ist das m-te korrigierte Merkmalsvektorsignal ECm als ein Eingabewert für das neuronale Gesamthinderniserkennungsnetz ANNO. Die Variable m repräsentiert hierbei die Anzahl der Sensoren. Es wird also nur das Ergebnis an das neuronale Gesamthinderniserkennungsnetz ANNO weitergegeben, das von dem schon vorhandenen Erkennungsergebnis in Form des m-ten rekonstruierten Merkmalsvektorsignals EVm abweicht. Zu Beginn einer Erkennungsperiode wird der Wert des ersten rekonstruierten Merkmalsvektorsignals EV1 daher auf Null gesetzt, so dass dieser in dieser Phase keine Veränderung erzeugt.

Das neuronale Gesamthinderniserkennungsnetz ANNO erkennt innerhalb eines Zyklus aus den korrigierten Merkmalsvektorsignalen EC1 bis ECm ein am wahrscheinlichsten vorliegendes, dominierendes Hindernisobjekt HO1,HO2,...HOp.

Das im ersten Zyklus durch das Gesamthinderniserkennungsnetz ANNO erkannte erste Hindernisobjekt HO1 wird in einem ersten Zwischenspeicher EO1 des Realteils gespeichert. Dadurch ändert sich das erste rekonstruierte Merkmalsvektorsignal EV1, was später erläutert wird.

Das im zweiten Zyklus durch das Gesamthinderniserkennungsnetz ANNO erkannte zweite Hindernisobjekt HO2 wird in einem zweiten Zwischenspeicher EO2 des Realteils gespeichert. Dadurch ändert sich das zweite rekonstruierte Merkmalsvektorsignal EV2, was später erläutert wird.

Das im p-ten Zyklus durch das Gesamthinderniserkennungsnetz ANNO erkannte p-te Hindernisobjekt HOp wird in einem p-ten Zwischenspeicher EOp des Realteils gespeichert.

Die Variable p repräsentiert hierbei die Anzahl der erkannten Hindernisobjekte und damit die Anzahl der Zyklen pro Erkennungsperiode.

Ein erstes neuronales Einzelhindernisobjekterkennungsnetz RNN1 des Realteils rekonstruiert aus den im ersten Zwischenspeicher EO1 gespeicherten Informationen m Merkmalsvektorsignale RO11 bis RO1m, die das erste erkannte Hindernisobjekt HO1 zumindest teilweise repräsentieren (nachfolgend als Merkmalsvektorsignal des ersten erkannten Hindernisobjekts bezeichnet) und die zusammen mit anderen Merkmalsvektorsignalen RO22,...,ROp1 zur Korrektur der Eingabe des Gesamtmerkmalsvektorsignals EF1,EF2,...,EFm der Sensoren S1,S2,...,Sm dienen, was weiter unten noch beschrieben wird. Die das erste Hindernisobjekt HO1 repräsentierenden m rekonstruierten Merkmalsvektorsignale RO11 bis RO1m des ersten Hindernisobjekts HO1 umfassen ein rekonstruiertes Merkmalsvektorsignal RO11 des ersten Hindernisobjekts HO1 zur Korrektur des Gesamtmerkmalsvektorsignals EF1 des ersten Sensors S1 und ein rekonstruiertes Merkmalsvektorsignal RO12 des ersten Hindernisobjekts HO1 zur Korrektur des Gesamtmerkmalsvektorsignals EF2 des zweiten Sensors S2 und ein rekonstruiertes Merkmalsvektorsignal RO13 des ersten Hindernisobjekts HO1 zur Korrektur des Gesamtmerkmalsvektorsignals EF3 des dritten Sensors S3, etc., bis zu einem rekonstruierten Merkmalsvektorsignal RO1m des ersten Hindernisobjekts HO1 zur Korrektur dess Gesamtmerkmalsvektorsignals EFm des m-ten Sensors Sm. Des Weiteren gibt das erste neuronale Einzelhindernisobjekterkennungsnetz RNN1 ein rekonstruiertes Merkmalsvektorsignal RO1 des ersten Hindernisobjekts HO1 für alle m Sensoren S1 bis Sm aus. Dieses rekonstruierte Merkmalsvektorsignal RO1 des ersten Hindernisobjekts HO1 für alle m Sensoren S1 bis Sm repräsentiert eine modellhafte Vorstellung über ein Hindernisobjekt mit erkannten Eigenschaften, wie beispielsweise Position im Raum, Orientierung, Objektart, Bewegungsrichtung, Objektgeschwindigkeit etc. Bevorzugt ist dieser zumindest teilweise eine Kaskadierung der anderen rekonstruierten Merkmalsvektorsignale RO11 bis RO1m des ersten Hindernisobjekts HO1 für die m Sensoren S1 bis Sm in einem gemeinsamen Spaltenvektor. Wenn hier von Vektoren die Rede ist, ist von Signalen mit Werten die Rede, die diese Werte im Zeit- oder Raummultiplex signalisieren, wobei diese Werte dann ein Tupel bilden, das den Vektor darstellt. Das rekonstruierte Merkmalsvektorsignal RO1 des ersten Hindernisobjekts HO1 für alle m Sensoren S1 bis Sm wird am Ende des ersten Zyklus in einem ersten Hindernisobjektspeicher SP1 zwischengespeichert. Die Ausgabe des ersten Hindernisobjektspeichers SP1 ist das erste rekonstruierte und gespeicherte Merkmalsvektorsignal ROS1 des ersten Hindernisobjekts HO1.

Ein zweites neuronales Einzelhindernisobjekterkennungsnetz RNN2 des Realteils rekonstruiert aus den im zweiten Zwischenspeicher EO2 gespeicherten Informationen m Merkmalsvektorsignale RO21 bis RO2m, die das zweite Hindernisobjekt HO2 zumindest teilweise repräsentieren (nachfolgend als Merkmalsvektorsignal des zweiten erkannten Hindernisobjekts bezeichnet) und die zusammen mit anderen Merkmalsvektorsignalen RO21,...,ROp zur Korrektur der Eingabe des Gesamtmerkmalsvektorsignals EF1,EF2,...,EFm der Sensoren S1,S2,...,Sm dienen, was weiter unten noch beschrieben wird. Die das zweite Hindernisobjekt HO2 repräsentierenden m rekonstruierten Merkmalsvektorsignale RO21 bis RO2m des zweiten Hindernisobjekts HO2 umfassen ein rekonstruiertes Merkmalsvektorsignal RO21 des zweiten Hindernisobjekts HO2 zur Korrektur des Gesamtmerkmalsvektorsignals EF1 des ersten Sensors S1 und ein rekonstruiertes Merkmalsvektorsignal RO22 des zweiten Hindernisobjekts HO2 zur Korrektur des Gesamtmerkmalsvektorsignals EF2 des zweiten Sensors S2 und ein rekonstruiertes Merkmalsvektorsignal RO23 des zweiten Hindernisobjekts HO2 zur Korrektur des Gesamtmerkmalsvektorsignals EF3 des dritten Sensors S3, etc., bis zu einem rekonstruierten Merkmalsvektorsignal RO2m des zweiten Hindernisobjekts HO2 zur Korrektur des Gesamtmerkmalsvektorsignals EFm des m-ten Sensors Sm. Des Weiteren gibt das zweite neuronale Einzelhindernisobjekterkennungsnetz RNN2 ein rekonstruiertes Merkmalsvektorsignal RO2 des zweiten Hindernisobjekts HO2 für alle m Sensoren S1 bis Sm aus. Dieses rekonstruierte Merkmalsvektorsignal RO2 des zweiten Hindernisobjekts HO2 für alle m Sensoren S1 bis Sm repräsentiert eine modellhafte Vorstellung über ein Hindernisobjekt mit erkannten Eigenschaften, wie beispielsweise Position im Raum, Orientierung, Objektart, Bewegungsrichtung, Objektgeschwindigkeit etc. Bevorzugt ist dieser zumindest teilweise eine Kaskadierung der anderen rekonstruierten Merkmalsvektorsignale R21 bis R2m des zweiten Hindernisobjekts HO2 für die m Sensoren S1 bis Sm in einem gemeinsamen Spaltenvektor. Wenn hier von Vektoren die Rede ist, ist von Signalen mit Werten die Rede, die diese Werte im Zeit- oder Raummultiplex signalisieren, wobei diese Werte dann ein Tupel bilden, das den Vektor darstellt. Das rekonstruierte Merkmalsvektorsignal RO2 des zweiten Hindernisobjekts HO2 für alle m Sensoren S1 bis Sm wird am Ende des zweiten Zyklus in einem zweiten Hindernisobjektspeicher SP2 zwischengespeichert. Die Ausgabe des zweiten Hindernisobjektspeichers SP2 ist das zweite rekonstruierte und gespeicherte Merkmalsvektorsignal ROS2 des zweiten Hindernisobjekts HO2.

Ein p-tes neuronales Einzelhindernisobjekterkennungsnetz RNNp des Realteils rekonstruiert aus den im p-ten Zwischenspeicher EO2 gespeicherten Informationen m Merkmalsvektorsignale ROp1 bis ROpmm due das erste erkannte Hindernisobjekt HO1 zumindest teilweise repräsentieren (nachfolgend als Merkmalsvektorsignal des ersten erkannten Hindernisobjekts bezeichnet) und die zusammen mit anderen Merkmalsvektorsignalen ROp1 zur Korrektur der Eingabe des Gesamtmerkmalsvektorsignals EF1,EF2,...,EFm der Sensoren S1,S2,...Sm dienen, was weiter unten noch beschrieben wird. Die das erste Hindernisobjekt H=1 repräsentierenden m rekonstruierten Merkmalsvektorsignale ROp1 bis ROpm des p-ten Hindernisobjekts HOp umfassen ein rekonstruiertes Merkmalsvektorsignal ROp1 des p-ten Hindernisobjekts HOp zur Korrektur des Gesamtmerkmalsvektorsignals EF1 des ersten Sensors S1 und ein rekonstruiertes Merkmalsvektorsignal ROp2 des p-ten Hindernisobjekts HOp zur Korrektur des Gesamtmerkmalsvektorsignals des zweiten Sensors S2 und ein rekonstruiertes Merkmalsvektorsignal ROp3 des p-ten Hindernisobjekts HOp zur Korrektur des Gesamtmerkmalsvektorsignals EF3 des dritten Sensors S3, etc., bis zu einem rekonstruierten Merkmalsvektorsignal ROpm des p-ten Hindernisobjekts HOp zur Korrektur des Gesamtmerkmalsvektorsignals EFm des m-ten Sensors Sm.

Des Weiteren gibt das p-te neuronale Einzelhindernisobjekterkennungsnetz RNNp ein rekonstruiertes Merkmalsvektorsignal ROp des p-ten Hindernisobjekts HOp für alle m Sensoren S1 bis Sm aus. Dieses rekonstruierte Merkmalsvektorsignal ROp des p-ten Hindernisobjekts HOp für alle m Sensoren S1 bis Sm repräsentiert eine modellhafte Vorstellung über ein Hindernisobjekt mit erkannten Eigenschaften, wie beispielsweise Position im Raum, Orientierung, Objektart, Bewegungsrichtung, Objektgeschwindigkeit etc. Bevorzugt ist dieser zumindest teilweise eine Kaskadierung der anderen rekonstruierten Merkmalsvektorsignale Rp1 bis Rpm des p-ten Hindernisobjekts HOp für die m Sensoren S1 bis Sm in einem gemeinsamen Spaltenvektor. Wenn hier von Vektoren die Rede ist, ist von Signalen mit Werten die Rede, die diese Werte im Zeit- oder Raummultiplex signalisieren, wobei diese Werte dann ein Tupel bilden, das den Vektor darstellt. Das rekonstruierte Merkmalsvektorsignal ROp des p-ten Hindernisobjekts HOp für alle m Sensoren S1 bis Sm wird am Ende des p-ten Zyklus in einem p-ten Hindernisobjektspeicher SPp zwischengespeichert. Die Ausgabe des p-ten Hindernisobjektspeichers SPp ist das p-te rekonstruierte und gespeicherte Merkmalsvektorsignal ROSp des p-ten Hindernisobjekts HOp.

Das erste rekonstruierte Merkmalsvektorsignal EV1 ist die Summe aus dem rekonstruierten Merkmalsvektorsignal RO11 des ersten Hindernisobjekts HO1 für den ersten Sensor S1 und dem rekonstruierten Merkmalsvektorsignal RO21 des zweiten Hindernisobjekts HO2 für den ersten Sensor S1 und aus allen weiteren rekonstruierten Merkmalsvektorsignalen RO31 bis ROp1 für den ersten Sensor S1 bis zum rekonstruierten Merkmalsvektorsignal ROp1 des p-ten Hindernisobjekts HOp für den ersten Sensor S1.

Das zweite rekonstruierte Merkmalsvektorsignal EV2 ist die Summe aus dem rekonstruierten Merkmalsvektorsignal RO12 des ersten Hindernisobjekts HO1 für den zweiten Sensor S2 und dem rekonstruierten Merkmalsvektorsignal RO22 des zweiten Hindernisobjekts HO2 für den zweiten Sensor S2 und aus allen weiteren rekonstruierten Merkmalsvektorsignalen RO32 bis ROp2 für den zweiten Sensor S2 bis zum rekonstruierten Merkmalsvektorsignal Op2 des p-ten Hindernisobjekts HOp für den zweiten Sensor S2.

Das dritte rekonstruierte Merkmalsvektorsignal EV3 ist die Summe aus dem rekonstruierten Merkmalsvektorsignal RO13 des ersten Hindernisobjekts HO1 für den dritten Sensor S3 und dem rekonstruierten Merkmalsvektorsignal RO23 des zweiten Hindernisobjekts HO2 für den dritten Sensor S3 und aus allen weiteren rekonstruierten Merkmalsvektorsignalen RO33 bis ROp3 für den dritten Sensor S3 bis zum rekonstruierten Merkmalsvektorsignal ROp3 des p-ten Hindernisobjekts HOp für den dritten Sensor S3.

Das m-te rekonstruierte Merkmalsvektorsignal EVm ist die Summe aus dem rekonstruierten Merkmalsvektorsignal RO1m des ersten Hindernisobjekts HO1 für den m-ten Sensor Sm und dem rekonstruierten Merkmalsvektorsignal RO2m des zweiten Hindernisobjekts HO2 für den m-ten Sensor Sm und aus allen weiteren rekonstruierten Merkmalsvektorsignalen RO3m bis ROpm für den m-ten Sensor Sm bis zum rekonstruierten Merkmalsvektorsignal ROpm des p-ten Hindernisobjekts HOp für den m-ten Sensor Sm.

Am Ende einer Erkennungsperiode, also nach Durchlauf von p Zyklen, enthalten die Hindernisobjektspeicher SP1 bis SPp rekonstruierte Merkmalsvektorsignale ROS1 bis ROSp für das erste bis p-te Hindernisobjekt HO1,HO2,...,HOp.

Die Hindernisobjektspeicher SP1 bis SPp können ausgelesen werden, um die real existierenden Hindernisobjekte z.B. in einer Umfeldkarte anzuzeigen. Der nachfolgend beschriebenen Modellteil bildet auf Basis dieser Inhalte der Hindernisobjektspeicher SP1 bis SPp eine Prognose der Veränderung der Hindernisobjekte für den Zeitraum bis zum nächsten Zeitpunkt, zu dem Ergebnisse (Hindernisobjekt-Veränderung) auf Grund von Messungen vorliegen.

Die Hindernisobjektspeicher SP1 bis SPp werden von einer Speichersteuerung SPC angesteuert. Die Speichersteuerung SPC setzt die Ausgabevektoren, d.h. die rekonstruierten Merkmalsvektorsignale ROS1 bis ROSp, zu bestimmten Zeitpunkten der im folgenden Teil beschriebenen Prognose zu Null.

Im Folgenden wird anhand von Fig. 28 nun der Modellteil beschrieben.

Der Modellteil prognostiziert nun auf Grund des aktuellen Erkennungsergebnisses und vorausgegangener Erkennungsergebnisse die weitere Entwicklung der rekonstruierten Merkmalsvektorsignale ROS1 bis ROSp des ersten bis p-ten Hindernisobjekts HO1,HO2,...,HOp.

Hierbei setzt die Speichersteuerung SPC die Ausgabevektoren, d.h. die rekonstruierten Merkmalsvektorsignale ROS1 bis ROSp während der Prognose zu Null, so dass der Modellteil unabhängig von dem Realteil arbeitet. Erst, wenn nach einem erneut gesendeten Ultraschallpuls neue Messwerte und somit neue rekonstruierte Merkmalsvektorsignale ROS1 bis ROSp im Realteil vorliegen, stellt die Speichersteuerung SPC die Ausgabevektoren der Objektspeicher SP1 bis SPp auf diese rekonstruierten Merkmalsvektorsignale ROS1 bis ROSp um. Hierdurch bekommt der Modellteil aktualisierte Werte aus der Realität und die Prognosen können verbessert werden.

Die Prognose erfolgt in Prognoseperioden PP1,PP2,...,PPq, die jeweils in Prognosezyklen PZ1,PZ2,...,PZp, deren Anzahl gleich der Anzahl von Hindernisobjekten HO1,HO2,...,HOp ist, unterteilt sind. Zur besseren Verdeutlichung ist dies in Fig. 28 dargestellt (s. Beschreibung von Fig. 28)

Ein Oszillator OSC erzeugt einen Zeitbasisvektor TBV (beides in der Zeichnung nicht dargestellt). Der Zeitbasisvektor TBV wird sowohl an das neuronale Gesamthindernisobjekterkennungsnetz ANN0 des Realteils und die neuronalen Einzelrekonstruktionsnetze NN1 bis NNp des Realteils als auch an ein Gesamtprognosenetz DANN0 und an mehrere Einzelprognosenetze MNN1,...,MNNp übergeben. Der Zeitbasisvektor TBV ermöglicht eine zeitliche Taktung und Fortschreibung der Prognose.

Das neuronale Gesamtprognosenetz DANN0 ist genauso parametrisiert wie das neuronale Gesamthindernisobjekterkennungsnetz ANN0. Es dient zusammen mit weiteren künstlichen neuronalen Einzelprognosenetzen MNN1,...,MNNp der Vorhersage der Veränderung der Hindernisobjekte HO1,HO2,...,HOp für die Dauer des Prognoseintervalls. Die Veränderung eines Hindernisobjekts wird nachfolgend als virtuelles oder als virtuell erkanntes Hindernisobjekt bezeichnet.

Von dem rekonstruierten Merkmalsvektorsignal ROS1 des ersten Hindernisobjekts HO1 wird an einem ersten Summierer MS1 des Modellteils ein zweites rekonstruiertes Merkmalsvektorsignal RV12 des ersten virtuellen Hindernisobjekts HO1 abgezogen. Das Ergebnis der Subtraktion ist ein Eingabewert in Form des ersten Prognosemerkmalsvektorsignals PV1 für das neuronale Gesamtprognosenetz DANN0. Zu Beginn einer Prognoseperiode hat das zweite rekonstruierte Merkmalsvektorsignal RV12 des ersten virtuellen Hindernisobjekts HO1 den Wert 0 und wird gegebenenfalls zu diesem Zeitpunkt auf Null zurückgesetzt.

Von dem rekonstruierten Merkmalsvektorsignal ROS2 des zweiten Hindernisobjekts HO2 wird an einem zweiten Summierer MS2 des Modellteils ein zweites rekonstruiertes Merkmalsvektorsignal RV22 des zweiten virtuellen Hindernisobjekts HO2 abgezogen. Das Ergebnis der Subtraktion ist ein Eingabewert in Form des zweiten Prognosemerkmalsvektorsignals PV2 für das neuronale Gesamtprognosenetz DANN0. Zu Beginn einer Prognoseperiode hat das zweite rekonstruierte Merkmalsvektorsignal RV22 des zweiten virtuellen Hindernisobjekts HO2 den Wert 0 und wird gegebenenfalls zu diesem Zeitpunkt auf Null zurückgesetzt.

Analog wird mit dem Merkmalsvektorsignal des dritten Hindernisobjekts HO3 bis einschließlich dem Merkmalsvektorsignal des (p-1)-ten Hindernisobjekts HOp verfahren. Dies ist jedoch aus Übersichtsgründen in der Fig. 27 nicht dargestellt.

Schließlich wird von dem rekonstruierten und gespeicherten Merkmalsvektorsignal ROSp des p-ten Hindernisobjekts HOp an einem p-ten Summierer MSp des Modellteils ein zweites rekonstruiertes Merkmalsvektorsignal RVp2 des p-ten virtuellen Hindernisobjekts HOp abgezogen. Das Ergebnis der Subtraktion ist ein Eingabewert in Form des p-ten Prognosemerkmalsvektorsignals PVp für das neuronale Gesamtprognosenetz DANN0. Zu Beginn einer Prognoseperiode hat das zweite rekonstruierte Merkmalsvektorsignal RVp2 des p-ten virtuellen Hindernisobjekts HOp den Wert 0 und wird gegebenenfalls zu diesem Zeitpunkt auf Null zurückgesetzt.

Zusätzlich zu den Prognosemerkmalsvektorsignalen PV1 bis PVp erhält das neuronale Gesamtprognosenetz DANNO als Eingabevektoren die rekonstruierten Merkmalsvektorsignale ROS1 bis ROSp aller p Hindernisobjekte HOp. Das neuronale Gesamtprognosenetz DANNO verfügt somit über Informationen der Prognose und der Realität.

Das neuronale Gesamtprognosenetz DANNO gibt ein erstes virtuell erkanntes Hindernisobjekt VEO1 und ein zweites virtuell erkanntes Hindernisobjekt VEO2 und so weiter bis hin zu einem p-ten virtuell erkannten Hindernisobjekt VEOp aus. Hierbei handelt es sich um vektorielle Signale, die die erkannten Hindernisobjekte im Zeit- und/oder Raummultiplex beschreiben. Die Werte dieser Signale können beispielsweise die Objektart, die Objektposition, die Objektorientierung und andere Objekteigenschaften repräsentieren.

Zu Beginn sind keine Hindernisobjekte bekannt.

Im Folgenden werden der erste, der zweite und der p-te Prognosezyklus PZ1,PZ2,...,PZp kurz beschrieben. Der dritte bis (p-1)-te Prognosezyklus läuft analog ab, was jedoch aus Gründen der Übersichtlichkeit in der Fig. 27 nicht dargestellt ist.

Erster Prognosezyklus:

Im ersten Prognosezyklus PZ1 erkennt das neuronale Gesamtprognosenetz DANNO das erste virtuell erkannte Hindernisobjekt VEO1. Das erste virtuell erkannte Hindernisobjekt VE01 wird in einem ersten Zwischenspeicher VM1 des Modellteils gespeichert. Ein erstes künstliches neuronales Einzelprognosenetz MNN1 des Modellteils rekonstruiert aus dem ersten virtuell erkannten Hindernisobjekt VEO1 ein erstes rekonstruiertes Merkmalsvektorsignal RV11 des ersten virtuellen Hindernisobjekts. Das erste rekonstruierte Merkmalsvektorsignal RV11 des ersten virtuellen Hindernisobjekts wird in einem ersten Prognosespeicher SPRV1 gespeichert. Im ersten Prognosezyklus der nächsten Prognoseperiode wird dieses gespeicherte erste rekonstruierte Merkmalsvektorsignal RV11 des ersten virtuellen Hindernisobjekts an einem Summierer von dem aktuell berechneten ersten rekonstruierten Merkmalsvektorsignal RV11 des ersten virtuellen Hindernisobjekts abgezogen. Das Ergebnis ist ein zweites rekonstruiertes Merkmalsvektorsignal RV12 des ersten virtuellen Hindernisobjekts. Dieses repräsentiert somit die Abweichung zur vorangegangen Prognoseperiode. Das aktuelle erste rekonstruierte Merkmalsvektorsignal RV11 des ersten virtuellen Hindernisobjekts überschreibt dann den Inhalt im ersten Prognosespeicher SPRV1. Hierdurch werden zeitliche Änderungen, wie sie z.B. zur Berechnung von Geschwindigkeiten notwendig sind, in der Prognose berücksichtigt. Das zweite rekonstruierte Merkmalsvektorsignal RV12 des ersten virtuellen Hindernisobjekts wird dann, wie beschrieben, von dem ersten rekonstruierten und im Hindernisobjektspeicher SP1 gespeicherten Merkmalsvektorsignal ROS1 des ersten Hindernisobjekts abgezogen, wodurch das erste Prognosemerkmalsvektorsignal PV1 erhalten wird. Damit ist der erste Prognosezyklus beendet.

Zweiter Prognosezyklus:

Im zweiten Prognosezyklus PZ2 erkennt das neuronale Gesamtprognosenetz DANNO das zweite virtuell erkannte Hindernisobjekt VEO2. Das zweite virtuell erkannte Hindernisobjekt VEO2 wird in einem zweiten Zwischenspeicher VM2 des Modellteils gespeichert. Ein zweites künstliches neuronales Einzelprognosenetz MNN2 des Modellteils rekonstruiert aus dem zweiten virtuell erkannten Hindernisobjekt VEO2 ein erstes rekonstruiertes Merkmalsvektorsignal RV21 des zweiten virtuellen Hindernisobjekts. Das erste rekonstruierte Merkmalsvektorsignal RV21 des zweiten virtuellen Hindernisobjekts wird in einem zweiten Prognosespeicher SPRV2 gespeichert. Im zweiten Prognosezyklus der nächsten Prognoseperiode wird dieses gespeicherte erste rekonstruierte Merkmalsvektorsignal RV21 des zweiten virtuellen Hindernisobjekts an einem Summierer von dem aktuell berechneten ersten rekonstruierten Merkmalsvektorsignal RV21 des zweiten virtuellen Hindernisobjekts abgezogen. Das Ergebnis ist ein zweites rekonstruiertes Merkmalsvektorsignal RV22 des zweiten virtuellen Hindernisobjekts. Dieses repräsentiert somit die Abweichung zur vorangegangen Prognoseperiode. Das aktuelle erste rekonstruierte Merkmalsvektorsignal RV21 des zweiten virtuellen Hindernisobjekts überschreibt dann den Inhalt im zweiten Prognosespeicher SPRV2. Hierdurch werden zeitliche Änderungen, wie sie z.B. zur Berechnung von Geschwindigkeiten notwendig sind, in der Prognose berücksichtigt. Das zweite rekonstruierte Merkmalsvektorsignal RV22 des zweiten virtuellen Hindernisobjekts wird dann, wie beschrieben, von dem ersten rekonstruierten und im Hindernisobjektspeicher SP1 gespeicherten Merkmalsvektorsignal ROS2 des zweiten Hindernisobjekts abgezogen, wodurch das zweite Prognosemerkmalsvektorsignal PV2 erhalten wird. Damit ist der zweite Prognosezyklus beendet.

p-ter Prognosezyklus:

Im p-ten Prognosezyklus PZp erkennt das Gesamtprognosenetz DANNO das p-te virtuell erkannte Hindernisobjekt VEOo. Das p-te virtuell erkannte Hindernisobjekt VEOp wird in einem p-ten Zwischenspeicher VMp des Modellteils gespeichert. Ein p-tes künstliches neuronales Einzelprognosenetz MNNp des Modellteils rekonstruiert aus dem p-ten virtuell erkannten Hindernisobjekt VEOp ein erstes rekonstruiertes Merkmalsvektorsignal RVp1 des p-ten virtuellen Hindernisobjekts. Das erste rekonstruierte Merkmalsvektorsignal RVp1 des p-ten virtuellen Hindernisobjekts wird in einem p-ten Prognosespeicher SPRVp gespeichert. Im p-ten Prognosezyklus der nächsten Prognoseperiode wird dieses gespeicherte erste rekonstruierte Merkmalsvektorsignal RVp1 des p-ten virtuellen Hindernisobjekts an einem Summierer von dem aktuell berechneten ersten rekonstruierten Merkmalsvektorsignal RVp1 des p-ten virtuellen Hindernisobjekts abgezogen. Das Ergebnis ist ein zweites rekonstruiertes Merkmalsvektorsignal RVp2 des p-ten virtuellen Hindernisobjekts. Dieses repräsentiert somit die Abweichung zur vorangegangenen Prognoseperiode. Das aktuelle erste rekonstruierte Merkmalsvektorsignal RVp1 des p-ten virtuellen Hindernisobjekts überschreibt dann den Inhalt im p-ten Prognosespeicher SPRVp. Hierdurch werden zeitliche Änderungen, wie sie z.B. zur Berechnung von Geschwindigkeiten notwendig sind, in der Prognose berücksichtigt. Das zweite rekonstruierte Merkmalsvektorsignal RVp2 des p-ten virtuellen Hindernisobjekts wird dann, wie beschrieben, von dem ersten rekonstruierten und im Hindernisobjektspeicher SP1 gespeicherten Merkmalsvektorsignal ROSp des p-ten Hindernisobjekts abgezogen, wodurch das p-te Prognosemerkmalsvektorsignal PVp erhalten wird. Damit ist der p-te Prognosezyklus beendet.

Ein künstliches neuronales Realitätsnachbildungsnetz MNN0 des Modellteils rekonstruiert aus dem ersten virtuell erkannten Hindernisobjekt VEO1, dem zweiten virtuell erkannten Hindernisobjekt VEO2 und allen weiteren virtuell erkannten Hindernisobjekten VEO3 bis VEOp-1 bis einschließlich dem p-ten virtuell erkannten Hindernisobjekt VEOp ein virtuell gebildetes Realitätsnachbildungsmerkmalsvektorsignal VRV, das beispielsweise eine mehrdimensionale Umfeldkarte sein kann.

Das Realitätsnachbildungsmerkmalsvektorsignal VRV und damit die Speicher VM1,VM2,...,VMp können jeder Zeit ausgelesen werden. Sie enthalten auswertbare Informationen über die räumliche Position erkannter Objekte zu Zeitpunkten, die zwischen ausgesandten Ultraschallpulsen liegen.

Anhand von Fig. 28 wird nachfolgend auf die zeitliche Synchronisation der einzelnen Schritte bei der Prognose der Veränderungen der detektierten Hindernisobjekte eingegangen. Im oberen Teil der Fig. 28 ist auf der t-Achse dargestellt, dass Mess- oder Erkennungsintervalle ΔT aufeinanderfolgen. Pro Intervall ΔT wird im Falle der Anwendung der Erfindung bei einem Ultraschallmesssystem ein Ultraschallsendesignal erzeugt, woraufhin dann der die Funktion sowohl des Sendens als auch des Empfangens übernehmende Ultraschall-Transducer ausschwingt. An diese Ausschwingphase schließt sich dann die Empfangsphase pro Intervall ΔT an.

Ein Prognoseintervall kann in erster Näherung dahingehend aufgefasst werden, dass es jeweils die gleiche Dauer wie die zuvor genannten Intervalle ΔT aufweist. Das Prognoseintervall EP ist unterteilt in einzelne Prognoseperioden PP1,PP2,...,PPq, mit q als natürliche Zahl größer 2. Innerhalb jeder Prognoseperiode existieren Prognosezyklen PZ1,PZ2,...,PZp, die gleich der Anzahl der erkannten Hindernisobjekte sind. Die Prognose der Veränderung von erkannten Hindernisobjekten kann frühestens mit dem zweiten Intervall ΔT beginnen. Da die Prognose auf "Erfahrungen aus der Vergangenheit" setzt, ist es zweckmäßig, erst zu einem späteren Zeitpunkt, allerdings auch nicht zu spät, mit der Prognose zu beginnen. Das ist letztendlich applikationsabhängig.

## BEZUGSZEICHENLISTE

**(für die Fign. 1 bis 20)**

| | |
|---|---|
| α | Aussenden des Ultraschall-Bursts |
| β | Empfangen des an einem Hindernisobjekt reflektierten Ultraschall-Bursts und Umwandlung in ein elektrisches Empfangssignal |
| γ | Kompression des elektrischen Empfangssignals |
| γa | Abtastung des elektrischen Eingangssignals und Bildung eines abgetasteten elektrischen Eingangssignals, wobei bevorzugt jedem Abtastwert des elektrischen Eingangssignals ein Zeitstempel zugeordnet werden kann. |
| γb | Ermittlung von mehreren Spektralwerten z.B. durch Optimalfilter (englisch Matched Filter) für prototypische Signalobjektklassen. Diese mehreren Spektralwerte bilden zusammen einen Feature-Vektor. Diese Bildung findet bevorzugt fortlaufend statt, so dass sich ein Strom von Feature-Vektor-Werten ergibt. Jedem Feature-Vektor-Wert kann bevorzugt wieder ein Zeitstempel zugeordnet werden. |
| γc | optionale, aber bevorzugt durchgeführte Normierung der Spektralkoeffizienten des jeweiligen Feature-Vektors eines Zeitstempelwerts vor der Korrelation mit den prototypischen Signalobjektklassen in Form von vorgegebenen prototypischen Feature-Vektor-Werten einer Prototypen-Bibliothek |
| γd | Abstandsbestimmung zwischen dem aktuellen Feature-Vektor-Wert und den Werten der prototypischen Signalobjektklassen in Form von vorgegebenen prototypischen Feature-Vektor-Werten einer Prototypen-Bibliothek |
| γe | Selektion der ähnlichsten prototypischen Signalobjektklasse in Form eines vorgegebenen prototypischen Feature-Vektor-Wertes einer Prototypen-Bibliothek mit bevorzugt minimalem Abstand zum aktuellen Feature-Vektor und Übernahme des Symbols dieser Signalobjektklasse als erkanntes Signalobjekt zusammen mit dem Zeitstempelwert als komprimierte Daten. Gegebenenfalls können weitere Daten, insbesondere Signalobjektparameter, wie z.B. dessen Amplitude mit als komprimierte Daten übernommen werden. Diese komprimierten Daten bilden dann das komprimierte Empfangssignal. |
| δ | Übertragung des komprimierten elektrischen Empfangssignals an das Rechnersystem |
| 1 | Hüllkurve des empfangenen Ultraschallsignals, hier auch als Ultraschall-Echo-Signal bezeichnet |
| 2 | Ausgangssignal (übermittelte Information) einer IO-Schnittstelle gemäß dem Stand der Technik |
| 3 | übermittelte Information einer LIN-Schnittstelle gemäß dem Stand der Technik |
| 4 | erster Schnittpunkt des Ultraschall-Echo-Signals 1 mit dem Schwellwertsignal SW in Abwärtsrichtung |
| 5 | erster Schnittpunkt des Ultraschall-Echo-Signals 1 mit des Schwellwertsignals SW in Aufwärtsrichtung |
| 6 | erstes Maximum des Ultraschall-Echo-Signals 1 oberhalb des Schwellwertsignals SW |
| 7 | zweiter Schnittpunkt des Ultraschall-Echo-Signals 1 mit dem Schwellwertsignals SW in Abwärtsrichtung |

| | |
|---|---|
| 8 | zweiter Schnittpunkt des Ultraschall-Echo-Signals 1 mit dem Schwellwertsignal SW in Aufwärtsrichtung |
| 9 | zweites Maximum des Ultraschall-Echo-Signals 1 oberhalb des Schwellwertsignals SW |
| 10 | erstes Minimum des Ultraschall-Echo-Signals 1 oberhalb des Schwellwertsignals SW |
| 11 | drittes Maximum des Ultraschall-Echo-Signals 1 oberhalb des Schwellwertsignals SW |
| 12 | dritter Schnittpunkt des Ultraschall-Echo-Signals 1 mit dem Schwellwertsignal SW in Abwärtsrichtung |
| 13 | dritter Schnittpunkt des Ultraschall-Echo-Signals 1 mit dem Schwellwertsignal SW in Aufwärtsrichtung |
| 14 | viertes Maximum des Ultraschall-Echo-Signals 1 oberhalb des Schwellwertsignals SW |
| 15 | vierter Schnittpunkt des Ultraschall-Echo-Signals 1 mit dem Schwellwertsignal SW in Abwärtsrichtung |
| 16 | vierter Schnittpunkt des Ultraschall-Echo-Signals 1 mit dem Schwellwertsignal SW in Aufwärtsrichtung |
| 17 | fünftes Maximum des Ultraschall-Echo-Signals 1 oberhalb des Schwellwertsignals SW |
| 18 | fünfter Schnittpunkt des Ultraschall-Echo-Signals 1 mit dem Schwellwertsignal SW in Abwärtsrichtung |
| 19 | fünfter Schnittpunkt des Ultraschall-Echo-Signal 1 mit dem Schwellwertsignal SW in Aufwärtsrichtung |
| 20 | sechstes Maximum des Ultraschall-Echo-Signals 1 oberhalb des Schwellwertsignals SW |
| 21 | sechster Schnittpunkt des Ultraschall-Echo-Signals 1 mit dem Schwellwertsignal SW in Abwärtsrichtung |
| 22 | sechster Schnittpunkt des Ultraschall-Echo-Signals 1 mit dem Schwellwertsignal SW in Aufwärtsrichtung |
| 23 | siebtes Maximum des Ultraschall-Echo-Signals 1 oberhalb des Schwellwertsignals SW |
| 24 | siebter Schnittpunkt des Ultraschall-Echo-Signals 1 mit dem Schwellwertsignal SW in Abwärtsrichtung |
| 25 | Hüllkurve während des Ultraschall-Bursts |
| 26 | Übertragung der Daten des ersten Schnittpunkts 4 des Ultraschall-Echo-Signals 1 mit dem Schwellwertsignal SW in Abwärtsrichtung über den vorzugsweise bidirektionalen Datenbus |
| 27 | Übertragung der Daten des ersten Schnittpunkts 5 des Ultraschall-Echo-Signals 1 mit dem Schwellwertsignal SW in Aufwärtsrichtung über den vorzugsweise bidirektionalen Datenbus |
| 28 | Übertragung der Daten des ersten Maximums 6 des Ultraschall-Echo-Signals 1 oberhalb des Schwellwertsignals SW über den vorzugsweise bidirektionalen Datenbus |
| 29 | Übertragung der Daten des zweiten Schnittpunkts 7 des Ultraschall-Echo-Signals 1 mit dem Schwellwertsignal SW in Abwärtsrichtung über den vorzugsweise bidirektionalen Datenbus |
| 30 | Übertragung der Daten des zweiten Schnittpunkts 8 des Ultraschall-Echo-Signals 1 mit dem Schwellwertsignal SW in Aufwärtsrichtung über den vorzugsweise bidirektionalen Datenbus |
| 31 | Übertragung der Daten des zweiten Maximums 9 des Ultraschall-Echo-Signals 1 oberhalb des Schwellwertsignals SW und der Daten des ersten Minimums 10 des Ultraschall-Echo-Signals 1 oberhalb der Schwellwertsignal SW über den vorzugsweise bidirektionalen Datenbus |
| 32 | Übertragung der Daten des dritten Maximums 11 des Ultraschall-Echo-Signals 1 oberhalb des Schwellwertsignals SW über den vorzugsweise bidirektionalen Datenbus |
| 34 | Übertragung der Daten des dritten Schnittpunkts 12 des Ultraschall-Echo-Signals 1 mit dem Schwellwertsignal SW in Abwärtsrichtung über den vorzugsweise bidirektionalen Datenbus |
| 35 | Übertragung der Daten des dritten Schnittpunkts 13 des Ultraschall-Echo-Signals 1 mit dem Schwellwertsignal SW in Aufwärtsrichtung über den vorzugsweise bidirektionalen Datenbus |
| 36 | Übertragung der Daten des vierten Maximums 14 des Ultraschall-Echo-Signals 1 oberhalb des Schwellwertsignals SW über den vorzugsweise bidirektionalen Datenbus |
| 37 | Übertragung der Daten des vierten Schnittpunkts 15 des Ultraschall-Echo-Signals 1 mit dem Schwellwertsignal SW in Abwärtsrichtung über den vorzugsweise bidirektionalen Datenbus |
| 38 | Übertragung der Daten des vierten Schnittpunkts 16 des Ultraschall-Echo-Signals 1 mit dem Schwellwertsignal SW in Aufwärtsrichtung über den vorzugsweise bidirektionalen Datenbus |
| 39 | Übertragung der Daten des fünften Maximums 17 des Ultraschall-Echo-Signal 1 oberhalb des Schwellwertsignals SW über den vorzugsweise bidirektionalen Datenbus |
| 40 | Übertragung der Daten des fünften Schnittpunkt 18 des Ultraschall-Echo-Signal 1 mit dem Schwellwertsignal SW in Abwärtsrichtung über den vorzugsweise bidirektionalen Datenbus |
| 41 | Übertragung der Daten des fünften Schnittpunkts 19 des Ultraschall-Echo-Signal 1 mit dem Schwellwertsignal SW in Aufwärtsrichtung über den vorzugsweise bidirektionalen Datenbus |
| 42 | Übertragung der Daten des sechsten Schnittpunkts 21 des Ultraschall-Echo-Signal 1 mit dem Schwellwertsignal SW in Abwärtsrichtung über den vorzugsweise bidirektionalen Datenbus |
| 43 | Übertragung der Daten der empfangenen Echos auf dem LIN-Bus nach dem Stand der Technik nach Ende des Empfangs |
| 44 | Übertragung von Daten auf dem LIN-Bus nach dem Stand der Technik vor Aussendung des Ultraschall-Bursts |
| 45 | Übertragung von Daten über die IO-Schnittstelle nach dem Stand der Technik vor Aussendung des Ultraschall-Bursts |
| 46 | Wirkung des Ultraschall-Sende-bursts auf das Ausgangssignal der IO-Schnittstelle nach dem Stand der Technik |
| 47 | Signal des ersten Echos 5, 6, 7 auf der IO-Schnittstelle gem. dem Stand der Technik |

48 Signal des zweiten Echos 8, 9, 10, 11, 12 auf der IO-Schnittstelle gem. dem Stand der Technik

49 Signal des dritten und vierten Echos 13, 14, 15 auf der IO-Schnittstelle gem. dem Stand der Technik

50 Signal des fünften Echos 16, 17, 18 auf der IO-Schnittstelle gem. dem Stand der Technik

51 Signal des sechsten Echos 19, 20, 21 auf der IO-Schnittstelle gem. dem Stand der Technik

52 Signal des siebten Echos 22, 23, 24 auf der IO-Schnittstelle gem. dem Stand der Technik

53 Startbefehl von dem Rechnersystem an den Sensor über den Datenbus

54 periodische automatische Datenübertragung zwischen Sensor und Rechnersystem vorzugsweise nach DSI3-Standard

55 Diagnose-Bits nach dem Messzyklus

56 Ende des Aussendens des Ultraschall-Bursts (Ende des Sende-Bursts). Bevorzugt fällt das Ende des Ultraschall-Bursts mit dem Punkt 4 zusammen

57 Anfang des Aussendens des Ultraschall-Bursts (Anfang des Sende-Bursts)

58 Ende der Datenübertragung

100 Ultraschallwandler, der beispielsweise auch einen separaten Ultraschallsender und einen separaten Ultraschallempfänger umfassen kann

101 physikalische Schnittstelle zum Antreiben des Ultraschallwandlers 100 und zum Aufbereiten des vom Ultraschallwandler 100 empfangenen Ultraschallwandlersignals 102 zum Ultraschall-Echo-Signal 1 für die anschließende Signalobjektklassifikation

102 Ultraschallwandlersignal

111 Feature-Vektor-Extraktor 111

112 Abstandsermittler (oder Klassifikator)

113 Viterbi-Schätzer

115 Prototypendatenbank

116 Signalobjektdatenbank

122 erkannte Signalobjekte mit Signalobjektparametern

123 Zwischenparametersignale

125 Signifikanzsteigerer

126 LDA-Matrix

138 Feature-Vektor-Signal oder Merkmalsvektorsignal

141 Schwerpunktkoordinate eines ersten prototypischen Signalgrundobjekts der Prototypendatenban 115

142 Schwerpunktkoordinate eines zweiten prototypischen Signalgrundobjekts der Prototypendatenban 115

143 Schwerpunktkoordinate eines dritten prototypischen Signalgrundobjekts der Prototypendatenban 115

144 Schwerpunktkoordinate eines fierten prototypischen Signalgrundobjekts der Prototypendatenban 115

145 aktueller Feature-Vektor-Signalwert des Feature-Vektor-Signals 138 in dem Überlappungsbereich der Streubereiche der beiden Signalgrundobjekte der Prototypendatenban 115 mit den Schwerpunktkoordinaten 142 und 143

146 Feature-Vektor-Signalwert, der zu weit von den Schwerpunktkoordinaten 141,142,143,144 des Schwerpunkts irgendeines Signalgrundobjektprototypen der Prototypendatenbank 115 entfernt liegt

147 Streubereich (Schwellwertellipsoid) 147 um den Schwerpunkt 141 eines einzigen Signalgrundobjektprototyps 141

148 aktueller Feature-Vektor-Signalwert, der im Streubereich (Schwellwertellipsoid) 147 um den Schwerpunkt 141 eines einzigen Signalgrundobjektprototyps 141 liegt und der damit sicher durch den Abstandsermittler 112 erkannt und als erkanntes Signalgrundobjekt 121 an den Viterbi-Schätzer 113 weitergegeben werden kann

150 Schätzer mit einem HMM-Modell

151 Schätzer mit einem neuronalen Netzwerkmodell

160 erstes Signalobjekt in Dreiecksform mit Chirp-Down A und Datenübertragungspriorität 1

161 zweites Signalobjekt in Dreiecksform mit Chirp-Up B und Datenübertragungspriorität 2

162 drittes Signalobjekt in Doppelspitzenform mit Chirp-Up B und Datenübertragungspriorität 3 (Curbstone Profil)

163 viertes Signalobjekt in Dreiecksform mit Chirp-Down A und Datenübertragungspriorität 4

164 fünftes Signalobjekt in Dreiecksform mit Chirp-Down A und Datenübertragungspriorität 5

165 sechstes Signalobjekt in Dreiecksform mit Chirp-Up B und Datenübertragungspriorität 6

166 mit Hilfe von Signalobjekten übertragenes und dekomprimiertes Echo-Signal

600 Rekonstruierer

601 Speicher für das Ultra-Schall-Echo-Signal 1. Der Speicher umfasst bevorzugt die Daten des Echos eines Ultraschallpulses oder -bursts

602 Subtrahierer für die Subtraktion der durch den Rekonstruierer 600 berechneten rekonstruierten Abtastwerte des Ultraschall-Echo-Signals, die das rekonstruierte Ultraschall-Echo-Signal-Modell 610 bilden, von den im Speicher 601 gespeicherten Abtastwerten des Ultraschall-Echo-Signals 1, um das Restsignal 660 zu bilden, das als alternatives Eingangssignal für den Feature-Vektor-Extraktor 111 an Stelle des Ultraschall-Echo-Signals 1 dient

603 Rekonstruktionsspeicher für das rekonstruierte Ultraschall-Echo-Signal-Modell 610. Der Rekonstruktionsspeicher wird in der Regel als Teil des Rekonstruierers 600 ausgeführt

610     rekonstruiertes Ultraschall-Echo-Signal-Modell

660     Restsignal. Das Restsignal stellt den Kompressionsfehler dar. Je mehr Objekte erkannt werden, desto geringer wird der Kompressionsfehler. Die Kompression wird in der Regel abgebrochen, wenn alle Abtastwerte des Restsignals 660 unterhalb einer Schwellwertkurve für die Kompression liegen. Die entsprechende Abbruchsignalisierung ist in den Figuren nicht eingezeichnet.

a       Übertragene Informationen für die Übertragung der empfangenen Ultraschallechos mittels einer IO-Schnittstelle aus dem Stand der Technik

A       erkanntes Signalobjekt mit Chirp-Down

a.u.    "arbritrary units" = frei gewählte Einheiten

B       erkanntes Signalobjekt mir Chip-Up

b       Übertragene Informationen für die Übertragung der empfangenen Ultraschallechos mittels einer LIN-Schnittstelle aus dem Stand der Technik

c       Übertragene Informationen für die Übertragung der empfangenen Ultraschallechos mittels des vorgeschlagenen Verfahrens und der vorgeschlagenen Vorrichtung mit Hüllkurve (Ultraschall-Echo-Signal 1) zum Vergleich

d       Übertragene Informationen für die Übertragung der empfangenen Ultraschallechos mittels des vorgeschlagenen Verfahrens und der vorgeschlagenen Vorrichtung ohne Hüllkurve

e       schematische Signalformen bei der Übertragung der empfangenen Echo-Informationen mittels einer IO-Schnittstelle aus dem Stand der Technik

En      Amplitude der Hüllkurve (Ultraschall-Echo-Signal 1) des empfangenen Ultraschallsignals

f       schematische Signalformen bei der Übertragung der empfangenen Echo-Informationen mittels einer LIN-Schnittstelle aus dem Stand der Technik

g       schematische Signalformen bei der Übertragung der empfangenen Echo-Informationen mittels einer bidirektionalen Datenschnittstelle

SA      Speicheradresse im Speicher 601 bzw. Rekonstruktionsspeicher 603. Diese ist typischerweise mit einer Zeit seit dem Aussenden eines Ultraschallpulses und/oder Ultraschall-Bursts korreliert.

SB      Sende-Burst

SW      Schwelle

t       Zeit

$T_E$     Empfangszeit. Die Empfangszeit beginnt typischerweise mit dem Ende 56 des Aussendens des ultraschall-Bursts. Es ist möglich, mit dem Empfang bereits zuvor zu beginnen. Dies kann aber zu Problemen führen die gegebenenfalls zusätzliche Maßnahmen erfordern.

## BEZUGSZEICHENLISTE

**(für die Fign. 21 bis 25)**

A0      nullter Summierer

A1      erster Summierer

A2      zweiter Summierer

An      n-ter Summierer

ANN0    neuronales Gesamthinderniserkennungsnetz

DANN0   neuronales Gesamtprognosenetz

DB      Datenbus

DR      Treiber

E1      erstes übertragenes Signalobjekt

E2      zweites übertragenes Signalobjekt

EC1     erstes korrigiertes Merkmalsvektorsignal

EC2     zweites korrigiertes Merkmalsvektorsignal

EC3     drittes korrigiertes Merkmalsvektorsignal

ECm     m-tes korrigiertes Merkmalsvektorsignal

ECU     Datenverarbeitungseinheit

EF1     rekonstruiertes Merkmalsvektorsignal des ersten Sensors

EF2     rekonstruiertes Merkmalsvektorsignal des zweiten Sensors

EF3     rekonstruiertes Merkmalsvektorsignal des dritten Sensors

EFm     rekonstruiertes Merkmalsvektorsignal des m-ten Sensors

| EM1 | erster Zwischenspeicher der Datenverarbeitungseinheit |
| EM2 | zweiter Zwischenspeicher der Datenverarbeitungseinheit |
| EMn | n-ter Zwischenspeicher der Datenverarbeitungseinheit |
| En | n-tes übertragenes Signalobjekt |
| ENN1 | erstes neuronales Einzeldekompressionsnetz |
| ENN2 | zweites neuronales Einzeldekompressionsnetz |
| ENNn | n-tes neuronales Einzeldekompressionsnetz |
| EO1 | erster Zwischenspeicher des Realteils |
| EO2 | zweiter Zwischenspeicher des Realteils |
| EOp | p-ter Zwischenspeicher des Realteils |
| EP | Erkennungsperiode/Prognoseintervall |
| EPS1 | erster Messzeitpunkt |
| EPS2 | zweiter Messzeitpunkt |
| ER | rekonstruiertes Merkmalsvektorsignal |
| ER1 | erstes rekonstruiertes Merkmalsvektorsignal |
| ER2 | zweites rekonstruiertes Merkmalsvektorsignal |
| ERn-1 | n-1-tes rekonstruiertes Merkmalsvektorsignal |
| ERn | n-tes rekonstruiertes Merkmalsvektorsignal |
| ES1 | erster Summierer der Datenverarbeitungseinheit |
| ES2 | zweiter Summierer der Datenverarbeitungseinheit |
| ESn | n-ter Summierer der Datenverarbeitungseinheit |
| EV1 | erstes rekonstruiertes Merkmalsvektorsignal des Realteils |
| EV2 | zweites rekonstruiertes Merkmalsvektorsignal des Realteils |
| EV3 | drittes rekonstruiertes Merkmalsvektorsignal des Realteils |
| EVm | m-tes rekonstruierte Merkmalsvektorsignal des Realteils |
| F0 | nulltes Merkmalsvektorsignal |
| F1 | erstes Merkmalsvektorsignal |
| F2 | zweites Merkmalsvektorsignal |
| FE | Feature-Extraktion |
| IDB | interner Datenbus |
| IFE1 | inverse Feature-Extraktion |
| IFE2 | inverse Feature-Extraktion |
| IFEn-1 | inverse Feature-Extraktion |
| EFEn | inverse Feature-Extraktion |
| IM0 | nullter Zwischenspeicher |
| IM1 | erster Zwischenspeicher |
| IM2 | zweiter Zwischenspeicher |
| IMn | n-ter Zwischenspeicher |
| MNN0 | neuronales Realitätsnachbildungsnetz |
| MNN1 | erstes neuronales Einzelprognosenetz |
| MNN2 | zweites neuronales Einzelprognosenetz |
| MNNp | p-tes neuronales Einzelprognosenetz |
| MS1 | erster Summierer des Modellteils |
| MS2 | zweiter Summierer des Modellteils |
| MSp | p-ter Summierer des Modellteils |
| NN0 | neuronales Signalobjekterkennungsnetz |
| NN1 | erstes neuronales Einzelrekonstruktionsnetz |
| NN2 | zweites neuronales Einzelrekonstruktionsnetz |
| NNn | n-tes neuronales Einzelrekonstruktionsnetz |
| 01 | erstes erkanntes Signalobjekt |
| O2 | zweites erkanntes Signalobjekt |
| On | n-tes erkanntes Signalobjekt |
| PP1 | erste Prognoseperiode |
| PP2 | zweite Prognoseperiode |
| PPm | m-te Prognoseperiode |
| PV1 | erstes Prognosemerkmalsvektorsignal |
| PV2 | zweites Prognosemerkmalsvektorsignal |
| PVp | p-ter Prognosemerkmalsvektorsignal |

| PZ1 | erster Prognosezyklus |
|---|---|
| PZ2 | zweiter Prognosezyklus |
| PZn | n-ter Prognosezyklus |
| R1 | erstes rekonstruiertes Merkmalsvektorsignal |
| R2 | zweites rekonstruierter Merkmalsvektorsignal |
| RC | Erkennungssteuerung |
| REK | Rekonstruierer |
| RF | rekonstruiertes Merkmalsvektorsignal |
| Rn-1 | (n-1)-tes rekonstruiertes Merkmalsvektorsignal |
| Rn | n-tes rekonstruiertes Merkmalsvektorsignal |
| RNN1 | erstes neuronales Einzelhinderniserkennungsnetz des Realteils |
| RNN2 | zweites neuronales Einzelhinderniserkennungsnetz des Realteils |
| RNNp | p-tes neuronales Einzelhinderniserkennungsnetz des Realteils |
| RO1 | rekonstruiertes Hindernisobjekt-Merkmalsvektorsignal des ersten Objekts für alle m Sensoren |
| RO2 | rekonstruiertes Hindernisobjekt-Merkmalsvektorsignal des zweiten Objekts für alle m Sensoren |
| RO11 | rekonstruiertes Hindernisobjekt-Merkmalsvektorsignal des ersten Objekts für den ersten Sensor |
| RO12 | rekonstruiertes Hindernisobjekt-Merkmalsvektorsignal des ersten Objekts für den zweiten Sensor |
| RO13 | rekonstruiertes Hindernisobjekt-Merkmalsvektorsignal des ersten Objekts für den dritten Sensor |
| RO1m | rekonstruiertes Hindernisobjekt-Merkmalsvektorsignal des ersten Objekts für den m-ten Sensor |
| RO21 | rekonstruiertes Hindernisobjekt-Merkmalsvektorsignal des zweiten Objekts für den ersten Sensor |
| RO22 | rekonstruiertes Hindernisobjekt-Merkmalsvektorsignal des zweiten Objekts für den zweiten Sensor |
| RO23 | rekonstruiertes Hindernisobjekt-Merkmalsvektorsignal des zweiten Objekts für den dritten Sensor |
| RO2m | rekonstruiertes Hindernisobjekt-Merkmalsvektorsignal des zweiten Objekts für den m-ten Sensor |
| ROp | rekonstruiertes Hindernisobjekt-Merkmalsvektorsignal des p-ten Objekts für alle m Sensoren |
| ROp1 | rekonstruiertes Hindernisobjekt-Merkmalsvektorsignal des p-ten Objekts für den ersten Sensor |
| ROp2 | rekonstruiertes Hindernisobjekt-Merkmalsvektorsignal des p-ten Objekts für den zweiten Sensor |
| ROp3 | rekonstruiertes Hindernisobjekt-Merkmalsvektorsignal des p-ten Objekts für den dritten Sensor |
| ROpm | rekonstruiertes Hindernisobjekt-Merkmalsvektorsignal des p-ten Objekts für den m-ten Sensor |
| ROS1 | rekonstruiertes und gespeichertes Merkmalsvektorsignal des ersten Hindernisobjekts |
| ROS2 | rekonstruiertes und gespeichertes Merkmalsvektorsignal des zweiten Hindernisobjekts |
| ROSp | rekonstruiertes und gespeichertes Merkmalsvektorsignal des p-ten Hindernisobjekts |
| RS1 | erster Summierer des Realteils |
| RS2 | zweiter Summierer des Realteils |
| RS3 | dritter Summierer des Realteils |
| RSm | m-ter Summierer des Realteils |
| RSP | Rekonstruktionsspeicher |
| RV11 | rekonstruiertes Merkmalsvektorsignal des ersten virtuell erkannten Hindernisobjekts |
| RV12 | rekonstruiertes Merkmalsvektorsignal des ersten virtuell erkannten Hindernisobjekts |
| RV21 | rekonstruiertes Merkmalsvektorsignal des zweiten virtuell erkannten Hindernisobjekts |
| RV22 | rekonstruiertes Merkmalsvektorsignal des zweiten virtuell erkannten Hindernisobjekts |
| RVp1 | rekonstruiertes Merkmalsvektorsignal des p-ten virtuell erkannten Hindernisobjekts |
| RVp2 | rekonstruiertes Merkmalsvektorsignal des p-ten virtuell erkannten Hindernisobjekts |
| RX | Empfänger |
| S1 | erster Sensor |
| S2 | zweiter Sensor |
| S3 | dritter Sensor |
| Sm | m-ter Sensor |
| SCE | ECU-Systemsteuerung |
| SCU | Ultraschall-Systemsteuerung |
| SP1 | erster Hindernisobjektspeicher |
| SP2 | zweiter Hindernisobjektspeicher |
| SPC | Speichersteuerung |
| SPp | p-ter Hindernisobjektspeicher |
| SPRV1 | erster Prognosespeicher |
| SPRV2 | zweiter Prognosespeicher |
| SPRVp | p-ter Prognosespeicher |
| TR | Ultraschallwandler |
| TEC | Sendersteuerung |

| TRU | Datenbus-Schnittstelle |
| --- | --- |
| TU | Ultraschall-Sendersteuerung |
| TRE | Datenbus-Schnittstelle |
| VEO1 | erstes virtuell erkanntes Hindernisobjekt |
| VEO2 | zweites virtuell erkanntes Hindernisobjekt |
| VEOp | p-tes virtuell erkanntes Hindernisobjekt |
| VM1 | erster Zwischenspeicher des Modellteils |
| VM2 | zweiter Zwischenspeicher des Modellteils |
| VMp | p-ter Zwischenspeicher des Modellteils |
| VRV | Realitätsnachbildungsmerkmalsvektorsignal |

## LITERATURVERZEICHNIS

DE 4 433 957 A1
DE 10 2012 015 967 A1
DE 10 2011 085 286 A1
DE 10 2015 104 934 A1
DE 10 2010 041 424 A1
DE 10 2013 226 373 A1
DE 10 024 959 A1
DE 10 2013 015 402 A1
DE 10 2018 106 244 B3
DE 10 2019 106 190 A1
DE 10 2017 123 049 B3
DE 10 2017 123 050 B3
DE 10 2017 123 051 B3
DE 10 2017 123 052 B3
WO 2012/016834 A1
WO 2014/108300 A1
WO 2018/210966 A1
US 2006/0250297 A1

Nächster Stand der Technik:

DE 10 2017 108348 B3
US 10 106 153 B1

**Patentansprüche**

1. Verfahren zur Erkennung der Existenz von Hindernisobjekten in einem Erfassungsbereich, insbesondere in einem an ein Fahrzeug angrenzenden Erfassungsbereich, insbesondere in der Umgebung eines Fahrzeugs, anhand von von mehreren, den Erfassungsbereich erfassenden Sensoren, insbesondere von mehreren den Erfassungsbereich erfassenden Ultraschallsensoren, gelieferten Sensorsignalen, wobei bei dem Verfahren

A) für jeden Sensor mittels einer Merkmalsextaktion aus dessen Sensorsignal Signalverlaufscharakteristika extrahiert und aus diesen Merkmalen ein das Sensorsignal repräsentierendes Merkmalsvektorsignal (EF1,EF2,EF3,...,EFm) gebildet wird,
B) die Merkmalsvektorsignale (EF1,EF2,EF3,..., EFm) einem künstlichen neuronalen Gesamthindernisobjekterkennungsnetz (ANN0) als Eingabesignale zugeführt werden, das anhand der Merkmale der Merkmalsvektorsignale (EF1,EF2,EF3,...,EFm) mindestens ein Hindernisobjekt erkennt und dieses Hindernisobjekt beschreibende Informationen pro Hindernisobjekt in einem separaten Hindernisobjektspeicher (EO1,EO2,...,EOp) abspeichert,
C) die Informationen jedes Hindernisobjektsspeichers (EO1,EO2,...,EOp) in einem diesem zugeordneten künstlichen neuronalen Einzelhindernisobjekterkennungsnetz (RNN1,RNN2,...,RNNp) als Eingabedaten eingegeben werden,

D) jedes neuronale Einzelhindernisobjekterkennungsnetz (RNN1,RNN2,...,RNNp) ein das Hindernisobjekt des betreffenden Hindernisobjektspeichers (EO1,EO2,...,EOp) repräsentierendes Hindernisobjekt-Merkmalsvektorsignal (RO1,RO2,...,ROp) und eine mit der Anzahl der Sensoren identische Anzahl von Zwischen-Merkmalsvektorsignalen (ROij mit i = 1, 2, ..., p, mit p gleich der Anzahl der Hindernisobjekte, und mit j = 1, 2, ..., m, mit m gleich der Anzahl der Sensoren) ausgibt, von denen jedes einem einzigen Sensor (S1,S2,S3,...,Sm) zugeordnet ist,

E) für jeden Sensor (S1,S2,S3,...,Sm) die von den neuronalen Einzelhindernisobjekterkennungsnetzen (RNN1,RNN2,...,RNNp) ausgegebenen Zwischen-Merkmalsvektorsignalen (RO ij mit i = 1, 2, ..., p, mit p gleich der Anzahl der Hindernisobjekte, und mit j = 1, 2, ..., m, mit m gleich der Anzahl der Sensoren) zur Bildung eines korrigierten Merkmalsvektorsignals (EV1,EV2,EV3,...,EVm) addiert werden,

F) für jeden Sensor (S1,S2,S3,...,Sm) ein Restmerkmalsvektorsignal (EC1,EC2,EC3,...,ECm) gebildet wird, indem das korrigierte Merkmalsvektorsignal (EV1,EV2,EV3,...,EVm) von dem Merkmalsvektorsignal (EF1, EF2, EF3, ..., EFm) subtrahiert wird,

G) die Schritte B) bis F) unter Verwendung des jeweils aktualisierten Restmerkmalsvektorsignals (EC1,EC2,EC3,...,ECm) wiederholt werden, sofern das Restmerkmalsvektorsignal (EC1,EC2,EC3,...,ECm) größer ist als ein Schwellwertsignal, und

H) andernfalls die von den neuronalen Unternetzen (RNN1,RNN2,...,RNNp) ausgegebenen Hindernisobjekt-Merkmalsvektorsignale (RO1,RO2,...,ROp) jeweils ein Hindernisobjekt repräsentieren und anhand der Hindernisobjekt-Merkmalsvektorsignale (RO1,RO2,...,ROp) potentielle, in dem Erfassungsbereich befindliche Hindernisobjekte insbesondere hinsichtlich Position, Lage und/oder Orientierung und/oder hinsichtlich ihrer Typen, ihrer Beschaffenheiten und/oder ihrer Abstände zum Fahrzeug bestimmt werden.

2. Verfahren nach Anspruch 1, **dadurch gekennzeichnet, dass** als jedem Sensor (S1,S2,S3,...,Sm) jeweils zugeordnetes Merkmalsvektorsignal (EF1,EF2,EF3,...,EFm) ein rekonstruiertes Gesamtmerkmalsvektorsignal (ER) bereitgestellt wird, das gebildet wird gemäß einem Verfahren zur Dekomprimierung von ein Sensorsignal beschreibenden komprimierten Sensorsignaldaten eines Sensors (S1,S2,S3,...,Sn) eines Messsystems, insbesondere eines Abstandsmesssystems, insbesondere zur Anwendung in einem Fahrzeug und insbesondere von ein Ultraschall-Sensorsignal eines Ultraschallsensors beschreibenden, komprimierten Sensorsignaldaten, wobei bei dem Verfahren

- ein Sensorsignal beschreibende komprimierte Sensorsignaldaten bereitgestellt werden, wobei die Sensorsignaldaten Signalobjekte repräsentieren, denen Signalverlaufscharakteristika des Sensorsignals zugeordnet sind, welche mittels einer Merkmalsextraktion (FE) aus dem Sensorsignal extrahiert sind und die Merkmale eines Gesamtmerkmalsvektorsignals (F1) bilden,

- für jedes Signalobjekt die das jeweilige Signalobjekt beschreibenden Daten einem anderen von mehreren künstlichen neuronalen Einzeldekompressionsnetzen (ENN1,ENN2,...,ENNn) zugeführt werden oder aus den jeweils ein Signalobjekt beschreibenden Daten das jeweilige Signalobjekt erzeugt und dieses einem anderen von mehreren künstlichen neuronalen Einzeldekompressionsnetzen (ENN1,ENN2,...,ENNn) zugeführt wird, wobei die neuronalen Einzeldekompressionsnetze (ENN1,ENN2,...,ENNn) Parametrisierungen aufweisen, die hinsichtlich einer Verarbeitung von Eingangssignalen zu Ausgangssignalen invers sind zu einer Verarbeitung von Eingangssignalen zu Ausgangssignalen durch künstliche neuronale Netze oder durch andere Datenverarbeitungsvorrichtungen, die bei der Komprimierung der Sensorsignaldaten eingesetzt worden sind,

- von jedem neuronalen Einzeldekompressionsnetz (ENN1,ENN2,...,ENNn) ein rekonstruiertes Einzelmerkmalsvektorsignal (ER1,ER2,...,ERn) gebildet wird und

- die rekonstruierten Einzelmerkmalsvektorsignale (ER1,ER2,...,ERn) zur Bildung eines das Gesamtmerkmalsvektorsignal (F1) repräsentierenden, rekonstruierten Gesamtmerkmalsvektorsignals (ER) summiert werden, welches die Dekomprimierung der komprimierten Sensorsignaldaten repräsentiert.

3. Verfahren nach Anspruch 2, **dadurch gekennzeichnet, dass** die Bildung der rekonstruierten Einzelmerkmalsvektorsignale (ER1,ER2,...,ERn) durch Raum- oder Zeitmultiplexen erfolgt.

4. Verfahren nach Anspruch 2 oder 3, **dadurch gekennzeichnet, dass** die Bereitstellung der das Sensorsignal beschreibenden, komprimierten Sensorsignaldaten gemäß dem Verfahren nach Anspruch 1 oder 2 erfolgt, wobei die Parametrisierung jedes der neuronalen Einzeldekompressionsnetze (ENN1,ENN2,...,ENNn), das ein einem Signalobjekt zugeordnetes rekonstruiertes Einzelmerkmalsvektorsignal (ER1,ER2,...,ERn) erzeugt und hinsichtlich einer Verarbeitung von Eingangssignalen zu Ausgangssignalen invers zu dem neuronalen Einzelrekonstruktionsnetz (NN1,NN2,...,NNn) bei der Kompression ist.

**Claims**

1. The method for recognizing the existence of obstacles in a detection zone, particularly in a detection zone adjoining a vehicle, particularly in the vicinity of a vehicle, by means of sensor signals supplied by a plurality of sensors detecting the detection zone, particularly by a plurality of ultrasonic sensors detecting the detection zone, wherein in the method

   A) for each sensor, by means of a feature extraction from its sensor signal, signal curve characteristics are extracted and a feature vector signal (EF1, EF2, EF3, ..., EFm) representing the sensor signal is formed from these features,
   B) the feature vector signals (EF1, EF2, EF3, ..., EFm) are fed to an artificial neural overall obstacle recognition network (ANNO) as input signals, which recognizes at least one obstacle by means of the features of the feature vector signals (EF1, EF2, EF3, ..., EFm) and stores information describing this obstacle in a separate obstacle memory EO1, EO2, ..., EOp, for each obstacle,
   C) the information items of each obstacle memory (EO1, EO2, ..., EOp) are entered as input data in an artificial neural individual obstacle recognition network (RNN1, RNN2, ..., RNNp) dedicated thereto,
   D) each neural individual obstacle recognition network (RNN1, RNN2, ..., RNNp) outputs an obstacle feature vector signal (RO1, RO2, ..., ROp) representing the obstacle of the relevant obstacle memory (EO1, EO2, ..., EOp) and a number of intermediate feature signals identical to the number of sensors (ROij with i = 1, 2, ..., p, with p equal to the number of obstacles, and with j = 1, 2, ..., m, with m equal to the number of sensors), each of which is assigned to an individual sensor (S1, S2, S3, ..., Sm),
   E) for each sensor (S1, S2, S3, ..., Sm), the intermediate feature vector signals output by the neural individual obstacle recognition networks (RNN1, RNN2, ..., RNNp) (ROij with i = 1, 2, ..., p, with p equal to the number of obstacles, and with j = 1, 2, ..., m, with m equal to the number of sensors) are added to form a corrected feature vector signal (EV1, EV2, EV3, ..., EVm),
   F) for each sensor (S1, S2, S3, ..., Sm), a residual feature vector signal (EC1, EC2, EC3, ..., ECm) is formed by subtracting the corrected feature vector signal (EV1, EV2, EV3, ..., EVm) from the feature vector signal (EF1, EF2, EF3, ..., EFm),
   G) steps B) to F) are repeated using the respectively updated residual feature vector signal (EC1, EC2, EC3, ..., ECm), provided that the residual feature vector signal (EC1, EC2, EC3, ..., ECm) is greater than a threshold signal, and
   H) otherwise, the obstacle feature vector signals (RO1, RO2, ..., ROp) output by the neural subnetworks (RNN1, RNN2, ..., RNNp) each represent an obstacle and, by means of the obstacle feature vector signals (RO1, RO2, ..., ROp), potential obstacles located in the detection zone are determined, particularly with regard to position, location and/or orientation and/or with regard to their types, their properties and/or their distances from the vehicle.

2. The method according to claim 1, **characterized in that** a reconstructed overall feature vector signal (ER) is provided as the feature vector signal (EF1, EF2, EF3, ..., EFm) assigned to each sensor (S1, S2, S3, ..., Sm), which reconstructed overall feature vector signal is formed according to a method for decompressing compressed sensor signal data describing a sensor signal of a sensor (S1, S2, S3, ..., Sn) of a measurement system, particularly a distance measurement system, particularly for use in a vehicle and particularly of compressed sensor signal data describing an ultrasonic sensor signal of an ultrasonic sensor, wherein in the method

   - compressed sensor signal data describing a sensor signal are provided, wherein the sensor signal data representing signal objects with which signal curve characteristics of the sensor signal are assigned, which are extracted from the sensor signal by means of a feature extraction (FE) and which form the features of an overall feature vector signal (F1),
   - for each signal object, the data describing the respective signal object are fed to another of a plurality of artificial neural individual decompression networks (ENN1, ENN2, ..., ENNn) or the respective signal object is generated from the data describing a signal object and this is fed to another of a plurality of artificial neural individual decompression networks (ENN1, ENN2, ..., ENNn), wherein the neural individual decompression networks (ENN1, ENN2, ..., ENNn) have parameterizations that are inverse with regard to processing of input signals to output signals for processing input signals into output signals by artificial neural networks or by other data processing devices that have been used to compress the sensor signal data,
   - a reconstructed individual feature vector signal (ER1, ER2, ..., ERn) is formed by each neural individual decompression network (ENN1, ENN2, ..., ENNn) and
   - the reconstructed individual feature vector signals (ER1, ER2, ..., ERn) are summed to form a reconstructed overall feature vector signal (ER) which represents the overall feature vector signal (F1) and which represents the decompression of the compressed sensor signal data.

3. The method according to claim 2, **characterized in that** the reconstructed individual feature vector signals (ER1, ER2, ..., ERn) are formed by space or time multiplexing.

4. The method according to claim 2 or 3, **characterized in that** the provision of the compressed sensor signal data describing the sensor signal is carried out in accordance with the method according to claim 1 or 2, wherein the parameterization of each of the neural individual decompression networks (ENN1, ENN2, ..., ENNn) which generates a reconstructed individual feature vector signal (ER1, ER2, ..., ERn) assigned to a signal object and, with regard to a processing of input signals to output signals, is the inverse of the neural individual reconstruction network (NN1, NN2, ..., NNn) during the compression.

**Revendications**

1. Procédé de reconnaissance de l'existence d'obstacles dans une zone de détection, en particulier dans une zone de détection adjacente à un véhicule, en particulier dans l'environnement d'un véhicule, à l'aide de plusieurs capteurs captant la zone de détection, en particulier par plusieurs capteurs ultrasonores captant la zone de détection, dans lequel lors du procédé

A) pour chaque capteur, des caractéristiques de signal sont extraites du signal de celui-ci au moyen d'une extraction de caractéristique et un signal vectoriel caractéristique (EF1, EF2, EF3, ..., EFm) représentant le signal de capteur est formé à partir de ces caractéristiques,

B) les signaux vectoriels caractéristiques (EF1, EF2, EF3, ..., EFm) sont envoyés comme signaux d'entrée à un réseau neuronal artificiel total de reconnaissance d'obstacles (ANN0), lequel reconnaît au moins un obstacle à l'aide des caractéristiques du signal vectoriel caractéristique (EF1, EF2, EF3, ..., EFm) et enregistre les informations décrivant cet obstacle dans une mémoire d'obstacles (EO1, EO2, ..., EOp) séparée par obstacle,

C) les informations de chaque mémoire d'obstacles (EO1, EO2, ..., EOp) sont entrées dans un réseau neuronal artificiel individuel de reconnaissance d'obstacles (RNN1, RNN2, ..., RNNp) associé à celle-ci en tant que données sources,

D) chaque réseau neuronal individuel de reconnaissance d'obstacles (RNN1, RNN2, ..., RNNp) associé émet un signal vectoriel caractéristique d'obstacle (RO1, RO2, ..., ROp) représentant l'obstacle de la mémoire d'obstacles (EO1, EO2, ..., EOp) concernée et un nombre (égal au nombre de capteurs) de signaux vectoriels caractéristiques intermédiaires (ROij où i = 1, 2, ..., p, où p est égal au nombre d'obstacles, et où j = 1, 2, ..., m, où m est égal au nombre de capteurs), parmi lesquels chacun est associé à un capteur individuel (S1, S2, S3, ..., Sm),

E) pour chaque capteur (S1, S2, S3, ..., Sm) les signaux vectoriels caractéristiques intermédiaires (ROij où i = 1, 2, ..., p, où p est égal au nombre d'obstacles, et où j = 1, 2, ..., m, où m est égal au nombre de capteurs) émis par les réseaux neuronaux individuels de reconnaissance d'obstacles (RNN1, RNN2, ..., RNNp) sont additionnés pour former un signal vectoriel caractéristique corrigé (EV1, EV2, EV3, ..., EVm),

F) pour chaque capteur (S1, S2, S3, ..., Sm) un signal vectoriel caractéristique restant (EC1, EC2, EC3, ..., ECm) est formé en soustrayant le signal vectoriel caractéristique corrigé (EV1, EV2, EV3, ..., EVm) du signal vectoriel caractéristique (EF1, EF2, EF3, ..., EFm),

G) les étapes B) à F) sont répétées en utilisant le signal vectoriel caractéristique restant (EC1, EC2, EC3, ..., ECm) respectivement mis à jour, pour autant que le signal vectoriel caractéristique restant (EC1, EC2, EC3, ..., ECm) est soit supérieur à un signal seuil, et

H) dans le cas contraire, les signaux vectoriels caractéristiques d'obstacle (RO1, RO2, ..., ROp) émis par les sous-réseaux neuronaux (RNN1, RNN2, ..., RNNp) représentent respectivement un obstacle et à l'aide des signaux vectoriels caractéristiques d'obstacle (RO1, RO2, ..., ROp) des obstacles potentiels se trouvant dans la zone de détection sont déterminés en particulier en ce qui concerne la position, la situation et/ou l'orientation et/ou en ce qui concerne leurs types, leurs caractères et/ou leurs distances par rapport au véhicule.

2. Procédé selon la revendication 1, **caractérisé en ce qu'**un signal vectoriel caractéristique total reconstruit (ER) est préparé en tant que signal vectoriel caractéristique (EF1, EF2, EF3, ..., EFm) respectivement associé à chaque capteur (S1, S2, S3, ..., Sm), lequel (ER) est formé selon un procédé destiné à la décompression de données comprimées de signal de capteur, décrivant un signal de capteur, d'un capteur (S1, S2, S3, ..., Sm) d'un système de mesure, en particulier d'un système de mesure de distance, en particulier destiné à être utilisé dans un véhicule et en particulier de données comprimées de signal de capteur, décrivant un signal de capteur ultrasonore d'un capteur à ultrasons, dans lequel lors du procédé

- des données comprimées de signal de capteur décrivant un signal de capteur sont préparées, dans lequel les données de signal de capteur représentent des objets de signal auxquels sont associées des caractéristiques de signal du signal de capteur, lesquels sont extraits du signal de capteur au moyen d'une extraction de caractéristique (ME) et forment les caractéristiques d'un signal vectoriel caractéristique total (F1),
- pour chaque objet de signal, les données décrivant l'objet de signal respectif sont envoyées à un autre des plusieurs réseaux neuronaux artificiels individuels de décompression (ENN1, ENN2, ..., ENNn) ou l'objet de signal respectif est généré à partir des données décrivant respectivement un objet de signal et est envoyé à un autre des plusieurs réseaux neuronaux artificiels individuels de décompression (ENN1, ENN2, ..., ENNn), dans lequel les réseaux neuronaux individuels de décompression (ENN1, ENN2, ..., ENNn) comportent des paramétrages, lesquels sont, en ce qui concerne un traitement de signaux d'entrée en signaux de sortie, inversés par rapport à un traitement de signaux d'entrée en signaux de sortie par des réseaux neuronaux artificiels ou par d'autres dispositifs de traitement de données utilisés lors de la compression des données de signal de capteur,
- un signal vectoriel caractéristique individuel reconstruit (ER1, ER2, ..., ERn) est formé depuis chaque réseau neuronal individuel de décompression (ENN1, ENN2, ..., ENNn) et
- les signaux vectoriels caractéristiques individuels reconstruits (ER1, ER2, ..., ERn) sont sommés afin de former un signal vectoriel caractéristique total (ER) reconstruit représentant le signal vectoriel caractéristique total (F1), lequel représente la décompression des données comprimées de signal de capteur.

3. Procédé selon la revendication 2, **caractérisé en ce que** la formation des signaux vectoriels caractéristiques individuels reconstruits (ER1, ER2, ..., ERn) s'effectue par multiplexage spatial ou temporel.

4. Procédé selon la revendication 2 ou 3, **caractérisé en ce que** la préparation des données comprimées de signal de capteur décrivant le signal de capteur conformément au procédé selon la revendication 1 ou 2, dans lequel le paramétrage de chacun des réseaux neuronaux artificiels individuels de décompression (ENN1, ENN2, ..., ENNn) générant un signal vectoriel caractéristique individuel reconstruit (ER1, ER2, ..., ERn) associé à un objet de signal est, en ce qui concerne un traitement de signaux d'entrée en signaux de sortie, inversé par rapport au réseau neuronal individuel de reconstruction (NN1, NN2, ..., NNn) lors de la compression.

Fig. 1

Fig. 2

Fig. 3

Fig. 4

EP 3 938 807 B1

Fig. 5

EP 3 938 807 B1

**Fig. 6**

EP 3 938 807 B1

**Fig. 7**

Prototypendatenbank (115)

Physikalische
Schnittstelle
(101)

100 | 102

1

Abstandsermittler
(Klassifikator)
(112)

erkannte
Signalgrundobjekte
(121)

138

Viterbi-Schätzer
(113)

erkannte
Signalobjekte
mit
Signalobjektparametern
(122)

Feature-Vektor-Extraktor (111)

Optimalfilter 1

Optimalfilter 2

123

Signifikanz-
Steigerer

Optimalfilter m-1

Optimalfilter m

LDA-Matrix

Signalobjektdatenbank
(Lexikon bekannter
zeitlicher Folgen von
Signalgrundobjekten)
(116)

EP 3 938 807 B1

Fig. 8

Fig. 9

EP 3 938 807 B1

Fig. 10

abc Sequenz

Kein Signalgrundobjektprototyp

da-Sequenz

Ende des
Signalobjekts

Warten

Aufwachen

bcd-Sequenz

Fig. 11

EP 3 938 807 B1

Fig. 12

EP 3 938 807 B1

Fig. 13

Fig. 14

Fig. 15

Fig. 16

EP 3 938 807 B1

(a) |En| [a.u.]

t

(b) |En| [a.u.]

166

SA (t)

(c) |En| [a.u.]

166

t

EP 3 938 807 B1

Fig. 17

Fig. 18

(a)

|En|
[a.u.]

670

1

Sende- und
Ausschwingphase

Empfangsphase

t

(b)

|En|
[a.u.]

166

SA
(t)

(c)

|En|
[a.u.]

670

660

166

t

(d)

|En|
[a.u.]

670

660

t

**Fig. 19**

erkannte
Signalobjekte
mit
Signalobjektparametern
(122)

Viterbi-Schätzer
(113)

Signalobjektdatenbank
(Lexikon bekannter
zeitlicher Folgen von
Signalgrundobjekten)
(116)

Rekonstruierer
(600)

rekonstruiertes
Ultraschall-Echo-Signal-Modell
(610)

erkannte
Signalgrundobjekte
(121)

Prototypendatenbank (115)

Abstandsermittler
(Klassifikator)
(112)

138

Signifikanz-
Steigerer

LDA-Matrix

Feature-Vektor-Extraktor (111)

123

Optimalfilter 1

Optimalfilter 2

Optimalfilter m-1

Optimalfilter m

660

Rekonstruktionsspeicher (603)

Physikalische
Schnittstelle
(101)

102

1

100

Subtrahierer (602)

Speicher (601)

71

Datenschnittstelle (TRU)

DB

O1 bis
On

| Abstandsermittler (Klassifikator) (NNO) |

Ultraschall-
Sendersteuerung
(TU)

TR

Physikalische
Schnittstelle
(RX)

F2

Feature-Vektor-Extraktor (FE)

Optimalfilter 1

Optimalfilter 2

Signifikanz-
Steigerer

F0

Speicher (IMO)

F1

Subtrahierer (A0)

Speicher
(IM1-IMn)

Optimalfilter m-1

Optimalfilter m

LDA-Matrix

R1

Rekonstruktionsnetze (NN1-NNn)

**Fig. 20**

Fig. 21

Fig. 22

Fig. 23

**Fig. 24**

**Fig. 25**

US-Sensor

ECU

EP 3 938 807 B1

```
            S1              S2              S3          .....            Sm

    ┌─────────────────────────────────────────────────────────────────────┐
    │                                                             ECU       │
    │                                                                       │
    │   ┌────────┐      ┌────────┐      ┌────────┐          ┌────────┐       │
    │   │  SR1   │      │  SR2   │      │  SR3   │          │  SRm   │       │
    │   │  ER    │      │  ER    │      │  ER    │          │  ER    │       │
    │   └────────┘      └────────┘      └────────┘          └────────┘       │
    │       ▽              ▽              ▽                      ▽           │
    │   ┌───────────────────────────────────────────────────────────────┐   │
    │   │                                                               │   │
    │   │                                              Fig 24           │   │
    │   └───────────────────────────────────────────────────────────────┘   │
    │                              ▽                                        │
    └─────────────────────────────────────────────────────────────────────┘

                                  VRV


                                          Fig. 26
```

Fig. 27

EP 3 938 807 B1

Intervall ΔT Senden, Ausschwingen und Empfang | Intervall ΔT Senden, Ausschwingen und Empfang

EPS1

EP

EPS2

Δt
PP1

Δt
PP2

. . .

Δt
PPq

PZ1 PZ2 . . . PZp

Δt << ΔT

Fig. 28

EP 3 938 807 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102019106204
- WO 2012016834 A
- DE 4433957 A
- DE 102012015967 A
- DE 102011085286 A
- WO 2014108300 A
- DE 102015104934 A
- DE 102010041424 A
- DE 102013226373 A
- DE 102013226376 A
- DE 10024959 A
- DE 102013015402 A
- US 20060250297 A
- WO 2018210966 A
- DE 102018106244 B
- DE 102019106190 A
- DE 102017108348 B
- US 10106153 B
- DE 102017123049 B
- DE 102017123050 B
- DE 102017123051 B

- DE 102017123052 B
- DE 4433957 A1
- DE 102012015967 A1
- DE 102011085286 A1
- DE 102015104934 A1
- DE 102010041424 A1
- DE 102013226373 A1
- DE 10024959 A1
- DE 102013015402 A1
- DE 102018106244 B3
- DE 102019106190 A1
- DE 102017123049 B3
- DE 102017123050 B3
- DE 102017123051 B3
- DE 102017123052 B3
- WO 2012016834 A1
- WO 2014108300 A1
- WO 2018210966 A1
- US 20060250297 A1
- DE 102017108348 B3
- US 10106153 B1